(19)

Europäisches Patentamt
European Patent Office
Office européen des brevets

(11)  **EP 3 029 172 A1**

(12)  **EUROPEAN PATENT APPLICATION**

(43)  Date of publication:
08.06.2016  Bulletin 2016/23

(51)  Int Cl.:
*C23C 14/34* (2006.01)          *C23C 14/08* (2006.01)
*H01L 21/363* (2006.01)        *H01L 21/8247* (2006.01)
*H01L 27/115* (2006.01)        *H01L 51/50* (2006.01)
*H05B 33/14* (2006.01)          *C23C 14/35* (2006.01)

(21)  Application number: 15202535.9

(22)  Date of filing: 17.06.2013

(84)  Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30)  Priority:  29.06.2012  JP 2012147928
05.12.2012  JP 2012266243
14.12.2012  JP 2012273482

(62)  Document number(s) of the earlier application(s) in
accordance with Art. 76 EPC:
13810525.9 / 2 867 387

(71)  Applicant: **Semiconductor Energy Laboratory Co.,
Ltd.**
**Atsugi-shi, Kanagawa 243-0036 (JP)**

(72)  Inventor: **YAMAZAKI, Shunpei**
**Atsugi-shi, Kanagawa 243-0036 (JP)**

(74)  Representative: **Grünecker Patent- und
Rechtsanwälte
PartG mbB
Leopoldstraße 4
80802 München (DE)**

Remarks:
This application was filed on 23-12-2015 as a
divisional application to the application mentioned
under INID code 62.

(54)  **METHOD FOR USING SPUTTERING TARGET AND METHOD FOR MANUFACTURING OXIDE
FILM**

(57)    A method of manufacturing an oxide film having crystallinity, the method comprising: providing a first sputtering target and a second sputtering target in a sputtering apparatus, the first sputtering target and the second sputtering target facing each other with a region therebetween; providing a first substrate holder in such a manner that a surface of the first substrate holder faces the region; and performing a formation of the oxide film having crystallinity by sputtering.

## FIG. 14A

# FIG. 14C

N S 4032a

S N

4033a

4033b

4032b

N S

4035

S N

**Description**

TECHNICAL FIELD

The present invention relates to an object, a method, or a manufacturing method. In addition, the present invention relates to a process, a machine, manufacture, or a composition of matter. In particular, the present invention relates to, for example, a semiconductor device, a display device, a light-emitting device, a power storage device, a driving method thereof, or a manufacturing method thereof. The present invention particularly relates to a semiconductor device, a display device, or a light-emitting device each including an oxide semiconductor, for example. The present invention further particularly relates to a sputtering target and a manufacturing method thereof, for example. Alternatively, the present invention relates to an oxide film formed by a sputtering method, using the sputtering target, and a semiconductor device including the oxide film, for example.

In this specification, a semiconductor device generally refers to a device which can function by utilizing semiconductor characteristics; an electro-optical device, a semiconductor circuit, and an electronic device are all included in the category of the semiconductor device.

BACKGROUND ART

A technique by which a transistor is formed using a semiconductor thin film formed over a substrate having an insulating surface has been attracting attention. The transistor is applied to a wide range of electronic devices such as an integrated circuit (IC) or an image display device (display device). As a semiconductor thin film applicable to the transistor, a silicon film is widely known; moreover, an oxide semiconductor film has been attracting attention as another material.

For example, disclosure is made of a transistor including an amorphous oxide semiconductor film containing In, Ga, and Zn and having an electron carrier concentration of lower than $10^{18}$ /cm$^3$, and a sputtering method is considered the most suitable as a method for forming the amorphous oxide semiconductor film (see Patent Document 1).

Although an oxide semiconductor containing a plurality of metal elements has high controllability of carrier density, there have been problems in that such an oxide semiconductor is made amorphous easily and instable in physical properties.

On the other hand, it is reported that a transistor including a crystalline oxide semiconductor film has excellent electrical characteristics and reliability compared with a transistor including an amorphous oxide semiconductor film (see Non-Patent Document 1).

[Reference]

[Patent Document 1] Japanese Published Patent Application No. 2006-165528

[Non-Patent Document]

[Non-Patent Document 1] Shunpei Yamazaki, Jun Koyama, Yoshitaka Yamamoto, and Kenji Okamoto, "Research, Development, and Application of Crystalline Oxide Semiconductor" SID 2012 DIGEST, pp. 183-186.

DISCLOSURE OF INVENTION

An object of the present invention is to provide a method for manufacturing a crystalline oxide film, which is a method for forming an oxide film containing a plurality of metal elements.

Another object of the present invention is to provide a sputtering target which enables the oxide film to be formed.

Another object of the present invention is to provide a method for using the sputtering target.

Another object of the present invention is to provide a transistor which has stable electrical characteristics with the use of the oxide film.

Another object of the present invention is to provide a highly reliable semiconductor device including the transistor.

An object of one embodiment of the present invention is to provide a semiconductor device with low off-state current. Alternatively, another object of one embodiment of the present invention is to provide a semiconductor device with low power consumption. Still alternatively, another object of one embodiment of the present invention is to provide a novel semiconductor device.

Note that the descriptions of these objects do not disturb the existence of any other object. Note that in one embodiment of the present invention, there is no need to achieve all the objects. Other objects will be apparent from and can be derived from the description of the specification, the drawings, the claims, and the like.

One embodiment of the present invention is a method for using a sputtering target including a polycrystalline oxide, in which a plurality of flat plate-like positively charged sputtered particles which are separated from the sputtering target are deposited on a deposition surface while repelling each other.

Another embodiment of the present invention is a method for using a sputtering target including a polycrystalline oxide, which includes the steps of: making an ion collide with the sputtering target to separate a plurality of flat plate-like sputtered particles from the sputtering target; and positively charging the plurality of flat plate-like sputtered particles, so that the plurality of flat plate-like sputtered particles are deposited on a deposition surface while repelling each other.

According to another embodiment of the present invention, a method for using a sputtering target including a polycrystalline oxide containing a plurality of crystal grains, in which the plurality of crystal grains each include a cleavage plane, includes the steps of: making an ion collide with the sputtering target to separate a plurality of flat plate-like sputtered particles from each cleavage plane; and positively charging the plurality of flat plate-like sputtered particles, so that the plurality of flat plate-like sputtered particles are deposited on a deposition surface while repelling each other.

Note that when the sputtered particle has a hexagonal cylinder shape, the sputtered particles are deposited uniformly with ease.

Another embodiment of the present invention is a method for forming an oxide film by depositing sputtered particles by any of the above-described methods.

Note that the cleavage plane refers to a plane where atoms included in a crystal grain are bonded weakly (a surface where cleavage occur or a surface where cleavage occur easily).

Owing to the cleavage planes in the plurality of crystal grains included in the sputtering target, when an ion collides with the sputtering target, sputtered particles can be separated from the cleavage plane of the crystal grain.

The separated sputtered particles which are formed from part of the crystal grain in such a manner has high crystallinity. Thus, an oxide film with a high degree of crystallinity can be formed by depositing the sputtered particles.

Note that the sputtered particle is separated from the cleavage plane and thus has a flat plate-like shape (also referred to as a pellet shape). As obvious in terms of stability, the flat plate-like sputtered particle is attached to the deposition surface with a high probability that the cleavage plane and the deposition surface are parallel to each other. Thus, a crystal portion of an oxide film to be formed is aligned along one crystal axis. For example, in the case where a cleavage plane of a crystal grain is parallel to an *a-b* plane, an oxide film has c-axis alignment. That is, a normal vector of the deposition surface and the *c*-axis of the crystal portion included in the oxide film are parallel to each other. However, an *a*-axis is freely rotated on the *c*-axis; therefore, the direction of *a*-axes of a plurality of crystal portions included in the oxide film are not the same.

In this specification, the trigonal and rhombohedral crystal systems are included in the hexagonal crystal system.

In this specification, a term "parallel" indicates that the angle formed between two straight lines is greater than or equal to -10° and less than or equal to 10°, and accordingly also includes the case where the angle is greater than or equal to -5° and less than or equal to 5°. In addition, a term "perpendicular" indicates that the angle formed between two straight lines is greater than or equal to 80° and less than or equal to 100°, and accordingly includes the case where the angle is greater than or equal to 85° and less than or equal to 95°.

Although sputtered particles are ideally single crystals, the crystallinity in part of the sputtered particle may be lowered due to the impact of ion collision. Thus, in some cases, a region with low crystallinity is included between crystal portions of an oxide film to be formed. For example, from an observation image obtained with a transmission electron microscope (TEM), a boundary between crystal portions is not clear. Therefore, an oxide film of one embodiment of the present invention has high electron mobility because a reduction in electron mobility due to the grain boundary is suppressed.

Here, a cleavage plane of a crystal of an In-Ga-Zn oxide (In:Ga:Zn = 1:1:1 [atomic ratio]) is described.

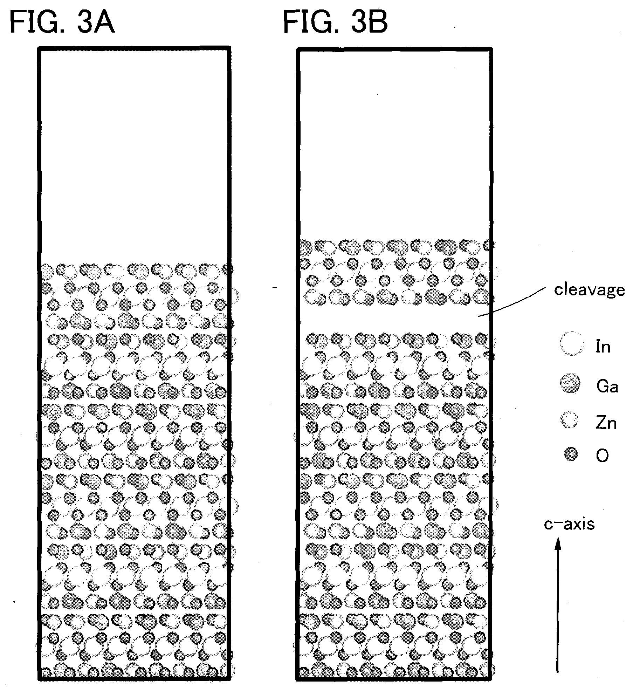

FIG. 3A illustrates the crystal structure of an In-Ga-Zn oxide viewed from a direction parallel to the *a-b* plane. FIG. 3B illustrates the crystal structure after ion collision during sputtering.

For example, cleavage of the crystal grain included in the In-Ga-Zn oxide occurs between a layer including a gallium atom and/or zinc atom and an oxygen atom, and a layer including a gallium atom and/or zinc atom, and an oxygen atom, which are illustrated in FIG. 3B. This is because oxygen atoms which have negative charges exist in the layer in a close distance from each other. In this manner, the cleavage plane is parallel to the *a-b* plane.

That is, it can be seen that, when an ion collides with the surface of a sputtering target including a crystal grain of an In-Ga-Zn oxide, the crystal grain included in the In-Ga-Zn oxide is cleaved along a plane parallel to the *a-b* plane of the crystal, and flat plate-like sputtered particles whose top and bottom surfaces are parallel to the *a-b* plane are separated from the sputtering target.

Moreover, in the crystal of the In-Ga-Zn oxide illustrated in FIG. 3A, metal atoms are arranged in a regular triangular or regular hexagonal configuration when seen from the direction perpendicular to the *a-b* plane; therefore, the flat plate-like crystal grain is likely to have the shape of a hexagonal cylinder whose regular hexagonal plane has internal angles of 120°.

Note that the relative density of the sputtering target is greater than or equal to 90 %, preferably greater than or equal to 95 %, more preferably greater than or equal to 99 %. Note that the relative density of the sputtering target refers to a ratio between the density of the sputtering target and the density of a substance free of porosity having the same composition as the sputtering target.

The polycrystalline oxide included in the sputtering target is at least an oxide containing, for example, In, *M* (*M* is Ga, Sn, Hf, Al, La, Ce, Pr, Nd, Sm, Eu, Gd, Tb, Dy, Ho, Er, Tm, Yb, or Lu), and Zn.

Moreover, the atomic ratio of In, *M*, and Zn contained in the polycrystalline oxide is preferably close to the stoichiometric composition ratio. When the atomic ratio of In, *M*, and Zn contained in the polycrystalline oxide becomes close to the stoichiometric composition ratio, the crystallinity of the polycrystalline oxide can be increased. Note that as described with "close", the atomic ratio and the stoichiometric composition ratio may deviate within the range of $\pm$ 10%.

The crystal grain included in the polycrystalline oxide containing In, $M$, and Zn includes a cleavage plane between a first plane containing $M$ and Zn and a second plane containing $M$ and Zn.

Described below is a method for further increasing the degree of crystallinity of an oxide film which is obtained by a method for forming a thin film by depositing sputtered particles by any of the above-described methods.

By reducing impurities that enter the oxide film, a crystal state is prevented from being broken by the impurities and an oxide film with a high degree of crystallinity can be formed. For example, the concentration of impurities (e.g., hydrogen, water, carbon dioxide, or nitrogen) which exist in a film formation chamber may be reduced. Furthermore, the concentration of impurities in a film formation gas may be reduced. Specifically, a film formation gas whose dew point is -80 °C or lower, preferably -100 °C or lower, more preferably -120 °C or lower is used.

When the surface where the oxide film is to be formed has minute unevenness, the oxide film has a lower degree of crystallinity. Thus, the planarity of the surface where the oxide film is to be formed is improved, whereby an oxide film with a high degree of crystallinity can be formed.

Further, by increasing the heating temperature during the film formation, migration of a sputtered particle occurs after the sputtered particle reach the deposition surface; therefore, an oxide film with a high degree of crystallinity can be formed. Specifically, the heating temperature during the film formation is higher than or equal to 100 °C and lower than or equal to 740 °C, preferably higher than or equal to 200 °C and lower than or equal to 500 °C. By increasing the heating temperature during the film formation, when the flat plate-like sputtered particle reaches the deposition surface, migration occurs on the deposition surface, so that a plane of the flat plate-like sputtered particle parallel to a cleavage plane is easily attached to the deposition surface.

Moreover, by increasing the proportion of oxygen included in the film formation gas and optimizing the power used for film formation, plasma damage at the film formation can be alleviated; accordingly, an oxide film with a high degree of crystallinity can be formed. The percentage of oxygen in the film formation gas is set to be greater than or equal to 30 vol.%, preferably greater than or equal to 50 vol.%, more preferably greater than or equal to 80 vol.%, still more preferably greater than or equal to 100 vol.%.

In addition, an oxide film with a high degree of crystallinity can be obtained by performing heat treatment after the film formation to reduce the impurity concentration in the oxide film. The heat treatment is highly effective in reducing the impurity concentration when performed in an inert atmosphere or under a reduced pressure. For the heat treatment, heat treatment in an oxidation atmosphere is preferably performed after the heat treatment in an inert atmosphere or under a reduced pressure is performed. This is in some cases due to oxygen vacancies caused in the oxide film as well as a reduction in the impurity concentration in the oxide film by the heat treatment performed in an inert atmosphere or under a reduced pressure. By performing the heat treatment in an oxidation atmosphere, oxygen vacancies in the oxide film can be reduced.

In the above manner, an oxide film with a high degree of crystallinity can be formed.

The oxide film with a high degree of crystallinity is preferably a c-axis aligned crystalline oxide semiconductor (CAAC-OS) film.

The CAAC-OS film is one of oxide semiconductor films including a plurality of crystal parts, and most of the crystal parts each fit inside a cube whose one side is less than 100 nm. Thus, there is a case where a crystal part included in the CAAC-OS film fits inside a cube whose one side is less than 10 nm, less than 5 nm, or less than 3 nm. The density of defect states of the CAAC-OS film is lower than that of the microcrystalline oxide semiconductor film. The CAAC-OS film is described in detail below.

In a TEM image of the CAAC-OS film, a boundary between crystal parts, that is, a grain boundary is not clearly observed. Thus, in the CAAC-OS film, a reduction in electron mobility due to the grain boundary is less likely to occur.

According to the TEM image of the CAAC-OS film observed in a direction substantially parallel to a sample surface (cross-sectional TEM image), metal atoms are arranged in a layered manner in the crystal parts. Each metal atom layer has a morphology reflected by a surface over which the CAAC-OS film is formed (hereinafter, a surface over which the CAAC-OS film is formed is referred to as a formation surface) or a top surface of the CAAC-OS film, and is arranged in parallel to the formation surface or the top surface of the CAAC-OS film.

On the other hand, according to the TEM image of the CAAC-OS film observed in a direction substantially perpendicular to the sample surface (plan TEM image), metal atoms are arranged in a triangular or hexagonal configuration in the crystal parts. However, there is no regularity of arrangement of metal atoms between different crystal parts.

From the results of the cross-sectional TEM image and the plan TEM image, alignment is found in the crystal parts in the CAAC-OS film.

A CAAC-OS film is subjected to structural analysis with an X-ray diffraction (XRD) apparatus. For example, when the CAAC-OS film including an $InGaZnO_4$ crystal is analyzed by an out-of-plane method, a peak appears frequently when the diffraction angle ($2\theta$) is around 31°. This peak is derived from the (009) plane of

the InGaZnO$_4$ crystal, which indicates that crystals in the CAAC-OS film have c-axis alignment, and that the c-axes are aligned in a direction substantially perpendicular to the formation surface or the top surface of the CAAC-OS film.

On the other hand, when the CAAC-OS film is analyzed by an in-plane method in which an X-ray enters a sample in a direction substantially perpendicular to the c-axis, a peak appears frequently when $2\theta$ is around 56°. This peak is derived from the (110) plane of the InGaZnO$_4$ crystal. Here, analysis ($\phi$ scan) is performed under conditions where the sample is rotated around a normal vector of a sample surface as an axis ($\phi$ axis) with $2\theta$ fixed at around 56°. In the case where the sample is a single-crystal oxide semiconductor film of InGaZnO$_4$, six peaks appear. The six peaks are derived from crystal planes equivalent to the (110) plane. On the other hand, in the case of a CAAC-OS film, a peak is not clearly observed even when $\phi$ scan is performed with $2\theta$ fixed at around 56°.

According to the above results, in the CAAC-OS film having c-axis alignment, while the directions of a-axes and b-axes are different between crystal parts, the c-axes are aligned in a direction parallel to a normal vector of a formation surface or a normal vector of a top surface. Thus, each metal atom layer arranged in a layered manner observed in the cross-sectional TEM image corresponds to a plane parallel to the a-b plane of the crystal.

Note that the crystal part is formed concurrently with deposition of the CAAC-OS film or is formed through crystallization treatment such as heat treatment. As described above, the c-axis of the crystal is aligned in a direction parallel to a normal vector of a formation surface or a normal vector of a top surface. Thus, for example, in the case where a shape of the CAAC-OS film is changed by etching or the like, the c-axis might not be necessarily parallel to a normal vector of a formation surface or a normal vector of a top surface of the CAAC-OS film.

Further, the degree of crystallinity in the CAAC-OS film is not necessarily uniform. For example, in the case where crystal growth leading to the CAAC-OS film occurs from the vicinity of the top surface of the film, the degree of the crystallinity in the vicinity of the top surface is higher than that in the vicinity of the formation surface in some cases. Further, when an impurity is added to the CAAC-OS film, the crystallinity in a region to which the impurity is added is changed, and the degree of crystallinity in the CAAC-OS film varies depending on regions.

Note that when the CAAC-OS film with an InGaZnO$_4$ crystal is analyzed by an out-of-plane method, a peak of $2\theta$ may also be observed at around 36°, in addition to the peak of $2\theta$ at around 31°. The peak of $2\theta$ at around 36° indicates that a crystal having no c-axis alignment is included in part of the CAAC-OS film. It is preferable that in the CAAC-OS film, a peak of $2\theta$ appears at around 31° and a peak of $2\theta$ do not appear at around 36°.

In a transistor including the CAAC-OS film, change in electrical characteristics due to irradiation with visible light or ultraviolet light is small. Thus, the transistor has high reliability.

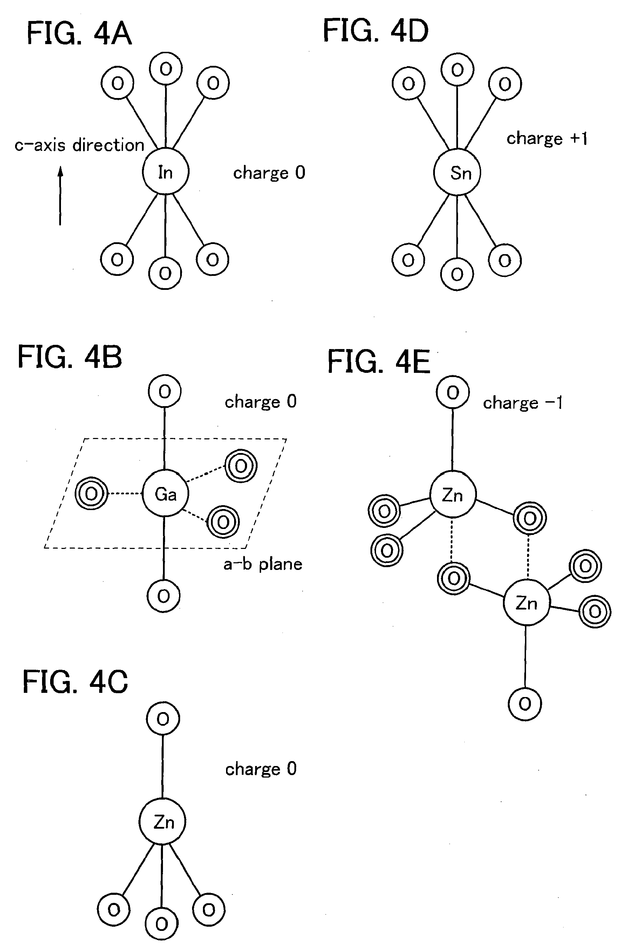

An example of a crystal structure of the crystal portion included in the CAAC-OS film is described in detail with reference to FIGS. 4A to 4E, FIGS. 5A to 5C, FIGS. 6A to 6C, and FIGS. 7A and 7B. In FIGS. 4A to 4E, FIGS. 5A to 5C, FIGS. 6A to 6C, and FIGS. 7A and 7B, the vertical direction corresponds to the c-axis direction and a plane perpendicular to the c-axis direction corresponds to the a-b plane, unless otherwise specified. In the case where the expressions "an upper half" and "a lower half" are simply used, they refer to an upper half above the a-b plane and a lower half below the a-b plane (an upper half and a lower half with respect to the a-b plane). Moreover, in FIGS. 4A to 4E, O surrounded by a circle represents tetracoordinate O and O surrounded by a double circle represents tricoordinate O.

FIG. 4A illustrates a structure including one hexacoordinate In atom and six tetracoordinate oxygen (hereinafter referred to as tetracoordinate O) atoms proximate to the In atom. Here, a structure including one metal atom and oxygen atoms proximate thereto is referred to as a small group. The structure in FIG. 4A is actually an octahedral structure, but is illustrated as a planar structure for easy understanding. Note that three tetracoordinate O atoms exist in each of an upper half and a lower half in FIG. 4A. In the small group illustrated in FIG. 4A, electric charge is 0 (zero).

FIG. 4B illustrates a structure including one pentacoordinate Ga atom, three tricoordinate oxygen (hereinafter referred to as tricoordinate O) atoms proximate to the Ga atom, and two tetracoordinate O atoms proximate to the Ga atom. All the tricoordinate O atoms are on the a-b plane. One tetracoordinate O atom is located in each of an upper half and a lower half in FIG. 4B. An In atom can also have the structure illustrated in FIG. 4B because an In atom can have five ligands. In the small group illustrated in FIG. 4B, electric charge is 0.

FIG. 4C illustrates a structure including one tetracoordinate Zn atom and four tetracoordinate O atoms proximate to the Zn atom. In FIG. 4C, one tetracoordinate O atom exists in an upper half and three tetracoordinate O atoms exist in a lower half. In the small group illustrated in FIG. 4C, electric charge is 0.

FIG. 4D illustrates a structure including one hexacoordinate Sn atom and six tetracoordinate O atoms proximate to the Sn atom. In FIG. 4D, three tetracoordinate O atoms exist in each of an upper half and a lower half. In the small group illustrated in FIG. 4D, electric charge is +1.

FIG. 4E illustrates a small group including two Zn atoms. In FIG. 4E, one tetracoordinate O atom exists in each of an upper half and a lower half. In the small group illustrated in FIG. 4E, electric charge is -1.

Here, a plurality of small groups form a medium group, and a plurality of medium groups form a large group.

Now, a rule of bonding between the small groups is described. The three O atoms in the upper half with respect to the hexacoordinate In atom in FIG. 4A has three proximate In atoms in the downward direction, and the three O atoms in the lower half has three proximate In atoms in the upward direction. The one O atom in the upper half with respect to the pentacoordinate Ga atom in FIG. 4B has one proximate Ga atom in the downward direction, and the one O atom in the lower half has one proximate Ga atom in the upward direction. The one O atom in the upper half with respect to the one tetracoordinate Zn atom in FIG. 4C has one proximate Zn atom in the downward direction, and the three O atoms in the lower half has three proximate Zn atoms in the upward direction. In this manner, the number of tetracoordinate O atoms above a metal atom is equal to the number of metal atoms proximate to and below the tetracoordinate O atoms; similarly, the number of tetracoordinate O atoms below a metal atom is equal to the number of metal atoms proximate to and above the tetracoordinate O atoms. Since the coordination number of the tetracoordinate O atom is 4, the sum of the number of metal atoms proximate to and below the O atom and the number of metal atoms proximate to and above the O atom is 4. Accordingly, when the sum of the number of tetracoordinate O atoms above a metal atom and the number of tetracoordinate O atoms below another metal atom is 4, the two kinds of small groups including the metal atoms can be bonded to each other. For example, in the case where the hexacoordinate metal (In or Sn) atom is bonded through three tetracoordinate O atoms in the lower half, it is bonded to the pentacoordinate metal (Ga or In) atom or the tetracoordinate metal (Zn) atom.

A metal atom whose coordination number is 4, 5, or 6 is bonded to another metal atom through a tetracoordinate O atom in the c-axis direction. In addition, a medium group can also be formed in a different manner by combining a plurality of small groups so that the total electric charge of the layered structure is 0.

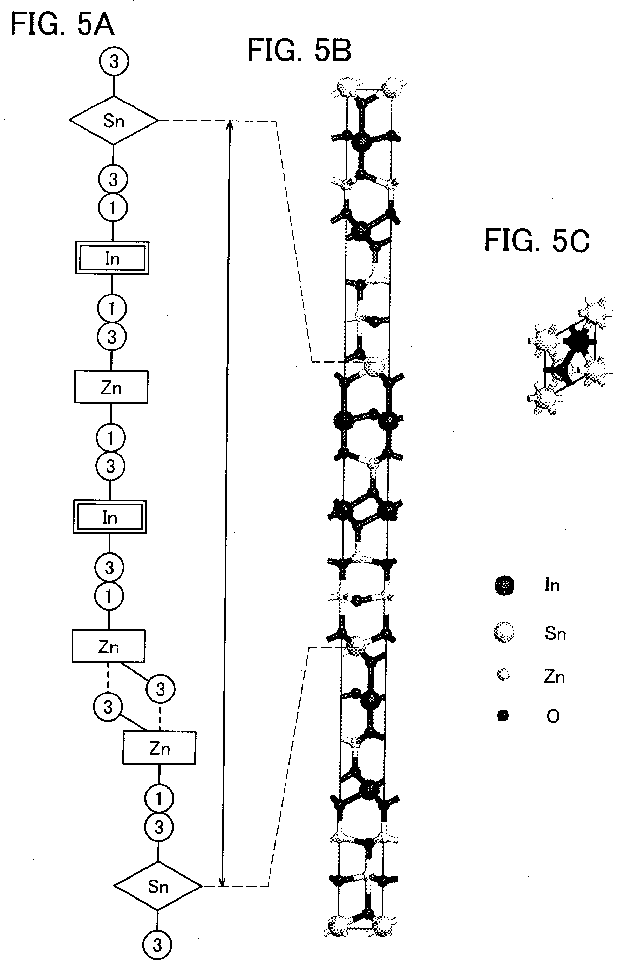

FIG. 5A illustrates a model of a medium group included in a layered structure of an In-Sn-Zn oxide. FIG. 5B illustrates a large group including three medium groups. FIG. 5C illustrates an atomic arrangement where the layered structure in FIG. 5B is observed from the c-axis direction.

In FIG. 5A, a tricoordinate O atom is omitted for easy understanding, and a tetracoordinate O atom is illustrated by a circle; the number in the circle shows the number of tetracoordinate O atoms. For example, three tetracoordinate O atoms existing in each of an upper half and a lower half with respect to a Sn atom are denoted by circled 3. Similarly, one tetracoordinate O atom existing in each of an upper half and a lower half with respect to an In atom is denoted by circled 1. Moreover, one tetracoordinate O atom existing in a lower half (or an upper half) with respect to a Zn atom is denoted by circled 1, and three tetracoordinate O atoms in an upper half (or a lower half) with respect to the Zn atom is denoted by circled 3.

In the medium group included in the layered structure of the In-Sn-Zn oxide in FIG. 5A, in the order starting from the top, a Sn atom proximate to three tetracoordinate O atoms in each of an upper half and a lower half is bonded to an In atom proximate to one tetracoordinate O atom in each of an upper half and a lower half, the In atom is bonded to a Zn atom proximate to three tetracoordinate O atoms in an upper half, the Zn atom is bonded to an In atom proximate to three tetracoordinate O atoms in each of an upper half and a lower half through one tetracoordinate O atom in a lower half with respect to the Zn atom, the In atom is bonded to a small group that includes two Zn atoms and is proximate to one tetracoordinate O atom in an upper half, and the small group is bonded to a Sn atom proximate to three tetracoordinate O atoms in each of an upper half and a lower half through one tetracoordinate O atom in a lower half with respect to the small group. A plurality of such medium groups are bonded, so that a large group is formed.

Here, electric charge for one bond of a tricoordinate O atom and electric charge for one bond of a tetracoordinate O atom can be assumed to be -0.667 and -0.5, respectively. For example, electric charge of a (hexacoordinate or pentacoordinate) In atom, electric charge of a (tetracoordinate) Zn atom, and electric charge of a (pentacoordinate or hexacoordinate) Sn atom are +3, +2, and +4, respectively. Accordingly, electric charge in a small group including a Sn atom is +1. Therefore, electric charge of -1, which cancels +1, is needed to form a layered structure in the small group including a Sn atom. As a structure having electric charge of -1, the small group including two Zn atoms as illustrated in FIG. 4E can be given. For example, with one small group including two Zn atoms, electric charge of one small group including a Sn atom is cancelled, so that the total electric charge of the layered structure can be 0.

Specifically, when the large group illustrated in FIG. 5B is repeated, a crystal of an In-Sn-Zn oxide ($In_2SnZn_3O_8$) can be obtained. Note that a layered structure of the obtained crystal of the In-Sn-Zn oxide can be expressed as a composition formula, $In_2SnZnO_6(ZnO)_m$ (m is 0 or a natural number).

The above-described rule also applies to the following oxides: an In-Sn-Ga-Zn oxide; an In-Ga-Zn oxide, an In-Al-Zn oxide; a Sn-Ga-Zn oxide; an Al-Ga-Zn oxide; a Sn-Al-Zn oxide; an In-Hf-Zn oxide; an In-La-Zn oxide; an In-Ce-Zn oxide; an In-Pr-Zn oxide; an In-Nd-Zn oxide; an In-Sm-Zn oxide; an In-Eu-Zn oxide; an In-Gd-Zn oxide; an In-Tb-Zn oxide; an In-Dy-Zn oxide; an In-Ho-Zn oxide; an In-Er-Zn oxide; an In-Tm-Zn oxide; an In-Yb-Zn oxide; an In-Lu-Zn oxide; an In-Zn oxide; a Sn-Zn oxide; an Al-Zn oxide; a Zn-Mg oxide; a Sn-Mg oxide; an In-Mg oxide; an In-Ga oxide; and the like.

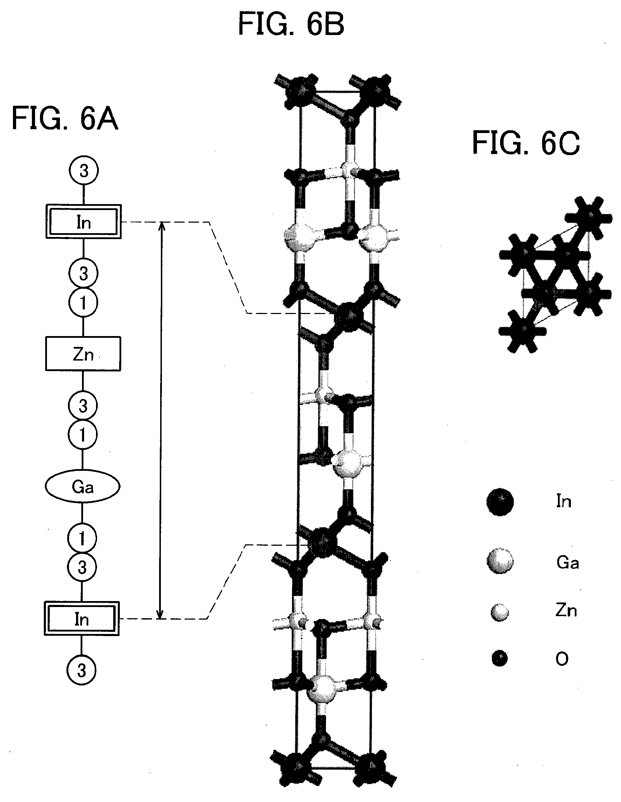

For example, FIG. 6A illustrates a model of a medium group included in a layered structure of an In-Ga-Zn oxide.

In the medium group included in the layered structure of the In-Ga-Zn oxide in FIG. 6A, in the order starting from the top, an In atom proximate to three tetracoordinate O atoms in each of an upper half and a lower half is bonded to a Zn atom proximate to one tetracoordinate O atom in an upper half, the Zn atom is bonded to a Ga atom proximate to one tetracoordinate O atom in each of an upper half and a lower half through three tetracoordinate O atoms in a lower half with respect to the Zn atom, and the Ga atom is bonded to an In atom proximate to three tetracoordinate O atoms in each of an upper half and a lower half through one tetracoordinate O atom in a lower half with respect to the Ga atom. A plurality of such medium groups are bonded, so that a large group is formed.

FIG. 6B illustrates a large group including three medium groups. Note that FIG. 6C illustrates an atomic arrangement in the case where the layered structure in FIG. 6B is observed from the c-axis direction.

Here, since electric charge of a (hexacoordinate or pentacoordinate) In atom, electric charge of a (tetracoordinate) Zn atom, and electric charge of a (pentacoordinate) Ga atom are +3, +2, and +3, respectively, electric charge of a small group including any of an In atom, a Zn atom, and a Ga atom is 0. As a result, the total electric charge of a medium group having a combination of such small groups is always 0.

In order to form the layered structure of the In-Ga-Zn oxide, a large group can be formed using not only the medium group illustrated in FIG. 6A but also a medium group in which the arrangement of the In atom, the Ga atom, and the Zn atom is different from that in FIG. 6A.

Specifically, when the large group illustrated in FIG. 6B is repeated, a crystal of an In-Ga-Zn oxide can be obtained. Note that a layered structure of the obtained crystal of the In-Ga-Zn oxide can be expressed as a composition formula, $InGaO_3(ZnO)_n$ ($n$ is a natural number).

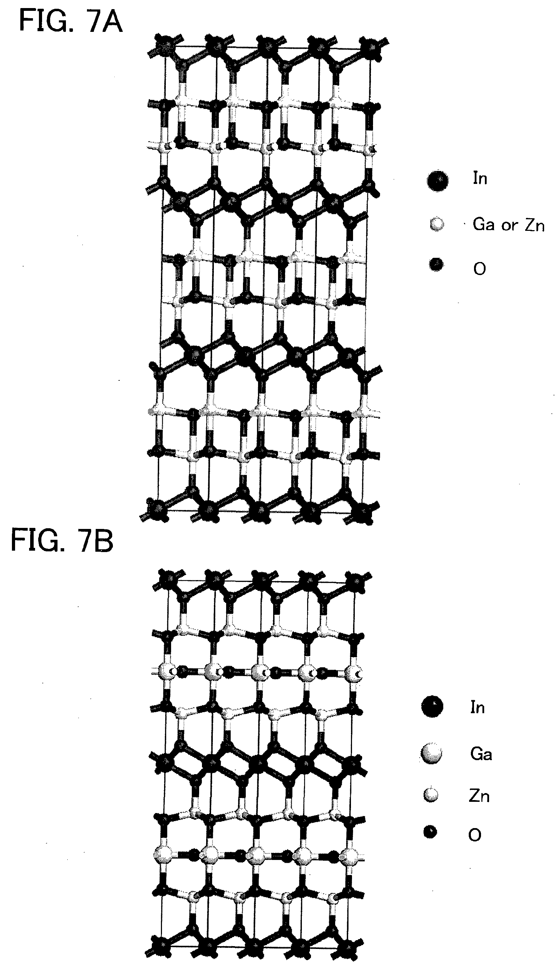

In the case where $n = 1$ ($InGaZnO_4$), a crystal structure illustrated in FIG. 7A can be obtained, for example. Note that since a Ga atom and an In atom each have five ligands in the crystal structure in FIG. 7A as described in FIG. 4B, a structure in which Ga is replaced with In can be obtained.

In the case where $n = 2$ ($InGaZn_2O_5$), a crystal structure illustrated in FIG. 7B can be obtained, for example. Note that since a Ga atom and an In atom each have five ligands in the crystal structure in FIG. 7B as described in FIG. 4B, a structure in which Ga is replaced with In can be obtained.

The reason why the In-Ga-Zn oxide has a high proportion of crystals with surface structures of planes parallel to the a-b plane is described below.

When a crystal has an equilibrium form, the area of a surface along a plane having a small surface energy becomes large. Also, cleavage of a crystal is likely to occur in a plane having a small surface energy. Calculation results of the surface energy of each plane are described below.

Here, the surface energy refers to an energy obtained by subtracting the energy of a crystal structure from the energy of a surface structure and then dividing the value by a surface area.

First principle calculation software, CASTEP, which is based on the density functional theory was used for the calculation, an ultrasoft type was used for pseudopotential, and the cut-off energy was 400 eV.

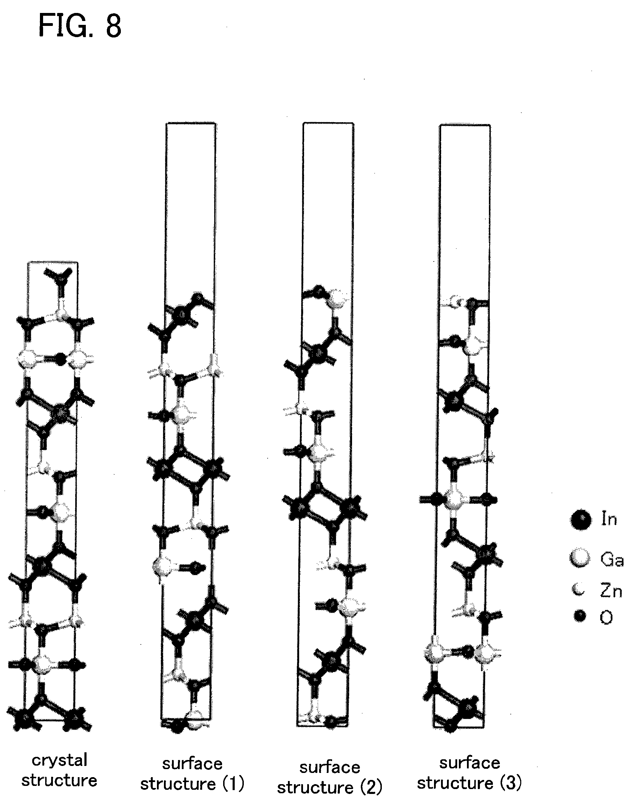

FIGS. 8 to 11 each illustrate a crystal structure and a surface structure used for the calculation. Note that in the surface structures in FIGS. 8 to 11, a spatial portion indicates a vacuum. That is, a plane in contact with the spatial portion is a surface. Note that although there are both an upper surface and a lower surface, a lower space is omitted for easy understanding.

The surface energy of a surface structure (1) in FIG. 8 is an average value of a surface energy of a (001) plane including In and O and a surface energy of a (001) plane including Ga and O. The surface energy of a surface structure (2) is an average value of a surface energy of a (001) plane including Ga and O and a surface energy of a (001) plane including Zn and O. The surface energy of a surface structure (3) is an average value of a surface energy of a (001) plane including Zn and O and a surface energy of a (001) plane including In and O. The surface energy of the (001) plane including In and O, the surface energy of the (001) plane including Ga and O, and the surface energy of the (001) plane including Zn and O were calculated by simultaneously calculating the obtained surface energies of the surface structure (1), the surface structure (2), and the surface structure (3). In this specification, planes parallel to an a-b plane are in some cases described for simplicity as a (001) plane. Note that in some cases, other planes (e.g., a (100) plane and a (10-1) plane) are described in a similar manner.

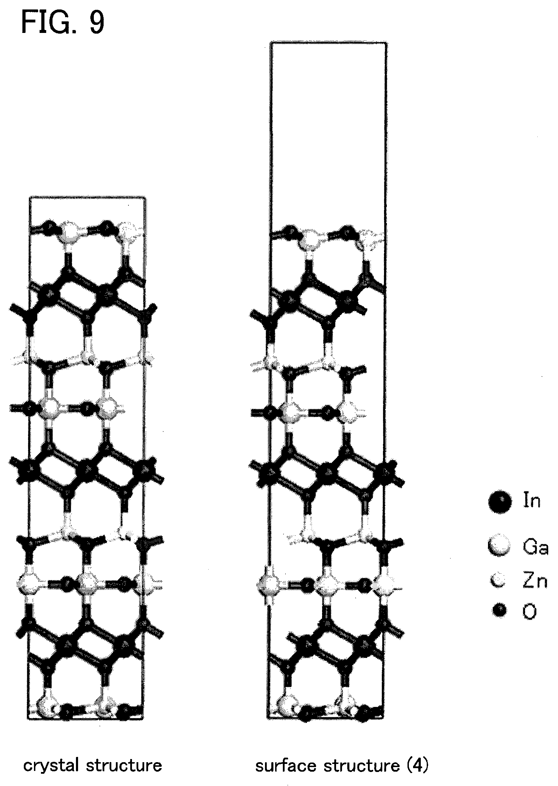

A surface structure (4) illustrated in FIG. 9 is a (001) plane in which Ga and Zn are mixed, which exists both at an upper surface and a lower surface.

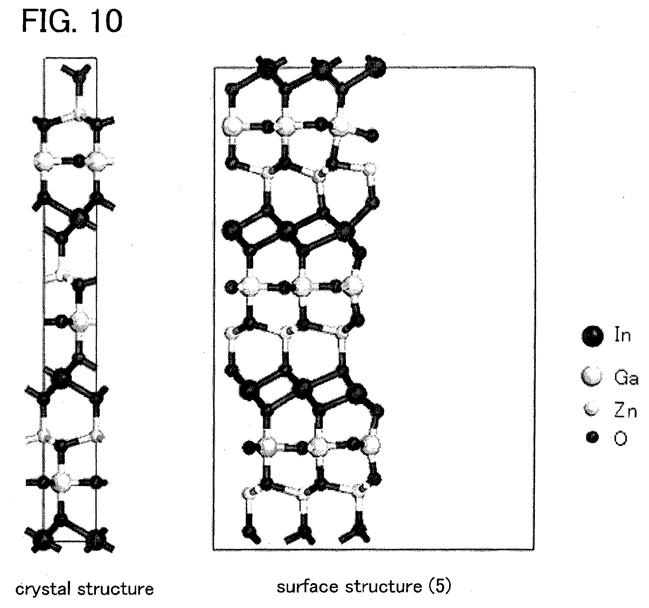

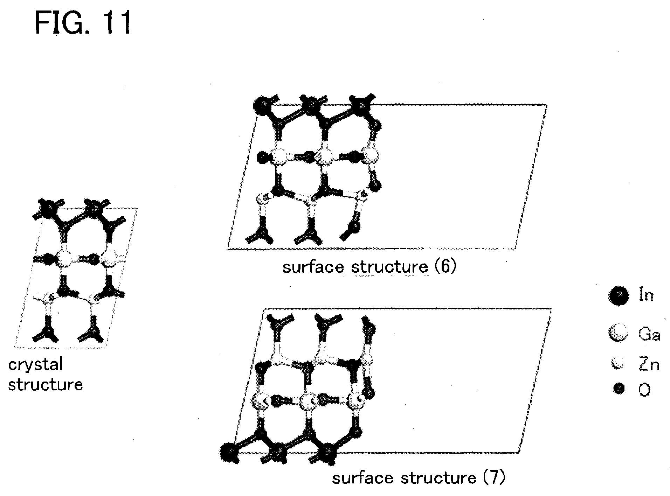

Note that a structure illustrated in FIG. 10 and a structure illustrated in FIG. 11 are a (100) plane and a (10-1) plane, respectively. Note that the (100) plane and the (10-1) plane each include plural kinds of surface energies. Since there are all kinds of elements in the outermost surfaces of the (100) plane and the (10-1) plane, an average value of typical two surface energies was regarded here as a surface energy of each plane. In addition, two kinds of a surface structure (6) and a surface structure (7), which were given as the (10-1) plane, were described as a (10-1) plane_a and a (10-1) plane_b, respectively, to distinguish between them.

The surface energy of the surface structure (1) was 1.54 J/m².

The surface energy of the surface structure (2) was 1.24 J/m².

The surface energy of the surface structure (3) was 1.57 J/m².

When the surface energies of the surface structure (1), the surface structure (2), and the surface structure (3) were simultaneously calculated, the surface energy of the (001) plane including In and O was 1.88 J/m$^2$.

When the surface energies of the surface structure (1), the surface structure (2), and the surface structure (3) were simultaneously calculated, the surface energy of the (001) plane including Ga and O was 1.21 J/m$^2$.

When the surface energies of the surface structure (1), the surface structure (2), and the surface structure (3) were simultaneously calculated, the surface energy of the (001) plane including Zn and O was 1.26 J/m$^2$.

The surface energy of the surface structure (4) was 0.35 J/m$^2$.

The surface energy of the surface structure (5) was 1.64 J/m$^2$.

The surface energy of the surface structure (6) was 1.72 J/m$^2$.

The surface energy of the surface structure (7) was 1.79 J/m$^2$.

The above calculation results show that the surface energy of the surface structure (4) is the smallest, i.e., a (001) plane in which Ga and Zn are mixed has the smallest surface energy when considered as a surface.

Therefore, it can be seen that the crystal of the In-Ga-Zn oxide has high proportion of surface structures of planes parallel to the *a-b* plane.

Further, one embodiment of the present invention is a transistor including the above oxide film as a channel region.

Further, one embodiment of the present invention is a semiconductor device including the transistor.

It is possible to provide a transistor which has stable electrical characteristics with the use of an oxide film with a high degree of crystallinity.

In addition, it is possible to provide a highly reliable semiconductor device with the use of the transistor.

BRIEF DESCRIPTION OF DRAWINGS

FIGS. 1A and 1B are schematic diagrams illustrating a state in which sputtered particles are separated from a sputtering target.

FIGS. 2A and 2B are schematic diagrams each illustrating a state in which sputtered particles reach a deposition surface.

FIGS. 3A and 3B illustrate a crystal structure of an oxide semiconductor of one embodiment of the present invention.

FIGS. 4A to 4E each illustrate a crystal structure of an oxide semiconductor of one embodiment of the present invention.

FIGS. 5A to 5C illustrate a crystal structure of an oxide semiconductor of one embodiment of the present invention.

FIGS. 6A to 6C illustrate a crystal structure of an oxide semiconductor of one embodiment of the present invention.

FIGS. 7A and 7B each illustrate a crystal structure of an oxide semiconductor of one embodiment of the present invention.

FIG. 8 illustrates a crystal structure and surface structures.

FIG. 9 illustrates a crystal structure and a surface structure.

FIG. 10 illustrates a crystal structure and a surface structure.

FIG. 11 illustrates a crystal structure and surface structures.

FIG. 12 is a top view which illustrates an example of a film formation apparatus.

FIGS. 13A to 13C illustrate a structure example of a film formation chamber.

FIGS. 14A to 14D each illustrate a positional relation of a sputtering target, a magnet, and a substrate holder.

FIGS. 15A and 15B are flow charts illustrating an example of a method for manufacturing a sputtering target.

FIGS. 16A to 16C are a top view and cross-sectional views illustrating an example of a transistor.

FIGS. 17A to 17C are a top view and cross-sectional views illustrating an example of a transistor;

FIGS. 18A to 18C are a top view and cross-sectional views illustrating an example of a transistor.

FIGS. 19A to 19C are a top view and cross-sectional views illustrating an example of a transistor.

FIGS. 20A to 20C are a top view and cross-sectional views illustrating an example of a transistor.

FIGS. 21A to 21C are a top view and cross-sectional views illustrating an example of a transistor.

FIGS. 22A and 22B are a circuit diagram and a cross-sectional view of a semiconductor device of one embodiment of the present invention.

FIGS. 23A and 23B are each a circuit diagram of a semiconductor device of one embodiment of the present invention.

FIGS. 24A and 24B are a circuit diagram and a cross-sectional view of a semiconductor device of one embodiment of the present invention.

FIG. 25 is a circuit diagram of a semiconductor device of one embodiment of the present invention.

FIGS. 26A to 26D are circuit diagrams, a cross-sectional view, and a graph showing electrical characteristics of a semiconductor device of one embodiment of the present invention.

FIGS. 27A to 27C are a circuit diagram, a graph showing electrical characteristics, and a cross-sectional view of a semiconductor device of one embodiment of the present invention.

FIGS. 28A to 28C are block diagrams illustrating a structure of a CPU of one embodiment of the present invention.

FIG. 29 is a circuit diagram of part of a pixel of a display device using an EL element of one embodiment of the present invention.

FIGS. 30A to 30C are a top view and a cross-sectional view, and a cross-sectional view of a light-emitting layer, of a display device using an EL element of one embodiment of the present invention.

FIGS. 31A and 31B are each a cross-sectional view of a display device using an EL element of one embodiment of the present invention.

FIG. 32 is a circuit diagram of a pixel of a display device using a liquid crystal element of one embodiment of the present invention.

FIGS. 33A to 33C are each a cross-sectional view of a display device using a liquid crystal element of one embodiment of the present invention.

FIGS. 34A to 34D each illustrate an electronic device of one embodiment of the present invention.

FIGS. 35A, 35B-1 and 35B-2, and 35C are diagrams for describing a discharge state when sputtering is performed using an AC power source.

BEST MODE FOR CARRYING OUT THE INVENTION

Embodiments of the present invention are described in detail below with reference to the accompanying drawings. However, the present invention is not limited to the description below, and it is easily understood by those skilled in the art that modes and details thereof can be modified in various ways. Therefore, the present invention is not construed as being limited to description of the embodiments. In describing structures of the present invention with reference to the drawings, the same reference numerals are used in common for the same portions in different drawings. Note that the same hatch pattern is applied to similar parts, and the similar parts are not especially denoted by reference numerals in some cases.

Note that the ordinal numbers such as "first" and "second" in this specification are used for convenience and do not denote the order of steps or the stacking order of layers. In addition, the ordinal numbers in this specification do not denote particular names which specify the present invention.

[Embodiment 1]

In this embodiment, a method for using a sputtering target including a polycrystalline oxide is described.

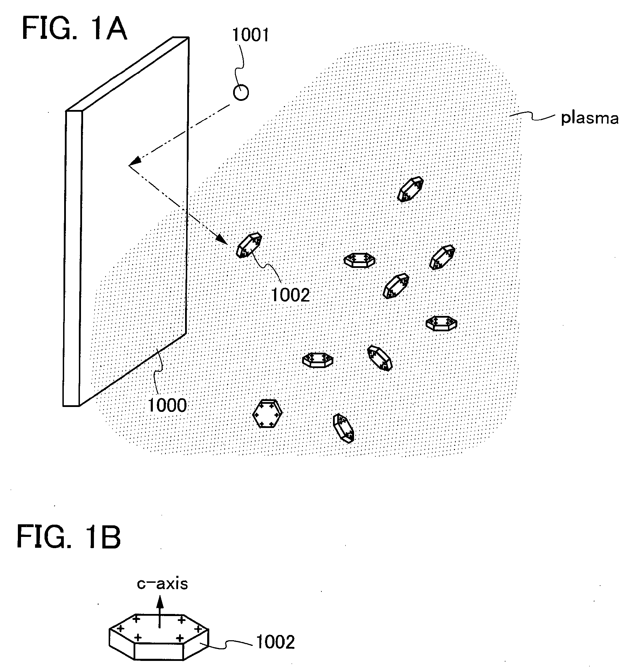

FIG. 1A is a schematic diagram illustrating a state in which an ion 1001 collides with a sputtering target 1000 to separate sputtered particles 1002 from the sputtering target 1000. Note that the sputtered particle 1002 may have the shape of a hexagonal cylinder whose hexagonal planes are parallel to an $a$-$b$ plane. In that case, the direction perpendicular to the hexagonal planes is a $c$-axis direction (see FIG. 1B). The diameter of the plane of the sputtered particle 1002, which is parallel to the $a$-$b$ plane, is approximately greater than or equal to 1 nm and less than or equal to 30 nm or greater than or equal to 1 nm and less than or equal to 10 nm, though it differs depending on the kind of oxide. Note that an oxygen cation is used as the ion 1001. An argon cation may be used in addition to the oxygen cation. Note that a cation of another rare gas may be used instead of an argon cation.

With the use of an oxygen cation as the ion 1001, plasma damage at the film formation can be alleviated. Thus, when the ion 1001 collides with the surface of the sputtering target 1000, a deterioration in crystallinity of the sputtering target 1000 can be suppressed or a change of the sputtering target 1000 into an amorphous state can be suppressed.

It is preferable that the separated sputtered particles 1002 be positively charged. However, there is no particular limitation on the timing at which the sputtered particles 1002 are positively charged. Specifically, a sputtered particle 1002 is in some cases positively charged by being exposed to plasma. Alternatively, a sputtered particle 1002 is in some cases positively charged by receiving an electric charge at the collision of the ion 1001. Further alternatively, a sputtered particle 1002 is in some cases positively charged in such a manner that the ion 1001 which is an oxygen cation is bonded with a side, top, or bottom surface of the sputtered particle 1002.

In the sputtered particle 1002, the corners of the hexagonal plane are positively charged, whereby positive charges of the hexagonal plane repel each other. Thus, flat-plate shapes of the sputtered particles 1002 can be maintained.

It is preferable to use a direct-current (DC) power source to positively charge the corners of the hexagonal plane of the sputtered particle 1002. Note that a radio frequency (RF) power source or an alternating-current (AC) power source can also be used. Note that it is difficult to use an RF power source for a sputtering apparatus which is capable of performing deposition to a large-sized substrate. In addition, a DC power source is preferred to an AC power source from the viewpoint below.

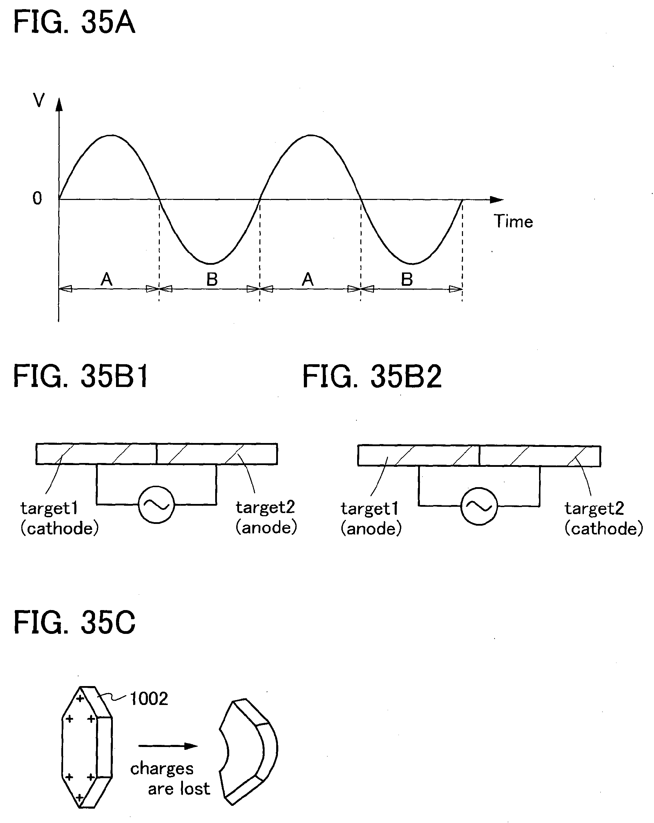

In the AC power source, adjacent targets alternately have a cathode potential and an anode potential. In a period A shown in FIG. 35A, a target 1 functions as a cathode and a target 2 functions as an anode as illustrated in FIG. 35B-1. In a period B shown in FIG. 35A, the target 1 functions as an anode and the target 2 functions as a cathode as illustrated in FIG. 35B-2. The total time of the period A and the period B is 20 μsec to 50 μsec and the period A and the period B are repeated at a constant frequency.

In the case where the sputtered particle 1002 is positively charged, positive charges in the sputtered particle 1002 repel each other, whereby flat-plate shapes of the sputtered particles 1002 can be maintained. However, in the case where the AC power source is used, there is time during which an electric field is not applied instantaneously; therefore, some charges of the sputtered particle 1002 are lost and the structure of the sputtered particle might be broken (see FIG. 35C). Thus, a DC power source is preferred to an AC power source.

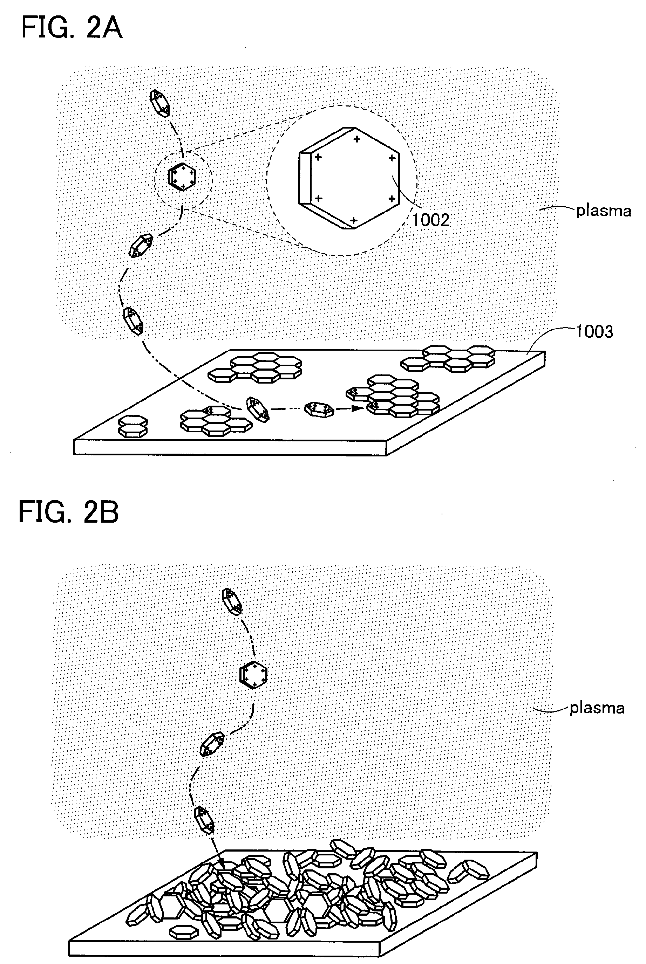

A state in which sputtered particles are deposited on a deposition surface is described below with reference to FIGS. 2A and 2B. Note that FIG. 2A illustrates the case where film formation is performed with substrate heating, whereas FIG. 2B illustrates the case where film formation is performed without substrate heating.

As illustrated in FIG. 2A, in the case with substrate heating, one sputtered particle 1002 moves to a region of the deposition surface 1003, where other sputtered particles 1002 have not been deposited yet, and migration of the sputtered particle 1002 occurs, whereby the sputtered particle 1002 is bonded to the side of the sputtered particles which are already deposited. In this manner, the sputtered particles 1002 are spread over the deposition surface 1003 with flat plate planes facing upward. The c-axes of the deposited sputtered particles 1002 are aligned in one direction perpendicular to the deposition surface 1003; accordingly, a CAAC-OS film is obtained. Moreover, an oxide film which is obtained by the deposition has a uniform thickness and a uniform crystal orientation.

The CAAC-OS film which is obtained by such a mechanism has high crystallinity even on an amorphous surface, a surface of an amorphous insulating film, a surface of an amorphous oxide film, or the like.

As illustrated in FIG. 2B, in the case without substrate heating, sputtered particles 1002 fall irregularly to a deposition surface 1003. Thus, the sputtered particles 1002 are deposited randomly also in a region where other sputtered particles 1002 are already deposited. That is, an oxide film which is obtained by the deposition has neither a uniform thickness nor a uniform crystal orientation. The oxide film which is obtained in such a manner is a microcrystalline oxide film because the crystallinity of flat plate-like sputtered particles 1002 is maintained to some extent.

Note that the deposition surface 1003 preferably has an insulating property. With the deposition surface 1003 having an insulating property, the sputtered particles 1002 which are deposited on the deposition surface 1003 are unlikely to loose positive charges. However, in the case where the deposition rate of the sputtered particles 1002 is less than the rate at which a positive charge is lost, the deposition surface 1003 may have conductivity.

With the use of a sputtering target in the way as described above, an oxide film having a uniform thickness and a uniform crystal orientation can be formed.

This embodiment can be implemented in appropriate combination with any of the other embodiments.

[Embodiment 2]

In this embodiment, a film formation apparatus for forming the oxide film with a high degree of crystallinity described in Embodiment 1 is described.

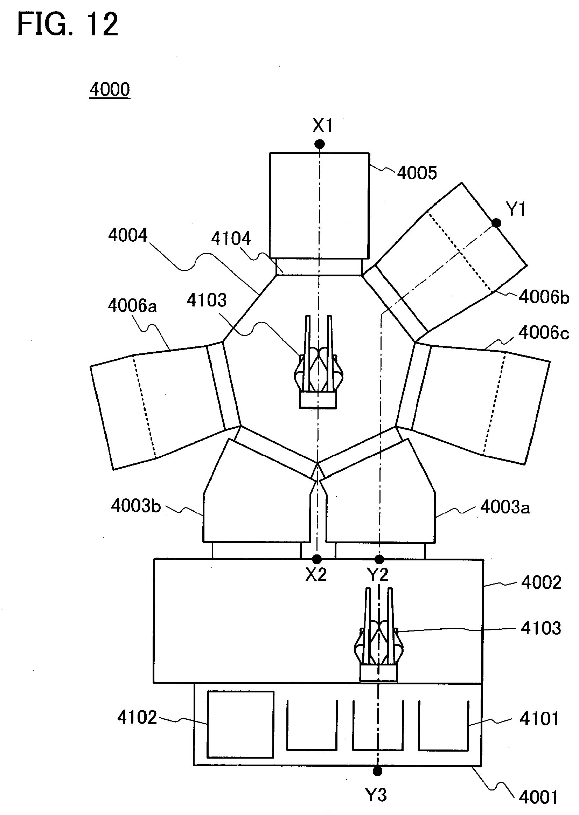

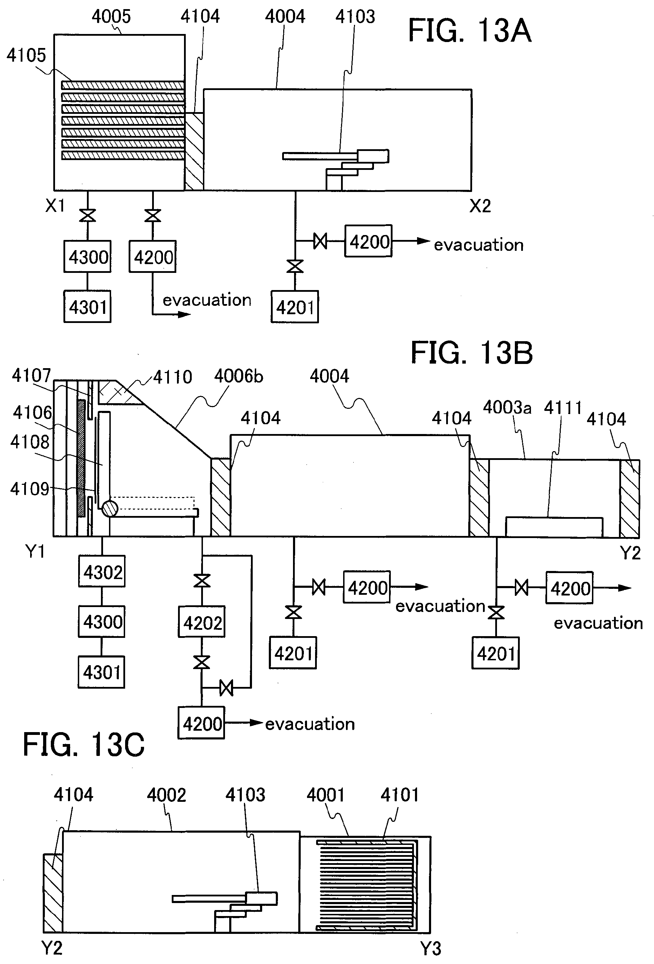

First, a structure of a film formation apparatus which allows the entry of few impurities into a film during film formation is described with reference to FIG. 12 and FIGS. 13A to 13C.

FIG. 12 is a top view schematically illustrating a single wafer multi-chamber film formation apparatus 4000. The film formation apparatus 4000 includes an atmosphere-side substrate supply chamber 4001 including a cassette port 4101 for holding a substrate and an alignment port 4102 for performing alignment of a substrate, an atmosphere-side substrate transfer chamber 4002 through which a substrate is transferred from the atmosphere-side substrate supply chamber 4001, a load lock chamber 4003a where a substrate is carried and the pressure inside the chamber is switched from an atmospheric pressure to a reduced pressure or from a reduced pressure to an atmospheric pressure, an unload lock chamber 4003b where a substrate is carried out and the pressure inside the chamber is switched from a reduced pressure to an atmospheric pressure or from an atmospheric pressure to a reduced pressure, a transfer chamber 4004 through which a substrate is transferred in a vacuum, a substrate heating chamber 4005 where a substrate is heated, and film formation chambers 4006a, 4006b, and 4006c in each of which a target is placed for film formation.

Note that a plurality of the cassette ports 4101 may be provided as illustrated in FIG. 12 (in FIG. 12, three cassette ports 4101 are provided).

The atmosphere-side substrate transfer chamber 4002 is connected to the load lock chamber 4003a and the unload lock chamber 4003b, the load lock chamber 4003a and the unload lock chamber 4003b are connected to the transfer chamber 4004, and the transfer chamber 4004 is connected to the substrate heating chamber 4005 and the film formation chambers 4006a, 4006b, and 4006c.

Gate valves 4104 are provided for connecting portions between chambers so that each chamber except the atmosphere-side substrate supply chamber 4001 and the atmosphere-side substrate transfer chamber 4002 can be independently kept under vacuum. Moreover, the atmosphere-side substrate transfer chamber 4002 and the transfer chamber 4004 each include a transfer robot 4103, with which a glass substrate can be transferred.

Further, it is preferable that the substrate heating chamber 4005 also serve as a plasma treatment chamber. In the film formation apparatus 4000, it is possible to transfer a substrate without exposure to the air between treatment and treatment; therefore, adsorption of impurities on a substrate can be suppressed. In addition, the order of film formation, heat treatment, or the like can be freely determined. Note that the number of the transfer chambers, the number of the film formation chambers, the number of the load lock chambers, the number of the unload lock chambers, and the number of the substrate heating chambers are not limited to the above, and the numbers thereof can be set as appropriate depending on the space for placement or the process conditions.

Next, FIG. 13A, FIG. 13B, and FIG. 13C are a cross-sectional view taken along dashed-dotted line X1-X2, a cross-sectional view taken along dashed-dotted line Y1-Y2, and a cross-sectional view taken along dashed-dotted line Y2-Y3, respectively, in the film formation apparatus 4000 illustrated in FIG. 12.

FIG. 13A is a cross section of the substrate heating chamber 4005 and the transfer chamber 4004, and the substrate heating chamber 4005 includes a plurality of heating stages 4105 which can hold a substrate. Note that although the substrate heating chamber 4005 including the seven heating stages 4105 is illustrated in FIG. 13A, one embodiment of the present invention is not limited to such a structure. The number of heating stages 4105 may be greater than or equal to one and less than seven. Alternatively, the number of heating stages 4105 may be greater than or equal to eight. It is preferable to increase the number of the heating stages 4105 because a plurality of substrates can be subjected to heat treatment at the same time, which leads to an increase in productivity. Further, the substrate heating chamber 4005 is connected to a vacuum pump 4200 through a valve. As the vacuum pump 4200, a dry pump and a mechanical booster pump can be used, for example.

As heating mechanism which can be used for the substrate heating chamber 4005, a resistance heater or the like may be used for heating, for example. Alternatively, heat conduction or heat radiation from a medium such as a heated gas may be used as the heating mechanism. For example, a rapid thermal annealing (RTA) apparatus such as a gas rapid thermal annealing (GRTA) apparatus or a lamp rapid thermal annealing (LRTA) apparatus can be used. The LRTA apparatus is an apparatus for heating an object by radiation of light (an electromagnetic wave) emitted from a lamp such as a halogen lamp, a metal halide lamp, a xenon arc lamp, a carbon arc lamp, a high-pressure sodium lamp, or a high-pressure mercury lamp. In the GRTA apparatus, heat treatment is performed using a high-temperature gas. An inert gas is used as the gas.

Moreover, the substrate heating chamber 4005 is connected to a refiner 4301 through a mass flow controller 4300. Note that although refiner 4301 and the mass flow controller 4300 can be provided for each of a plurality of kinds of gases, only one refiner 4301 and one mass flow controller 4300 are provided for easy understanding. As the gas introduced to the substrate heating chamber 4005, a gas whose dew point is -80 °C or lower, preferably -100 °C or lower can be used; for example, an oxygen gas, a nitrogen gas, and a rare gas (e.g., an argon gas) are used.

The transfer chamber 4004 includes the transfer robot 4103. The transfer robot 4103 includes a plurality of movable portions and an arm for holding a substrate and can transfer a substrate to each chamber. Further, the transfer chamber 4004 is connected to a vacuum pump 4200 and a cryopump 4201 through valves. With such a structure, evacuation can be performed using the vacuum pump 4200 when the pressure inside the transfer chamber 4004 is in the range of an atmospheric pressure to a low vacuum (approximately 0.1 Pa to several hundred Pa) and then, by switching the valves, evacuation can be performed using the cryopump 4201 when the pressure inside the transfer chamber 4004 is in the range of middle vacuum to ultra-high vacuum (0.1 Pa to $1 \times 10^{-7}$ Pa).

Alternatively, two or more cryopumps 4201 may connected in parallel to the transfer chamber 4004. With such a structure, even when one of the cryopumps is in regeneration, evacuation can be performed using any of the other cryopumps. Note that the above regeneration refers to treatment for discharging molecules (or atoms) entrapped in the cryopump. When molecules (or atoms) are entrapped too much in a cryopump, the evacuation capability of the cryopump is lowered; therefore, regeneration is performed regularly.

FIG. 13B is a cross section of the film formation chamber 4006b, the transfer chamber 4004, and the load lock chamber 4003a.

Here, the details of the film formation chamber (sputtering chamber) are described with reference to FIG. 13B. The film formation chamber 4006b illustrated in FIG. 13B includes a target 4106, an attachment protection plate 4107, and a substrate stage 4108. Note that here, a substrate 4109 is provided on the substrate stage 4108. Although not illustrated, the substrate stage 4108 may include a substrate holding mechanism which holds the substrate 4109, a rear heater which heats the substrate 4109 from the back surface, or the like.

Note that the substrate stage 4108 is held substantially vertically to a floor during film formation and is held substantially parallel to the floor when the substrate is delivered. In FIG. 13B, the position where the substrate stage 4108 is held when the substrate is delivered is denoted by a dashed line. With such a structure, the probability that dust or a particle which might be entered at the film formation is attached to the substrate 4109 can be suppressed as compared to the case where the substrate stage 4108 is held parallel to the floor. However, there is a possibility that the substrate 4109 falls when the substrate stage 4108 is held vertically (90°) to the floor; therefore, the angle of the substrate stage 4108 to the floor is preferably wider than or equal to 80° and narrower than 90°.

The attachment protection plate 4107 can suppress deposition of a particle which is sputtered from the target 4106 on a region where deposition is not needed. Moreover, the attachment protection plate 4107 is preferably processed to prevent accumulated sputtered particles from being separated. For example, blasting treatment which increases surface roughness may be performed, or roughness may be formed on the surface of the attachment protection plate 4107.

The film formation chamber 4006b is connected to a mass flow controller 4300 through a gas heating system 4302, and the gas heating system 4302 is connected to a refiner 4301 through the mass flow controller 4300. With the gas heating system 4302, a gas to be introduced to the film formation chamber 4006b can be heated to a temperature higher than or equal to 40 °C and lower than or equal to 400 °C, preferably higher than or equal to 50 °C and lower than or equal to 200 °C. Note that although the gas heating system 4302, the mass flow controller 4300, and the refiner 4301 can be provided for each of a plurality of kinds of gases, only one gas heating system 4302, one mass flow controller 4300, and one refiner 4301 are provided for easy understanding. As the gas introduced to the film formation chamber 4006b, a gas whose dew point is -80 °C or lower, preferably -100 °C or lower can be used; for example, an oxygen gas, a nitrogen gas, and a rare gas (e.g., an argon gas) are used.

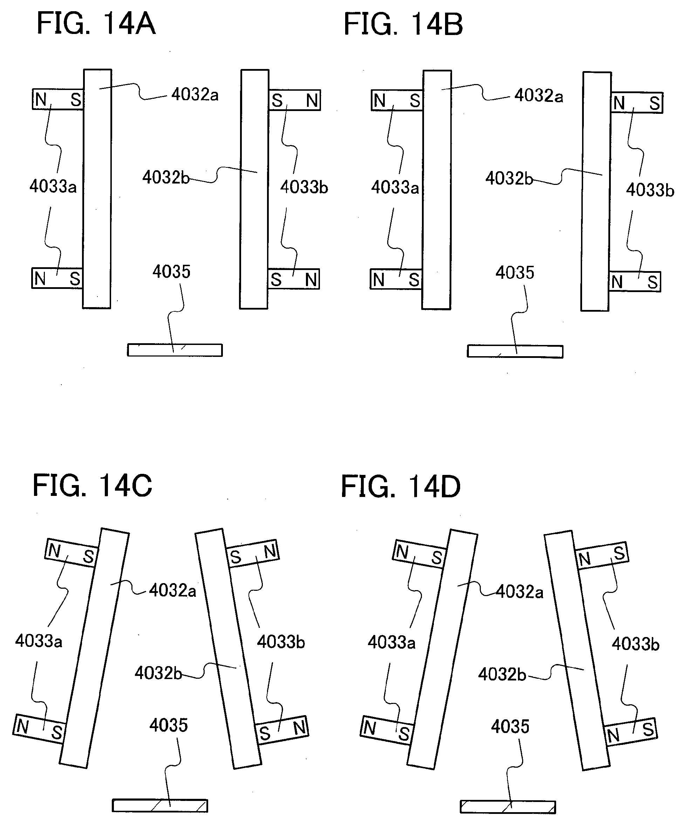

A facing-target-type sputtering apparatus may be provided in the film formation chamber 4006b. The specific positional relation of a sputtering target, a magnet, and a substrate holder is described with reference to FIGS. 14A to 14D.

Each of the structures illustrated in FIGS. 14A to 14D includes a first sputtering target 4032a, a second sputtering target 4032b, first cathode magnets 4033a, second cathode magnets 4033b, and a substrate holder 4035. That is, FIGS. 14A to 14D differ only in positions of the above components.

In the structure illustrated in FIG. 14A, the first sputtering target 4032a and the second sputtering target 4032b are provided parallel to face each other. The first cathode magnet 4033a and the second cathode magnet 4033b are provided so that the same polarities face each other. Note that although the first cathode magnet 4033a and the second cathode magnet 4033b are provided so that the S-poles thereof face each other, they may be provided so that the N-poles thereof face each other. The substrate holder 4035 is provided on a lower side of a region where the first sputtering target 4032a and the second sputtering target 4032b face each other; however, the substrate holder 4035 may be provided on an upper side thereof. Alternatively, the substrate holder 4035 may be provided on the upper side and the lower side thereof. When the substrate holder 4035 is provided on the upper side and the lower side, the productivity of the oxide film can be improved. Note that although the substrate holder 4035 is provided so that the top surface thereof is perpendicular to the top surfaces of the first sputtering target 4032a and the second sputtering target 4032b, the substrate holder 4035 may be inclined. With the positional relation illustrated in FIG. 14A, the deposition rate can be increased.

In the structure illustrated in FIG. 14B, the first sputtering target 4032a and the second sputtering target 4032b are provided parallel to face each other. The first cathode magnet 4033a and the second cathode magnet 4033b are provided so that different polarities face each other. The substrate holder 4035 is provided on a lower side of a region where the first sputtering target 4032a and the second sputtering target 4032b face each other; however, the substrate holder 4035 may be provided on an upper side thereof. Alternatively, the substrate holder 4035 may be provided on the upper side and the lower side thereof. When the substrate holder 4035 is provided on the upper side and the lower side, the productivity of the oxide film can be improved. Note that although the substrate holder 4035 is provided so that the top surface thereof is perpendicular to the top surfaces of the first sputtering target 4032a and the second sputtering target 4032b, the substrate holder 4035 may be inclined. With the positional relation illustrated in FIG. 14B, the deposition rate can be increased.

In the structure illustrated in FIG. 14C, the first sputtering target 4032a and the second sputtering target 4032b are provided to face each other with symmetrical inclination (in an inverted V shape). The first cathode magnet 4033a and the second cathode magnet 4033b are provided so that the same polarities face each other. Note that although the first cathode magnet 4033a and the second cathode magnet 4033b are provided so that the S-poles thereof face each other, they may be provided so that the N-poles thereof face each other. The substrate holder 4035 is provided on a lower side of a region where the first sputtering target 4032a and the second sputtering target 4032b face each other (the side on which a distance between the targets is larger). With the positional relation illustrated in FIG. 14C, the deposition rate can be increased because sputtered particles efficiently fall to the substrate holder 4035.

In the structure illustrated in FIG. 14D, the first sputtering target 4032a and the second sputtering target 4032b are provided to face each other with symmetrical inclination (in an inverted V shape). The first cathode magnet 4033a and the second cathode magnet 4033b are provided so that different polarities face each other. The substrate holder 4035 is provided on a lower side of a region where the first sputtering target 4032a and the second sputtering target 4032b face each other (the side on which a distance between the targets is larger). With the positional relation illustrated in FIG. 14D, the deposition rate can be increased because sputtered particles efficiently fall to the substrate holder 4035.

In each of the above-described structures of the facing-target-type sputtering apparatus, plasma is confined between the targets; therefore, plasma damage to a substrate can be reduced. Further, step coverage can be improved because an incident angle of a sputtered particle to the substrate can be made smaller depending on the inclination of the target.

Note that a parallel plate type sputtering apparatus or an ion beam sputtering apparatus may be provided in the film formation chamber 4006b.

In the case where the refiner is provided just before the gas is introduced, the length of a pipe between the refiner and the film formation chamber 4006b is less than or equal to 10 m, preferably less than or equal to 5 m, more preferably less than or equal to 1 m. When the length of the pipe is less than or equal to 10 m, less than or equal to 5m, or less than or equal to 1 m, the effect of the release of gas from the pipe can be reduced accordingly. As the pipe for the gas, a metal pipe the inside of which is covered with an iron fluoride, an aluminum oxide, a chromium oxide, or the like can be used. With the above pipe, the amount of released gas containing impurities is made small and the entry of impurities into the gas can be reduced as compared with a SUS316L-EP pipe, for example. Further, a high-performance ultra-compact metal gasket joint (UPG joint) may be used as a joint of the pipe. A structure where all the materials of the pipe are metals is preferable because the effect of the generated released gas or the external leakage can be reduced compared with a structure where resin or the like is used.

The film formation chamber 4006b is connected to a turbo molecular pump 4202 and a vacuum pump 4200 through valves.

In addition, the film formation chamber 4006b is provided with a cryotrap 4110.

The cryotrap 4110 is a mechanism which can adsorb a molecule (or an atom) having a relatively high melting point, such as water. The turbo molecular pump 4202 is capable of stably evacuating a large-sized molecule (or atom), needs low frequency of maintenance, and thus enables high productivity, whereas it has a low capability in evacuating hydrogen and water. Hence, the cryotrap 4110 is connected to the film formation chamber 4006b so as to have a high capability in evacuating water or the like. The temperature of a refrigerator of the cryotrap 4110 is set to be lower than or equal to 100 K, preferably lower than or equal to 80 K. In the case where the cryotrap 4110 includes a plurality of refrigerators, it is preferable to set the temperature of each refrigerator at a different temperature because efficient evacuation is possible. For example, the temperatures of a first-stage refrigerator and a second-stage refrigerator may be set at lower than or equal to 100 K and lower than or equal to 20 K, respectively.

Note that the evacuation method of the film formation chamber 4006b is not limited to the above, and a structure similar to that in the evacuation method described in the transfer chamber 4004 (the evacuation method using the cryopump and the vacuum pump) may be employed. Needless to say, the evacuation method of the transfer chamber 4004 may have a structure similar to that of the film formation chamber 4006b (the evacuation method using the turbo molecular pump and the vacuum pump).

Note that in each of the above transfer chamber 4004, the substrate heating chamber 4005, and the film formation chamber 4006b, the back pressure (total pressure) and the partial pressure of each gas molecule (atom) are preferably set as follows. In particular, the back pressure and the partial pressure of each gas molecule (atom) in the film formation chamber 4006b need to be noted because impurities might enter a film to be formed.

In each of the above chambers, the back pressure (total pressure) is less than or equal to $1 \times 10^{-4}$ Pa, preferably less than or equal to $3 \times 10^{-5}$ Pa, more preferably less than or equal to $1 \times 10^{-5}$ Pa. In each of the above chambers, the partial pressure of a gas molecule (atom) having a mass-to-charge ratio ($m/z$) of 18 is less than or equal to $3 \times 10^{-5}$ Pa, preferably less than or equal to $1 \times 10^{-5}$ Pa, more preferably less than or equal to $3 \times 10^{-6}$ Pa. Moreover, in each of the above chambers, the partial pressure of a gas molecule (atom) having a mass-to-charge ratio ($m/z$) of 28 is less than or equal to $3 \times 10^{-5}$ Pa, preferably less than or equal to $1 \times 10^{-5}$ Pa, more preferably less than or equal to $3 \times 10^{-6}$ Pa. Further, in each of the above chambers, the partial pressure of a gas molecule (atom) having a mass-to-charge ratio ($m/z$) of 44 is less than or equal to $3 \times 10^{-5}$ Pa, preferably less than or equal to $1 \times 10^{-5}$ Pa, more preferably less than or equal to $3 \times 10^{-6}$ Pa.

Note that a total pressure and a partial pressure in a vacuum chamber can be measured using a mass analyzer. For example, Qulee CGM-051, a quadrupole mass analyzer (also referred to as Q-mass) manufactured by ULVAC, Inc. may be used.

Moreover, the above transfer chamber 4004, the substrate heating chamber 4005, and the film formation chamber 4006b preferably have a small amount of external leakage or internal leakage.

For example, in each of the above transfer chamber 4004, the substrate heating chamber 4005, and the film formation chamber 4006b, the leakage rate is less than or equal to $3 \times 10^{-6}$ Pa·m$^3$/s, preferably less than or equal to $1 \times 10^{-6}$ Pa·m$^3$/s. The leakage rate of a gas molecule (atom) having a mass-to-charge ratio ($m/z$) of 18 is less than or equal to $1 \times 10^{-7}$ Pa·m$^3$/s, preferably less than or equal to $3 \times 10^{-8}$ Pa·m$^3$/s. The leakage rate of a gas molecule (atom) having a mass-to-charge ratio ($m/z$) of 28 is less than or equal to $1 \times 10^{-5}$ Pa·m$^3$/s, preferably less than or equal to $1 \times 10^{-6}$ Pa·m$^3$/s. The leakage rate of a gas molecule (atom) having a mass-to-charge ratio ($m/z$) of 44 is less than or equal to $3 \times 10^{-6}$ Pa·m$^3$/S, preferably less than or equal to $1 \times 10^{-6}$ Pa·m$^3$/s.

Note that a leakage rate can be derived from the total pressure and partial pressure measured using the mass analyzer.

The leakage rate depends on external leakage and internal leakage. The external leakage refers to inflow of gas from the outside of a vacuum system through a minute hole, a sealing defect, or the like. The internal leakage is due to leakage through a partition, such as a valve, in a vacuum system or due to released gas from an internal member. Measures need to be taken from both aspects of external leakage and internal leakage in order that the leakage rate is set to be less than or equal to the above value.

For example, an open/close portion of the film formation chamber 4006b can be sealed with a metal gasket. For the metal gasket, metal covered with an iron fluoride, an aluminum oxide, or a chromium oxide is preferably used. The metal gasket realizes higher adhesion than an O-ring, and can reduce the external leakage. Further, with the use of the metal covered with an iron fluoride, an aluminum oxide, a chromium oxide, or the like which is in the passive state, the release of gas containing impurities released from the metal gasket is suppressed, so that the internal leakage can be reduced.

For a member of the film formation apparatus 4000, aluminum, chromium, titanium, zirconium, nickel, or vanadium, which releases a smaller amount of gas containing impurities, is used. Alternatively, for the above member, an alloy containing iron, chromium, nickel, and the like covered with the above material may be used. The alloy containing iron, chromium, nickel, and the like is rigid, resistant to heat, and suitable for processing. Here, when surface unevenness of the member is decreased by polishing or the like to reduce the surface area, the release of gas can be reduced.

Alternatively, the above member of the film formation apparatus 4000 may be covered with an iron fluoride, an aluminum oxide, a chromium oxide, or the like.

The member of the film formation apparatus 4000 is preferably formed with only metal as much as possible. For example, in the case where a viewing window formed with quartz or the like is provided, it is preferable that the surface of the viewing window be thinly covered with an iron fluoride, an aluminum oxide, a chromium oxide, or the like so as to suppress release of gas.

When an adsorbate is present in the film formation chamber, the adsorbate does not affect the pressure in the film formation chamber because it is adsorbed onto an inner wall or the like; however, the adsorbate causes gas to be released when the inside of the film formation chamber is evacuated. Therefore, although there is no correlation between the leakage rate and the evacuation rate, it is important that the adsorbate present in the film formation chamber be desorbed as much as possible and evacuation be performed in advance with the use of a pump with high evacuation capability. Note that the film formation chamber may be baked to promote desorption of the adsorbate. By the baking, the film formation rate of the adsorbate can be increased approximately tenfold. The baking can be performed at a temperature in the range of 100 °C to 450 °C. At this time, when the adsorbate is removed while an inert gas is introduced to the film formation chamber, the film formation rate of water or the like, which is difficult to be desorbed simply by evacuation, can be further increased. Note that when the inert gas to be introduced is heated to substantially the same temperature as the baking temperature of the film formation chamber, the desorption rate of the adsorbate can be further increased. Here, a rare gas is preferably used as an inert gas. Depending on the kind of a film to be formed, oxygen or the like may be used instead of an inert gas. For example, in the case of forming an oxide, the use of oxygen which is the main component of the oxide is preferable in some cases.

Alternatively, treatment for evacuating the inside of the film formation chamber is preferably performed a certain period of time after heated oxygen, a heated inert gas such as a rare gas, or the like is introduced to increase a pressure in the film formation chamber. The introduction of the heated gas can desorb the adsorbate in the film formation chamber, and the impurities present in the film formation chamber can be reduced. Note that an advantageous effect can be achieved when this treatment is repeated more than or equal to twice and less than or equal to 30 times, preferably more than or equal to 5 times and less than or equal to 15 times. Specifically, an inert gas, oxygen, or the like with a temperature higher than or equal to 40 °C and lower than or equal to 400 °C, preferably higher than or equal to 50 °C and lower than or equal to 200 °C is introduced to the film formation chamber, so that the pressure therein can be kept to be greater than or equal to 0.1 Pa and less than or equal to 10 kPa, preferably greater than or equal to 1 Pa and less than or equal to 1 kPa, more preferably greater than or equal to 5 Pa and less than or equal to 100 Pa in the time range of 1 minute to 300 minutes, preferably 5 minutes to 120 minutes. After that, the inside of the film formation chamber is evacuated in the time range of 5 minutes to 300 minutes, preferably 10 minutes to 120 minutes.

The rate of desorption of the adsorbate can be further increased also by dummy film formation. Here, the dummy film formation refers to film formation on a dummy substrate by a sputtering method or the like, in which a film is deposited on the dummy substrate and the inner wall of the film formation chamber so that impurities in the film formation chamber and an adsorbate on the inner wall of the film formation chamber are confined in the film. For a dummy substrate, a substrate which releases a smaller amount of gas is preferably used. By performing dummy film formation, impurity concentration in a film to be formed later can be reduced. Note that the dummy film formation may be performed at the same time as the baking of the film formation chamber.

Next, the details of the transfer chamber 4004 and the load lock chamber 4003a illustrated in FIG. 13B and the atmosphere-side substrate transfer chamber 4002 and the atmosphere-side substrate supply chamber 4001 illustrated in FIG. 13C are described. Note that FIG. 13C is a cross section of the atmosphere-side substrate transfer chamber 4002 and the atmosphere-side substrate supply chamber 4001.

For the transfer chamber 4004 illustrated in FIG. 13B, the description of the transfer chamber 4004 illustrated in FIG. 13A can be referred to.

The load lock chamber 4003a includes a substrate delivery stage 4111. When a pressure in the load lock chamber 4003a becomes an atmospheric pressure by being increased from a reduced pressure, the substrate delivery stage 4111 receives a substrate from the transfer robot 4103 provided in the atmosphere-side substrate transfer chamber 4002. After that, the load lock chamber 4003a is evacuated into vacuum so that the pressure therein becomes a reduced pressure and then the transfer robot 4103 provided in the transfer chamber 4004 receives the substrate from the substrate delivery stage 4111.

Further, the load lock chamber 4003a is connected to a vacuum pump 4200 and a cryopump 4201 through valves. For a method for connecting evacuation systems such as the vacuum pump 4200 and the cryopump 4201, the description of the method for connecting the transfer chamber 4004 can be referred to, and the description thereof is omitted here. Note that the unload lock chamber 4003b illustrated in FIG. 12 can have a structure similar to that in the load lock chamber 4003a.

The atmosphere-side substrate transfer chamber 4002 includes the transfer robot 4103. The transfer robot 4103 can deliver a substrate from the cassette port 4101 to the load lock chamber 4003a or deliver a substrate from the load lock chamber 4003a to the cassette port 4101. Further, a mechanism for suppressing entry of dust or a particle, such as high efficiency particulate air (HEPA) filter, may be provided above the atmosphere-side substrate transfer chamber 4002 and the atmosphere-side substrate supply chamber 4001.

The atmosphere-side substrate supply chamber 4001 includes a plurality of the cassette ports 4101. The cassette port 4101 can hold a plurality of substrates.

When an oxide film is formed with the use of the above film formation apparatus, the entry of impurities into the oxide film can be suppressed. Further, when a film in contact with the oxide film is formed with the use of the above film formation apparatus, the entry of impurities into the oxide film from the film in contact therewith can be suppressed.

Next, a method for forming a CAAC-OS film with the use of the above film formation apparatus is described.

In order to form the oxide film, the sputtering target described in Embodiment 1 is used.

The surface temperature of the sputtering target is set to be lower than or equal to 100 °C, preferably lower than or equal to 50 °C, more preferably approximately room temperature (typically, 25°C). In a sputtering apparatus for a large substrate, a large sputtering target is often used. However, it is difficult to form a sputtering target for a large substrate without a juncture. In fact, a plurality of sputtering targets are arranged so that there is as little space as possible therebetween to obtain a large shape; however, a slight space is inevitably generated. When the surface temperature of the sputtering target increases, in some cases, Zn or the like is volatilized from such a slight space and the space might be expanded gradually. When the space expands, a metal of a backing plate or a metal used for adhesion might be sputtered and cause an increase in impurity concentration. Thus, it is preferable that the sputtering target be cooled sufficiently.

Specifically, for the backing plate, a metal having high conductivity and a high heat dissipation property (specifically Cu) is used. The sputtering target can be cooled efficiently by making a sufficient amount of cooling water flow through a water channel which is formed in the backing plate.

The oxide film is formed in an oxygen gas atmosphere with a substrate heating temperature higher than or equal to 100 °C and lower than or equal to 600 °C, preferably higher than or equal to 150 °C and lower than or equal to 550 °C, more preferably higher than or equal to 200 °C and lower than or equal to 500 °C. The thickness of the oxide film is greater than or equal to 1 nm and less than or equal to 40 nm, preferably greater than or equal to 3 nm and less than or equal to 20 nm. As the substrate heating temperature during the film formation is higher, the impurity concentration in the obtained oxide film is lower. Further, migration of sputtered particles on a deposition surface is likely to occur; therefore, the atomic arrangement in the oxide film is ordered and the density thereof is increased, so that a CAAC-OS film with a high degree of crystallinity is formed easily. Furthermore, when the film formation is performed in an oxygen gas atmosphere, plasma damage is alleviated and a surplus atom such as a rare gas atom is not contained in the oxide film, whereby a CAAC-OS film with a high degree of crystallinity is formed easily. Note that the film formation may be performed in a mixed atmosphere including an oxygen gas and a rare gas. In that case, the percentage of an oxygen gas is set to be greater than or equal to 30 vol.%, preferably greater than or equal to 50 vol.%, more preferably greater than or equal to 80 vol.%.

Note that in the case where the sputtering target includes Zn, plasma damage is alleviated by the film formation in an oxygen gas atmosphere; thus, an oxide film in which Zn is unlikely to be volatilized can be obtained.

The oxide film is formed under conditions in which the film formation pressure is less than or equal to 0.8 Pa, preferably less than or equal to 0.4 Pa, and the distance between the sputtering target and a substrate is less than or equal to 100 mm, preferably less than or equal to 40 mm, more preferably less than or equal to 25 mm. When the oxide film is formed under such a condition, the frequency of the collision between a sputtered particle and another sputtered particle, a gas molecule, or an ion can be reduced. That is, depending on the film formation pressure, the distance between the sputtering target and the substrate is made shorter than the mean free path of a sputtered particle, a gas molecule, or an ion, so that the entry of impurities into the film can be reduced.

For example, when the pressure is 0.4 Pa and the temperature is 25 °C (the absolute temperature is 298 K), a hydrogen molecule ($H_2$) has a mean free path of 48.7 mm, a helium atom (He) has a mean free path of 57.9 mm, a water molecule ($H_2O$) has a mean free path of 31.3 mm, an ethane molecule ($CH_4$) has a mean free path of 13.2 mm, a neon atom (Ne) has a mean free path of 42.3 mm, a nitrogen molecule ($N_2$) has a mean free path of 23.2 mm, a carbon monoxide molecule (CO) has a mean free path of 16.0 mm, an oxygen molecule ($O_2$) has a mean free path of 26.4 mm, an argon atom (Ar) has a mean free path of 28.3 mm, a carbon dioxide molecule ($CO_2$) has a mean free path of 10.9 mm, a krypton atom (Kr) has a mean free path of 13.4 mm, and a xenon atom (Xe) has a mean free path of 9.6 mm. Note that doubling of the pressure halves a mean free path and doubling of the absolute temperature doubles a mean free path.

The mean free path depends on pressure, temperature, and the diameter of a molecule (atom). In the case where pressure and temperature are constant, as the diameter of a molecule (atom) is larger, the mean free path is shorter. Note that the diameters of the molecules (atoms) are as follows: $H_2$: 0.218 nm; He: 0.200 nm; $H_2O$: 0.272 nm; $CH_4$: 0.419 nm; Ne: 0.234 nm; $N_2$: 0.316 nm; CO: 0.380 nm; $O_2$: 0.296 nm; Ar: 0.286 nm; $CO_2$: 0.460 nm; Kr: 0.415 nm; and Xe: 0.491 nm.

Thus, as the diameter of a molecule (atom) is larger, the mean free path is shorter and the degree of crystallinity is lowered due to the large diameter of the molecule (atom) when the molecule (atom) enters the film. For this reason, it can be said that, for example, a molecule (atom) whose diameter is larger than that of Ar is likely to behave as an impurity.

Next, heat treatment is performed. The heat treatment is performed under a reduced pressure or in an inert atmosphere or an oxidation atmosphere. By the heat treatment, the impurity concentration in the CAAC-OS film can be reduced.

The heat treatment is preferably performed in a manner such that after heat treatment is performed under a reduced pressure or in an inert atmosphere, the atmosphere is switched to an oxidation atmosphere with the temperature maintained and heat treatment is further performed. When the heat treatment is performed under a reduced pressure or in an inert atmosphere, the impurity concentration in the CAAC-OS film can be reduced; however, oxygen vacancies are caused at the same time. By the heat treatment in an oxidation atmosphere, the caused oxygen vacancies can be reduced.

When heat treatment is performed on the CAAC-OS film in addition to the substrate heating during the film formation, the impurity concentration in the film can be reduced.

Specifically, the concentration of hydrogen in the CAAC-OS film, which is measured by secondary ion mass spectrometry (SIMS), can be set to be lower than or equal to $2 \times 10^{20}$ atoms/cm³, preferably lower than or equal to $5 \times 10^{19}$ atoms/cm³, more preferably lower than or equal to $1 \times 10^{19}$ atoms/cm³, further preferably lower than or equal to $5 \times 10^{18}$ atoms/cm³.

The concentration of nitrogen in the CAAC-OS film, which is measured by SIMS, can be set to be lower than $5 \times 10^{19}$ atoms/cm³, preferably lower than or equal to $5 \times 10^{18}$ atoms/cm³, more preferably lower than or equal to $1 \times 10^{18}$ atoms/cm³, further preferably lower than or equal to $5 \times 10^{17}$ atoms/cm³.

The concentration of carbon in the CAAC-OS film, which is measured by SIMS, can be set to be lower than $5 \times 10^{19}$ atoms/cm³, preferably lower than or equal to $5 \times 10^{18}$ atoms/cm³, more preferably lower than or equal to $1 \times 10^{18}$ atoms/cm³, further preferably lower than or equal to $5 \times 10^{17}$ atoms/cm³.

The amount of each of the following gas molecules (atoms) released from the CAAC-OS film can be less than or equal to $1 \times 10^{19}$/cm³, preferably less than or equal to $1 \times 10^{18}$/cm³ or less, which is measured by thermal desorption spectroscopy (TDS) analysis: a gas molecule (atom) having a mass-to-charge ratio (*m/z*) of 2 (e.g., hydrogen molecule), a gas molecule (atom) having a mass-to-charge ratio (*m/z*) of 18, a gas molecule (atom) having a mass-to-charge ratio (*m/z*) of 28, and a gas molecule (atom) having a mass-to-charge ratio (*m/z*) of 44.

A measurement method of the amount of released oxygen atoms, which is to be described later, is referred to for a measurement method of the release amount using TDS analysis.

In the above manner, a CAAC-OS film with a high degree of crystallinity can be formed.

This embodiment can be implemented in appropriate combination with any of the other embodiments.

[Embodiment 3]

In this embodiment, a sputtering target of one embodiment of the present invention is described.

A sputtering target is a sputtering target where impurity concentration is reduced. Specifically, the concentration of silicon in the sputtering target is set to be lower than $1 \times 10^{19}$ atoms/cm³, preferably lower than $5 \times 10^{18}$ atoms/cm³, more preferably lower than $1 \times 10^{18}$ atoms/cm³. The concentration of carbon in the sputtering target is set to be lower than $1 \times 10^{19}$ atoms/cm³, preferably lower than $5 \times 10^{18}$ atoms/cm³, more preferably lower than $1 \times 10^{18}$ atoms/cm³. The concentration of iron in the sputtering target is set to be lower than $1 \times 10^{16}$ atoms/cm³, preferably lower than $5 \times 10^{15}$ atoms/cm³, more preferably lower than $1 \times 10^{15}$ atoms/cm³. The concentration of nickel in the sputtering target is set to be lower than $5 \times 10^{16}$ atoms/cm³, preferably lower than $1 \times 10^{16}$ atoms/cm³, more preferably lower than $5 \times 10^{15}$ atoms/cm³, further preferably lower than $1 \times 10^{15}$ atoms/cm³. It is preferable to use a highly-purified raw material in order to reduce the impurity concentration in the sputtering target.

The relative density of the sputtering target is higher than or equal to 90 %, preferably higher than or equal to 95 %, more preferably higher than or equal to 99 %.

The sputtering target includes a polycrystalline oxide containing a plurality of crystal grains, whose average grain size is less than or equal to 3 $\mu$m, preferably less than or equal to 2.5 $\mu$m, more preferably less than or equal to 2 $\mu$m.

Alternatively, the sputtering target includes a polycrystalline oxide containing a plurality of crystal grains, in which the proportion of crystal grains whose grain size is greater than or equal to 0.4 $\mu$m and less than or equal to 1 $\mu$m is 8 % or more, preferably 15 % or more, more preferably 25 % or more.

Note that a crystal grain size can be measured by, for example, electron backscatter diffraction (EBSD). The grain size of the crystal grain described here is calculated from a cross-sectional area, assuming that a cross section of one crystal grain is a perfect circle. The cross section of the crystal grain can be measured from a crystal grain map obtained by EBSD. Specifically, when the cross-sectional area of the crystal grain is denoted by $S$ and the radius of the cross section of the crystal grain is denoted by $r$, the radius $r$ is calculated from the relation in which $S = \pi r^2$ to obtain the grain size which can be represented by $2r$ (twice the radius $r$).

Further, the plurality of crystal grains included in the sputtering target include cleavage planes. The cleavage plane is a plane parallel to an *a-b* plane, for example.

Owing to small grain sizes of the plurality of crystal grains, when an ion collides with the sputtering target, a sputtered particle is separated from the cleavage plane. The separated sputtered particle has a flat plate-like shape whose top and bottom surfaces are parallel to the cleavage plane. Further, owing to small grain sizes of the plurality of crystal grains, a crystal is distorted and a sputtered particle is easily separated from the cleavage plane.

Note that when the plurality of crystal grains included in the sputtering target are hexagonal crystals, flat plate-like sputtered particles each have the shape of a hexagonal cylinder whose top and bottom surfaces are approximately equilateral hexagons each having interior angles of 120 °.

Although sputtered particles are ideally single crystals, part of the sputtered particles may be changed into an amorphous state due to the impact of ion collision.

As such a polycrystalline oxide included in the sputtering target, an oxide containing In, *M* (*M* is Ga, Sn, Hf, Al, La, Ce, Pr, Nd, Sm, Eu, Gd, Tb, Dy, Ho, Er, Tm, Yb, or Lu), and Zn can be used. The oxide containing In, *M*, and Zn is also referred to as In-*M*-Zn oxide.

Moreover, the atomic ratio of In, *M*, and Zn contained in the In-*M*-Zn oxide is preferably close to the stoichiometric composition ratio. When the atomic ratio of In, *M*, and Zn contained in the In-*M*-Zn oxide becomes close to the stoichiometric composition ratio, the crystallinity of the In-*M*-Zn oxide can be increased.

In the In-*M*-Zn oxide, a cleavage plane is in many cases a plane parallel to an *a-b* plane in which *M* and Zn are mixed.

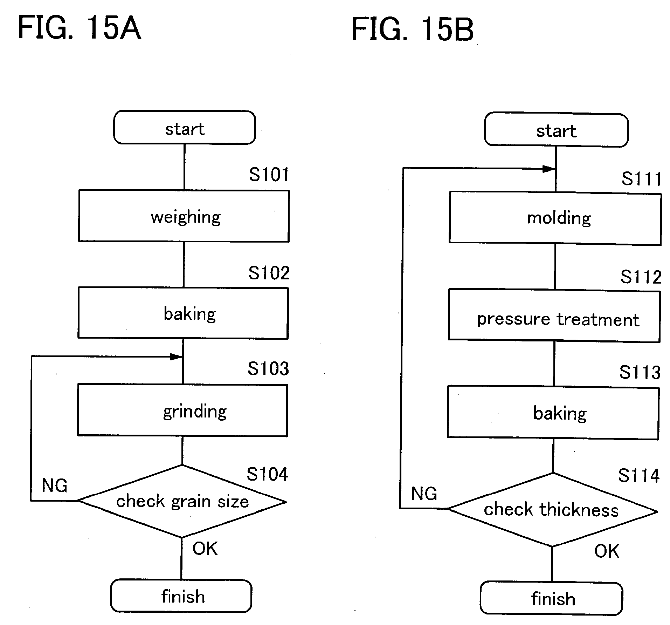

A method for manufacturing the above sputtering target is described with reference to FIGS. 15A and 15B.

FIG. 15A shows manufacture of an oxide powder containing a plurality of metal elements to be the sputtering target. First, the oxide powder is weighed in a step S101.

Here, description is given on the case where an oxide powder containing In, *M*, and Zn (also referred to as an In-*M*-Zn oxide powder) is obtained as the oxide powder containing a plurality of metal elements. Specifically, an $InO_X$ oxide powder, an $MO_Y$ oxide powder, and a $ZnO_Z$ oxide powder are prepared as a raw material. Note that *X, Y,* and *Z* are each a given positive number; for example, *X, Y,* and *Z* are 1.5, 1.5, and 1, respectively. It is needless to say that the above oxide powders are examples, and oxide powders can be selected as appropriate in order to obtain a desired composition. Note that *M* refers to Ga, Sn, Hf, Al, La, Ce, Pr, Nd, Sm, Eu, Gd, Tb, Dy, Ho, Er, Tm, Yb, or Lu. Although the case where three kinds of oxide powders are used is shown as an example in this embodiment, one embodiment of the present invention is not limited thereto. For example, this embodiment may be applied to the case where four or more kinds of oxide powders are used or the case where one or two kinds of oxide powders are used.

Next, the $InO_X$ powder, the $MO_Y$ powder, and the $ZnO_Z$ powder are mixed in a predetermined mole ratio.

For example, the predetermined mole ratio of the $InO_X$ oxide powder, the $MO_Y$ oxide powder, and the $ZnO_Z$ oxide powder is 2:2:1, 8:4:3, 3:1:1, 1:1:1, 4:2:3, 1:1:2, 3:1:4,1:3:2, 1:3:4,1:3:6, 1:3:8,1:3:10, 1:3:12, 1:6:4, 1:6:6, 1:6:8, 1:6:10, 1:6:12, 1:6:14, 1:6:16, 1:6:20, or 3:1:2. With such a mole ratio, a sputtering target including a polycrystalline oxide with high crystallinity can be obtained easily later.

Next, in a step S102, an In-*M*-Zn oxide is obtained by performing first baking on the $InO_X$ oxide powder, the $MO_Y$ oxide powder, and the $ZnO_Z$ oxide powder which are mixed in a predetermined mole ratio.

Note that the first baking is performed in an inert atmosphere, an oxidation atmosphere, or under a reduced pressure at a temperature higher than or equal to 400 °C and lower than or equal to 1700 °C, preferably higher than or equal to 900 °C and lower than or equal to 1500 °C. The first baking is performed for longer than or equal to 3 minutes and shorter than or equal to 24 hours, preferably longer than or equal to 30 minutes and shorter than or equal to 17 hours, more preferably longer than or equal to 30 minutes and shorter than or equal to 5 hours, for example. When the first baking is performed under the above conditions, secondary reactions other than the main reaction can be suppressed, and the impurity concentration in the In-*M*-Zn oxide can be reduced.

Accordingly, the crystallinity of the In-*M*-Zn oxide can be increased.

The first baking may be performed plural times at different temperatures and/or in different atmospheres. For example, the In-*M*-Zn oxide may be first held at a first temperature in a first atmosphere and then at a second temperature in a second atmosphere. Specifically, it is preferable that the first atmosphere be an inert atmosphere or under a reduced pressure and the second atmosphere be an oxidation atmosphere. This is because oxygen vacancies are generated in the In-*M*-Zn oxide when impurities contained in the In-*M*-Zn oxide are reduced in the first atmosphere. Therefore, it is preferable that oxygen vacancies in the obtained In-*M*-Zn oxide be reduced in the second atmosphere. The impurity concentration and oxygen vacancies in the In-*M*-Zn oxide are reduced, whereby the crystallinity of the In-*M*-Zn oxide can be increased.

Next, the In-*M*-Zn oxide powder is obtained by grinding the In-*M*-Zn oxide in a step S103.

The In-*M*-Zn oxide has a high proportion of crystals with structures of planes parallel to the *a-b* plane. Therefore, the obtained In-*M*-Zn oxide powder includes many flat plate-like crystal grains whose top and bottom surfaces are parallel to the *a-b* plane. Moreover, the crystal of the In-*M*-Zn oxide is in many cases a hexagonal crystal; therefore, in many cases, the above flat plate-like crystal grains each have the shape of a hexagonal cylinder whose top and bottom surfaces are approximately equilateral hexagons each having interior angles of 120°.

Next, the grain size of the obtained In-*M*-Zn oxide powder is checked in a step S104. Here, the average grain size of the In-*M*-Zn oxide powder is checked to be less than or equal to 3 $\mu$m, preferably less than or equal to 2.5 $\mu$m, more preferably less than or equal to 2 $\mu$m. Note that the step S104 may be omitted and only the In-*M*-Zn oxide powder whose grain size is less than or equal to 3 $\mu$m, preferably less than or equal to 2.5 $\mu$m, more preferably less than or equal to 2 $\mu$m may be sifted using a grain size filter. The average grain size of the In-*M*-Zn oxide powder can be certainly less than or equal to 3 $\mu$m, preferably less than or equal to 2.5 $\mu$m, more preferably less than or equal to 2 $\mu$m by sifting the In-*M*-Zn oxide powder whose grain size is less than or equal to 3 $\mu$m, preferably less than or equal to 2.5 $\mu$m, more preferably less than or equal to 2 $\mu$m.

In the case where the average grain size of the In-*M*-Zn oxide powder exceeds a predetermined size in the step S104, the procedure returns to the step S103 and the In-*M*-Zn oxide powder is ground again.

In the above manner, the In-*M*-Zn oxide powder whose average grain size is less than or equal to 3 $\mu$m, preferably less than or equal to 2.5 $\mu$m, more preferably less than or equal to 2 $\mu$m can be obtained. Note that the grain size of a crystal grain included in a sputtering target to be formed later can be reduced by obtaining the In-*M*-Zn oxide powder whose average grain size is less than or equal to 3 $\mu$m, preferably less than or equal to 2.5 $\mu$m, more preferably less than or equal to 2 $\mu$m.

Next, in FIG. 15B, a sputtering target is formed using the In-*M*-Zn oxide powder obtained in the flow chart shown in FIG. 15A.

In a step S111, the In-*M*-Zn oxide powder is made to spread over a mold and molded. Here, molding refers to making powder or the like spread over a mold to obtain a uniform thickness. Specifically, the In-*M*-Zn oxide powder is introduced to the mold, and then vibration is externally applied so that the In-*M*-Zn oxide powder is molded. Alternatively, the In-*M*-Zn oxide powder is introduced to the mold, and then molding is performed using a roller or the like so as to obtain a uniform thickness. Note that in the step S111, slurry in which the In-*M*-Zn oxide powder is mixed with water, a dispersant, and a binder may be molded. In that case, the slurry is poured into the mold and then molded by sucking the mold from the bottom. After that, drying treatment is performed on a molded body after the mold is sucked. The drying treatment is preferably natural drying because the molded body is less likely to be cracked. After that, the molded body is subjected to heat treatment at a temperature higher than or equal to 300 °C and lower than or equal to 700 °C, so that residual moisture or the like which cannot be taken out by natural drying is removed. Note that as the filter, a filter in which a porous resin film is attached over a woven fabric or a felt may be used.

When the In-*M*-Zn oxide powder including many flat plate-like crystal grains whose top and bottom surfaces are parallel to the *a-b* plane is made to spread over the mold and molded, the crystal grains are arranged with the planes which are parallel to the *a-b* plane thereof facing upward. Therefore, the proportion of the surface structures of planes parallel to the *a-b* plane can be increased in such a manner that the obtained In-*M*-Zn oxide powder is made to spread over the mold and molded. Note that the mold may be formed of a metal or an oxide and the upper shape thereof is rectangular or rounded.

Next, first pressure treatment is performed on the In-*M*-Zn oxide powder in a step S112. After that, in a step S113, second baking is performed to obtain an In-*M*-Zn oxide. The second baking is performed under conditions similar to those of the first baking. The crystallinity of the In-*M*-Zn oxide can be increased by performing the second baking.

Note that the first pressure treatment may be performed in any manner as long as the In-*M*-Zn oxide powder can be pressed. For example, a weight which is formed of the same kind of material as the mold can be used. Alternatively, the In-*M*-Zn oxide powder may be pressed under a high pressure using compressed air. Besides, the first pressure treatment can be performed using a known technique. Note that the first pressure treatment may be performed at the same time as the second baking.

Planarization treatment may be performed after the first pressure treatment. As the planarization treatment, chemical mechanical polishing (CMP) treatment or the like can be employed.

The plate-like In-*M*-Zn oxide thus obtained becomes a polycrystalline oxide with high crystallinity.

Next, the thickness of the obtained plate-like In-*M*-Zn oxide is checked in a step S 114. When the thickness of the plate-like In-*M*-Zn oxide is less than a desired thickness, the procedure returns to the step S111 and the In-*M*-Zn oxide powder is made to spread over the plate-like In-*M*-Zn oxide and molded. When the plate-like In-*M*-Zn oxide has a desired thickness in the step S114, the plate-like In-*M*-Zn oxide is used as a sputtering target. The description of steps following the step S111 when the thickness of the plate-like In-*M*-Zn oxide is less than a desired thickness is given below.

After the step S111, in the step S112, second pressure treatment is performed on the plate-like In-*M*-Zn oxide and the In-*M*-Zn oxide powder over the plate-like In-*M*-Zn oxide. Then, in the step S113, third baking is performed, whereby a plate-like In-*M*-Zn oxide whose thickness is increased by the thickness of the In-*M*-Zn oxide powder is obtained. A plate-like In-*M*-Zn oxide with an increased thickness is obtained through crystal growth with the use of the plate-like In-*M*-Zn oxide as a seed crystal; therefore, the plate-like In-*M*-Zn oxide is a polycrystalline oxide with high crystallinity.

Note that the third baking is performed under conditions similar to those of the second baking. The second pressure treatment is performed under conditions similar to those of the first pressure treatment. Note that the second pressure treatment may be performed at the same time as the third baking.

The thickness of the obtained plate-like In-*M*-Zn oxide is checked again in the step S 114.

Through the above steps, the thickness of the plate-like In-*M*-Zn oxide can be gradually increased while the crystal alignment is improved.

By repeating these steps of increasing the thickness of a plate-like In-*M*-Zn oxide *n* times (*n* is a natural number), the plate-like In-*M*-Zn oxide having a desired thickness (*t*), for example, greater than or equal to 2 mm and less than or equal to 20 mm, preferably greater than or equal to 3 mm and less than or equal to 20 mm can be obtained. The plate-like In-*M*-Zn oxide is used as a sputtering target.

After that, planarization treatment may be performed.

Note that fourth baking may be performed on the obtained sputtering target. The fourth baking is performed under conditions similar to those of the first baking. A sputtering target including a polycrystalline oxide with much higher crystallinity can be obtained by performing the fourth baking.

In the above manner, the sputtering target which includes a polycrystalline oxide containing a plurality of crystal grains having cleavage planes parallel to the *a-b* plane and a small grain size can be formed.

Note that the sputtering target formed in such a manner can have high density. When the density of the sputtering target is increased, the density of a film to be formed can also be increased. Specifically, the relative density of the sputtering target can be set to be higher than or equal to 90 %, preferably higher than or equal to 95 %, more preferably higher than or equal to 99 %.

This embodiment can be implemented in appropriate combination with any of the other embodiments.

[Embodiment 4]

In this embodiment, a transistor of one embodiment of the present invention is described.

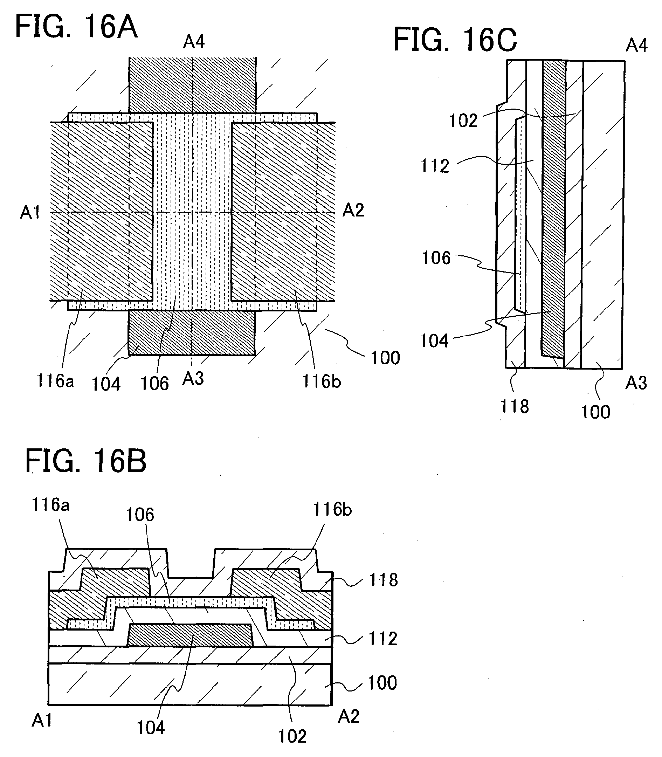

FIG. 16A is a top view of a transistor of one embodiment of the present invention. FIG. 16B is a cross-sectional view taken along dashed-dotted line A1-A2 in FIG. 16A. FIG. 16C is a cross-sectional view taken along dashed-dotted line A3-A4 in FIG. 16A. For easy understanding, a gate insulating film 112 and the like are not illustrated in FIG. 16A.

FIG. 16B is a cross-sectional view of a transistor which includes a base insulating film 102 over a substrate 100, a gate electrode 104 over the base insulating film 102, the gate insulating film 112 over the gate electrode 104, an oxide semiconductor film 106 which is over the gate insulating film 112 and overlaps with the gate electrode 104, a source electrode 116a and a drain electrode 116b over the oxide semiconductor film 106, and a protective insulating film 118 over the oxide semiconductor film 106, the source electrode 116a, and the drain electrode 116b. Although FIG. 16B illustrates the structure in which the base insulating film 102 is provided, the present invention is not limited thereto. For example, the base insulating film 102 may be omitted.

Here, the oxide film with high crystallinity described in the above embodiments is applied to the oxide semiconductor film 106.

The concentration of hydrogen in the oxide semiconductor film 106 is lower than or equal to $2 \times 10^{20}$ atoms/cm$^3$, preferably lower than or equal to $5 \times 10^{19}$ atoms/cm$^3$, more preferably lower than or equal to $1 \times 10^{19}$ atoms/cm$^3$, further preferably lower than or equal to $5 \times 10^{18}$ atoms/cm$^3$. This is because hydrogen in the oxide semiconductor film 106 might generate unintentional carriers. The generated carriers cause an increase in the off-state current and a change in the electrical characteristics of the transistor. Thus, by suppressing the concentration of hydrogen in the oxide semiconductor film 106 within the above-described range, an increase in the off-state current and a change in the electrical characteristics of the transistor can be suppressed.

By suppressing the donor (e.g., hydrogen or oxygen vacancy) concentration in the oxide semiconductor film 106 to be extremely low, the off-sate current of the transistor including the oxide semiconductor film 106 can be made extremely small. Specifically, the off-state current of the transistor with a channel length of 3 μm and

a channel width of 1 μm can be lower than or equal to 1 $\times$ 10$^{-21}$ A or lower than or equal to 1 $\times$ 10$^{-25}$ A.

There is no large limitation on the substrate 100. For example, a glass substrate, a ceramic substrate, a quartz substrate, or a sapphire substrate may be used as the substrate 100. Alternatively, a single crystal semiconductor substrate or a polycrystalline semiconductor substrate made of silicon, silicon carbide, or the like, a compound semiconductor substrate made of silicon germanium or the like, a silicon-on-insulator (SOI) substrate, or the like may be used as the substrate 100. Still alternatively, any of these substrates provided with a semiconductor element may be used as the substrate 100.

In the case of using a large glass substrate such as the fifth generation (1000 mm $\times$ 1200 mm or 1300 mm $\times$ 1500 mm); the sixth generation (1500 mm $\times$ 1800 mm); the seventh generation (1870 mm $\times$ 2200 mm); the eighth generation (2200 mm $\times$ 2500 mm); the ninth generation (2400 mm $\times$ 2800 mm); or the tenth generation (2880 mm $\times$ 3130 mm) as the substrate 100, in some cases, microfabrication is made difficult owing to shrinkage of the substrate 100, which is caused by heat treatment or the like in the manufacturing process of a semiconductor device. Therefore, in the case where the above-described large glass substrate is used as the substrate 100, a substrate whose shrinkage due to heat treatment is as less as possible is preferably used. For example, as the substrate 100, it is possible to use a large glass substrate in which the amount of shrinkage by heat treatment for one hour at 400 °C, preferably 450 °C, more preferably 500 °C is less than or equal to 10 ppm, preferably less than or equal to 5 ppm, more preferably less than or equal to 3 ppm.

Further alternatively, a flexible substrate may be used as the substrate 100. As the method for providing a transistor over a flexible substrate, there is also a method in which a transistor is formed over a non-flexible substrate, and then, the transistor is separated from the non-flexible substrate and transferred to a flexible substrate functioning as the substrate 100. In that case, a separation layer may be provided between the non-flexible substrate and the transistor.

The base insulating film 102 may be formed using a single layer or a stacked layer of an insulating film containing one or more kinds of an aluminum oxide, a magnesium oxide, a silicon oxide, a silicon oxynitride, a gallium oxide, a germanium oxide, an yttrium oxide, a zirconium oxide, a lanthanum oxide, a neodymium oxide, a hafnium oxide, and a tantalum oxide.

The gate electrode 104 may be formed using a single layer or a stacked layer of a simple substance, a nitride, an oxide, or an alloy containing one or more kinds of Al, Ti, Cr, Co, Ni, Cu, Y, Zr, Mo, Ag, Ta, and W.

The source electrode 116a and the drain electrode 116b each may be formed using a single layer or a stacked layer of a simple substance, a nitride, an oxide, or an alloy containing one or more kinds of Al, Ti, Cr, Co, Ni, Cu, Y, Zr, Mo, Ag, Ta, and W. Note that the compositions of the source electrode 116a and the drain electrode 116b are either the same as or different from each other.

The gate insulating film 112 may be formed using a single layer or a stacked layer of an insulating film containing one or more kinds of an aluminum oxide, a magnesium oxide, a silicon oxide, a silicon oxynitride, a gallium oxide, a germanium oxide, an yttrium oxide, a zirconium oxide, a lanthanum oxide, a neodymium oxide, a hafnium oxide, and a tantalum oxide.

The protective insulating film 118 may be formed using a single layer or a stacked layer of an insulating film containing one or more kinds of an aluminum oxide, a magnesium oxide, a silicon oxide, a silicon oxynitride, a gallium oxide, a germanium oxide, an yttrium oxide, a zirconium oxide, a lanthanum oxide, a neodymium oxide, a hafnium oxide, and a tantalum oxide.

The protective insulating film 118 may be, for example, a stacked film including a silicon oxide film as a first layer and a silicon nitride film as a second layer. In that case, the silicon oxide film may be a silicon oxynitride film. It is preferable to use a silicon oxide film whose defect density is small as the silicon oxide film. Specifically, a silicon oxide film whose spin density attributed to a signal with a *g* factor of 2.001 in electron spin resonance (ESR) is less than or equal to 3 $\times$ 10$^{17}$ spins/cm$^3$, preferably less than or equal to 5 $\times$ 10$^{16}$ spins/cm$^3$ is used. As the silicon nitride film, a silicon nitride film from which hydrogen and ammonia are discharged as less as possible is used. The amount of discharge of hydrogen or ammonia may be measured by thermal desorption spectroscopy (TDS). Further, a silicon nitride film which does not penetrate or hardly penetrate oxygen is used as the silicon nitride film.

The protective insulating film 118 may be, for example, a stacked film including a first silicon oxide film as a first layer, a second silicon oxide film as a second layer, and a silicon nitride film as a third layer. In that case, the first and/or second silicon oxide film may be a silicon oxynitride film. It is preferable to use a silicon oxide film whose defect density is small as the first silicon oxide film. Specifically, a silicon oxide film whose spin density attributed to a signal with a *g* factor of 2.001 in ESR is less than or equal to 3 $\times$ 10$^{17}$ spins/cm$^3$, preferably less than or equal to 5 $\times$ 10$^{16}$ spins/cm$^3$ is used. As the second silicon oxide film, a silicon oxide film having excess oxygen is used. As the silicon nitride film, a silicon nitride film from which hydrogen and ammonia are discharged as less as possible is used. Further, a silicon nitride film which does not penetrate or hardly penetrate oxygen is used as the silicon nitride film.

The silicon oxide film having excess oxygen means a silicon oxide film from which oxygen can be released by heat treatment or the like. When the above definition of the silicon oxide film is applied broadly to an insulating film, an insulating film having excess oxygen means an insulating film from which oxygen is released by heat treatment.

Here, a film from which oxygen is released by heat treatment may release oxygen, the amount of which is higher than or equal to $1 \times 10^{18}$ atoms/cm$^3$, higher than or equal to $1 \times 10^{19}$ atoms/cm$^3$, or higher than or equal to $1 \times 10^{20}$ atoms/cm$^3$ in TDS analysis (converted into the number of oxygen atoms).

Here, the method of measuring the amount of released oxygen using TDS analysis is described below.

The total amount of released gas from a measurement sample in TDS analysis is proportional to the integral value of the ion intensity of the released gas. Then, comparison with a reference sample is made, whereby the total amount of released gas can be calculated.

For example, the number of released oxygen molecules ($N_{O2}$) from a measurement sample can be calculated according to Formula 1 using the TDS results of a silicon wafer containing hydrogen at a predetermined density, which is a reference sample, and the TDS results of the measurement sample. Here, all gases having a mass number of 32 which are obtained in the TDS analysis are assumed to originate from an oxygen molecule. Note that CH$_3$OH, which is a gas having the mass number of 32, is not taken into consideration because it is unlikely to be present. Further, an oxygen molecule including an oxygen atom having a mass number of 17 or 18 which is an isotope of an oxygen atom is also not taken into consideration because the proportion of such a molecule in the natural world is minimal.

[FORMULA 1]

$$N_{O2} = \frac{N_{H2}}{S_{H2}} \times S_{O2} \times \alpha$$

Here, $N_{H2}$ is the value obtained by conversion of the number of hydrogen molecules desorbed from the reference sample into densities. In addition, $S_{H2}$ is the integral value of ion intensity in the TDS analysis of the reference sample. Here, the reference value of the reference sample is $N_{H2}/S_{H2}$. Further, $S_{O2}$ is the integral value of ion intensity in the TDS analysis of the measurement sample, and $\alpha$ is a coefficient affecting the ion intensity in the TDS analysis. Refer to Japanese Published Patent Application No. H6-275697 for details of Formula 1. The amount of released oxygen was measured with a thermal desorption spectroscopy apparatus produced by ESCO Ltd., EMD-WA1000S/W using a silicon wafer containing hydrogen atoms at $1 \times 10^{16}$ atoms/cm$^2$ as the reference sample.

Further, in the TDS analysis, part of oxygen is detected as an oxygen atom. The ratio between oxygen molecules and oxygen atoms can be calculated from the ionization rate of the oxygen molecules. Since the above $\alpha$ includes the ionization rate of the oxygen molecules, the number of the released oxygen atoms can also be estimated through the evaluation of the number of the released oxygen molecules.

Here, $N_{O2}$ is the number of the released oxygen molecules. The amount of released oxygen in terms of oxygen atoms is twice the number of the released oxygen molecules.

Further or alternatively, the film from which oxygen is released by heat treatment may contain a peroxide radical. Specifically, the spin density attributed to the peroxide radical is greater than or equal to $5 \times 10^{17}$ spins/cm$^3$. Note that the film containing a peroxide radical may have an asymmetric signal with a *g* factor of approximately 2.01 in ESR.

The insulating film containing excess oxygen may be oxygen-excess silicon oxide (SiO$_X$($X$>2)). In the oxygen-excess silicon oxide (SiO$_X$($X$ > 2)), the number of oxygen atoms per unit volume is more than twice the number of silicon atoms per unit volume. The number of silicon atoms and the number of oxygen atoms per unit volume are measured by Rutherford backscattering spectrometry (RBS).

At least one of the gate insulating film 112 and the protective insulating film 118 is preferably the insulating film containing excess oxygen.

In the case where at least one of the gate insulating film 112 and the protective insulating film 118 is the insulating film containing excess oxygen, oxygen vacancies in the oxide semiconductor film 106 can be reduced.

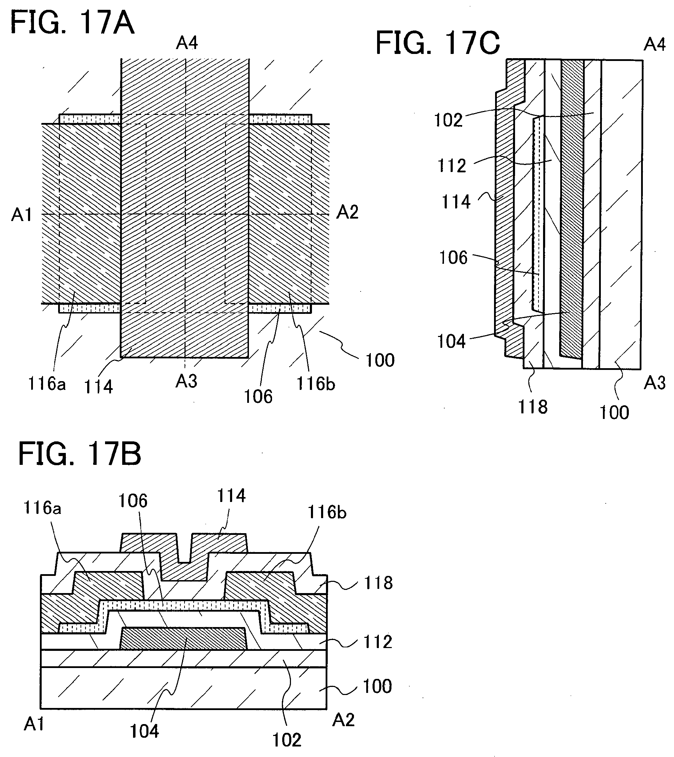

A transistor obtained by providing a back-gate electrode 114 for the transistor illustrated in FIGS. 16A to 16C is a transistor illustrated in FIGS. 17A to 17C.

FIG. 17A is a top view of a transistor of one embodiment of the present invention. FIG. 17B is a cross-sectional view taken along dashed-dotted line A1-A2 in FIG. 17A. FIG. 17C is a cross-sectional view taken along dashed-dotted line A3-A4 in FIG. 17A. For easy understanding, the gate insulating film 112 and the like are not illustrated in FIG. 17A.

The threshold voltage of the transistor illustrated in FIGS. 17A to 17C can be controlled easily because the back-gate electrode 114 is provided. Further, by connecting the gate electrode 104 to the back-gate electrode 114, the on-state current of the transistor can be increased. Alternatively, by setting the back-gate electrode 114 to a negative potential (potential lower than a source potential of the transistor) or the source potential, the off-state current of the transistor can be reduced.

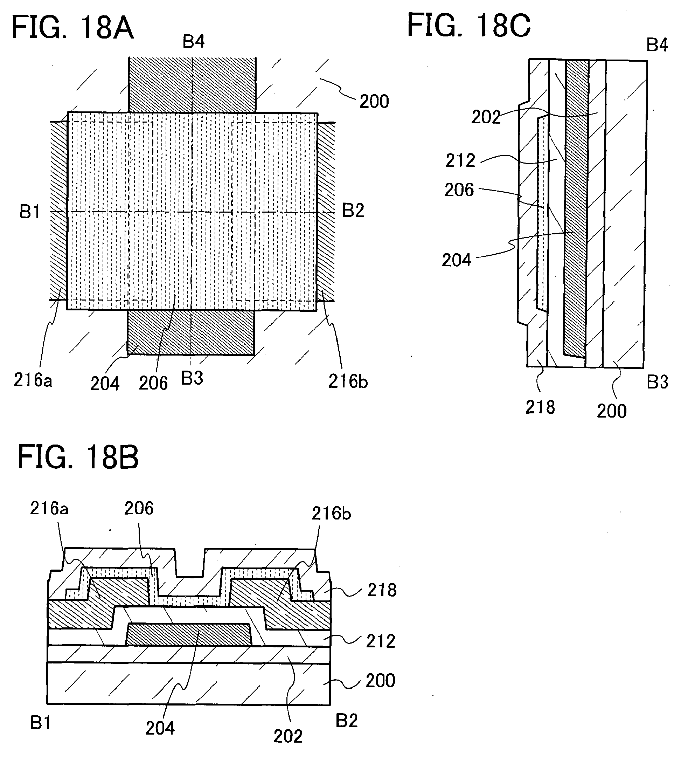

Next, a transistor whose structure is different from those of FIGS. 16A to 16C and FIGS. 17A to 17C is described with reference to FIGS. 18A to 18C.

FIG. 18A is a top view of a transistor of one embodiment of the present invention. FIG. 18B is a cross-sectional view taken along dashed-dotted line B1-B2 in FIG. 18A. FIG. 18C is a cross-sectional view taken along dashed-dotted line B3-B4 in FIG. 18A. For easy understanding, a gate insulating film 212 and the like are not illustrated in FIG. 18A.

FIG. 18B is a cross-sectional view of a transistor which includes a base insulating film 202 over a substrate 200, a gate electrode 204 over the base insulating film 202, the gate insulating film 212 over the gate electrode 204, a source electrode 216a and a drain electrode 216b over the gate insulating film 212, an oxide semiconductor film 206 which is over the gate insulating film 212, the source electrode 216a, and the drain electrode 216b and overlaps with the gate electrode 204, and a protective insulating film 218 over the oxide semiconductor film 206, the source electrode 216a, and the drain electrode 216b. Although FIG. 18B illustrates the structure in which the base insulating film 202 is provided, the present invention is not limited thereto. For example, the base insulating film 202 may be omitted.

For the oxide semiconductor film 206, refer to the description of the oxide semiconductor film 106.

For the substrate 200, refer to the description of the substrate 100.

For the base insulating film 202, refer to the description of the base insulating film 102.

For the gate electrode 204, refer to the description of the gate electrode 104.

For the gate insulating film 212, an insulating film similar to the gate insulating film 112 may be used.

For the source electrode 216a and the drain electrode 216b, refer to the description of the source electrode 116a and the drain electrode 116b.

For the protective insulating film 218, an insulating film similar to the protective insulating film 118 may be used.

Although not illustrated in the drawing, a back-gate electrode may be provided over the protective insulating film 218 of the transistor illustrated in FIGS. 18A to 18C. For the back-gate electrode, refer to the description of the back-gate electrode 114.

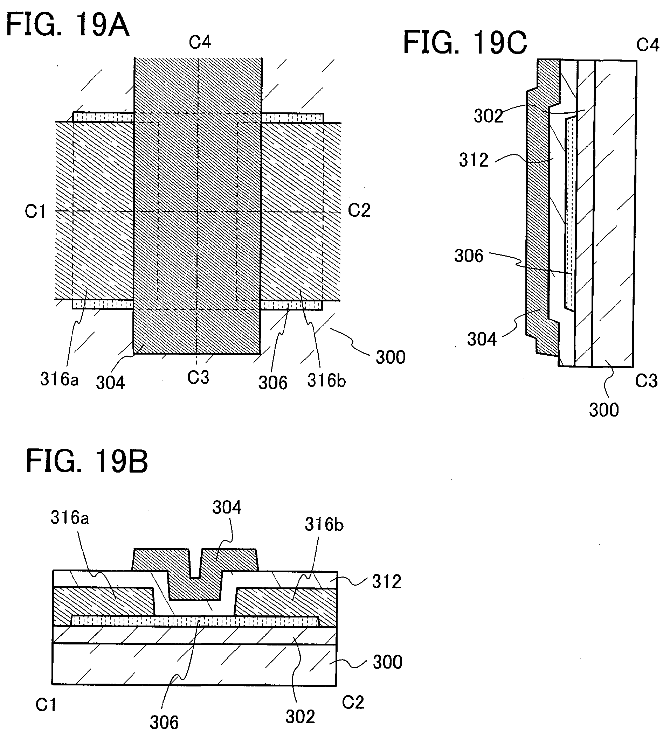

Next, a transistor whose structure is different from those of FIGS. 16A to 16C, FIGS. 17A to 17C, and FIGS. 18A to 18C is described with reference to FIGS. 19A to 19C.

FIG. 19A is a top view of a transistor of one embodiment of the present invention. FIG. 19B is a cross-sectional view taken along dashed-dotted line C1-C2 in FIG. 19A. FIG. 19C is a cross-sectional view taken along dashed-dotted line C3-C4 in FIG. 19A. For easy understanding, a gate insulating film 312 and the like are not illustrated in FIG. 19A.

FIG. 19B is a cross-sectional view of a transistor which includes a base insulating film 302 over a substrate 300, an oxide semiconductor film 306 over the base insulating film 302, a source electrode 316a and a drain electrode 316b over the oxide semiconductor film 306, the gate insulating film 312 provided over the oxide semiconductor film 306, the source electrode 316a, and the drain electrode 316b, and a gate electrode 304 which is over the gate insulating film 312 and overlaps with the oxide semiconductor film 306. Although FIG. 19B illustrates the structure in which the base insulating film 302 is provided, the present invention is not limited thereto.

For example, the base insulating film 302 may be omitted.

For the oxide semiconductor film 306, refer to the description of the oxide semiconductor film 106.

For the substrate 300, refer to the description of the substrate 100.

For the base insulating film 302, an insulating film similar to the protective insulating film 118 may be used. In the case of employing a stacked-layer structure in which the base insulating film 302 is an example of the protective insulating film 118, the order of stacking layers is reversed.

The base insulating film 302 is preferably flat. Specifically, the base insulating film 302 can be made to have an average surface roughness (*Ra*) of 1 nm or less, 0.3 nm or less, or 0.1 nm or less.

Note that *Ra* is obtained by expanding, into three dimensions, arithmetic mean surface roughness that is defined by JIS B 0601:2001 (ISO4287:1997) so as to be able to apply to a curved surface, and can be expressed as the "average value of the absolute values of deviations from a reference surface to a designated surface" and is defined by Formula 2.

[FORMULA 2]

$$Ra = \frac{1}{S_0} \int_{y1}^{y2} \int_{x1}^{x2} |f(x,y) - Z_0| dx dy$$

Here, the designated surface is a surface that is a target of roughness measurement, and is a quadrilateral region specified by four points represented by the coordinates $(x_1, y_1, f(x_1, y_1))$, $(x_1, y_2, f(x_1, y_2))$, $(x_2, y_1, f(x_2, y_1))$, and $(x_2, y_2, f(x_2, y_2))$. In addition, $S_0$ represents the area of a rectangle which is obtained by projecting the designated surface on the *xy* plane, and $Z_0$ represents the height of the reference surface (the average height of the designated surface). Further, *Ra* can be measured with an atomic force microscope (AFM).

The base insulating film 302 is preferably the insulating film containing excess oxygen.

For the source electrode 316a and the drain electrode 316b, refer to the description of the source electrode 116a and the drain electrode 116b.

For the gate insulating film 312, an insulating film similar to the gate insulating film 112 may be used.

For the gate electrode 304, refer to the description of the gate electrode 104.

Although not illustrated in the drawing, a back-gate electrode may be provided under the base insulating film 302 of the transistor illustrated in FIGS. 19A to 19C. For the back-gate electrode, refer to the description of the back-gate electrode 114.

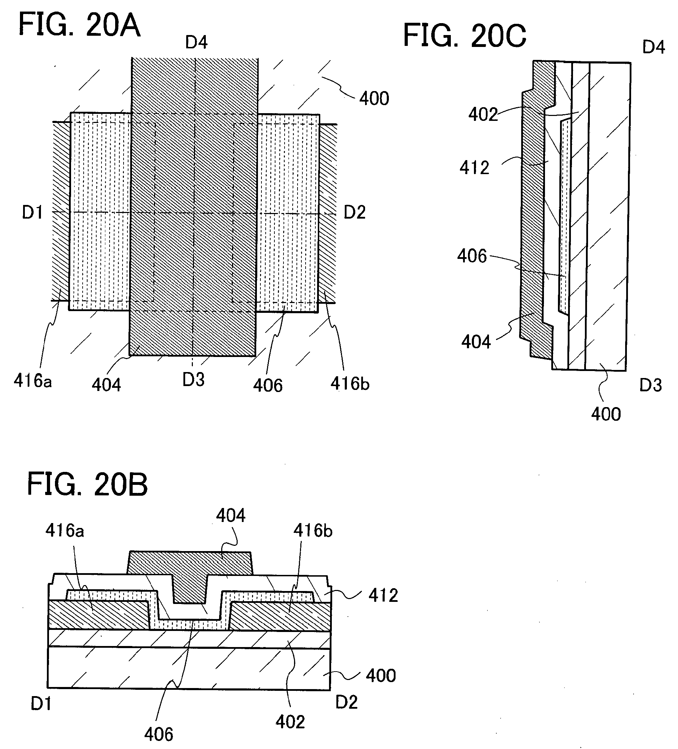

Next, a transistor whose structure is different from those of FIGS. 16A to 16C, FIGS. 17A to 17C, FIGS. 18A to 18C, and FIGS. 19A to 19C is described with reference to FIGS. 20A to 20C.

FIG. 20A is a top view of a transistor of one embodiment of the present invention. FIG. 20B is a cross-sectional view taken along dashed-dotted line D1-D2 in FIG. 20A. FIG. 20C is a cross-sectional view taken along dashed-dotted line D3-D4 in FIG. 20A. For easy understanding, a gate insulating film 412 and the like are not illustrated in FIG. 20A.

FIG. 20B is a cross-sectional view of a transistor which includes a base insulating film 402 over a substrate 400, a source electrode 416a and a drain electrode 416b over the base insulating film 402, an oxide semiconductor film 406 over the base insulating film 402, the source electrode 416a, and the drain electrode 416b, the gate insulating film 412 over the oxide semiconductor film 406, and a gate electrode 404 which is over the gate insulating film 412 and overlaps with the oxide semiconductor film 406. Although FIG. 20B illustrates the structure in which the base insulating film 402 is provided, the present invention is not limited thereto. For example, the base insulating film 402 may be omitted.

For the oxide semiconductor film 406, refer to the description of the oxide semiconductor film 106.

For the substrate 400, refer to the description of the substrate 100.

For the base insulating film 402, an insulating film similar to the base insulating film 302 may be used.

For the source electrode 416a and the drain electrode 416b, refer to the description of the source electrode 116a and the drain electrode 116b.

For the gate insulating film 412, an insulating film similar to the gate insulating film 112 may be used.

For the gate electrode 404, refer to the description of the gate electrode 104.

Although not illustrated in the drawing, a back-gate electrode may be provided under the base insulating film 402 of the transistor illustrated in FIGS. 20A to 20C. For the back-gate electrode, refer to the description of the back-gate electrode 114.

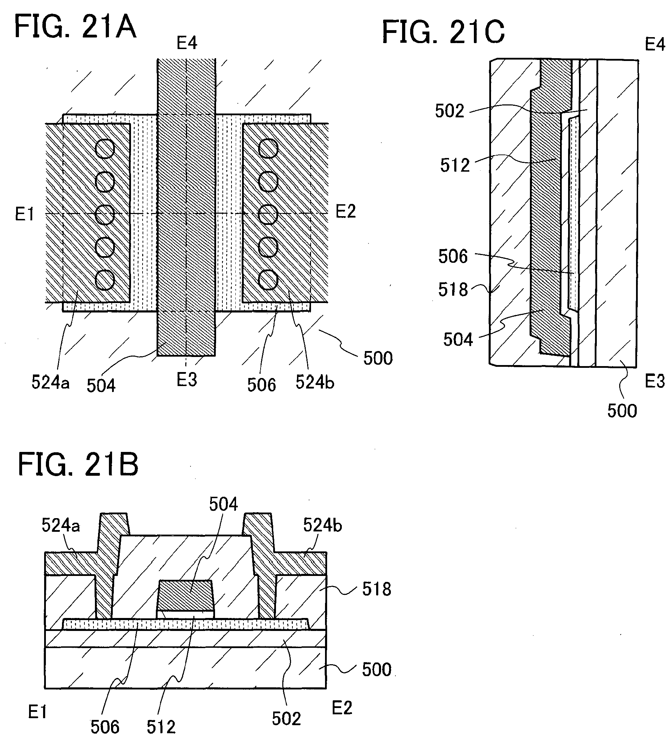

Next, a transistor whose structure is different from those of FIGS. 16A to 16C, FIGS. 17A to 17C, FIGS. 18A to 18C, FIGS. 19A to 19C, and FIGS. 20A to 20C is described with reference to FIGS. 21A to 21C.

FIG. 21A is a top view of a transistor of one embodiment of the present invention. FIG. 21B is a cross-sectional view taken along dashed-dotted line E1-E2 in FIG. 21A. FIG. 21C is a cross-sectional view taken along dashed-dotted line E3-E4 in FIG. 21A. For easy understanding, a gate insulating film 512 and the like are not illustrated in FIG. 21A.

FIG. 21B is a cross-sectional view of a transistor which includes a base insulating film 502 over a substrate 500, an oxide semiconductor film 506 over the base insulating film 502, the gate insulating film 512 over the oxide semiconductor film 506, a gate electrode 504 which is over the gate insulating film 512 and overlaps with the oxide semiconductor film 506, and an interlayer insulating film 518 over the oxide semiconductor film 506 and the gate electrode 504. Although FIG. 21B illustrates the structure in which the base insulating film 502 is provided, the present invention is not limited thereto. For example, the base insulating film 502 may be omitted.

In the cross-sectional view of FIG. 21B, the interlayer insulating film 518 has openings reaching the oxide semiconductor film 506, and wirings 524a and 524b over the interlayer insulating film 518 are in contact with the oxide semiconductor film 506 through the openings.

Although the gate insulating film 512 is provided only in a region which overlaps with the gate electrode 504 in FIG. 21B, the present invention is not limited thereto. For example, the gate insulating film 512 may be provided to cover the oxide semiconductor film 506. Further, a sidewall insulating film may be provided in contact with the sidewall of the gate electrode 504.

Further, in the case where the sidewall insulating film is provided in contact with the sidewall of the gate electrode 504, it is preferable that the resistance of a region of the oxide semiconductor film 506, which overlaps with the sidewall insulating film, be lower than that of a region of the oxide semiconductor film 506, which overlaps with the gate electrode 504. For example, a region of the oxide semiconductor film 506, which does not overlap with the gate electrode 504, may contain an impurity which reduces the resistance of the oxide semiconductor film 506, or may be a region whose resistance is reduced by a defect. The region of the oxide semiconductor film 506, which overlaps with the sidewall insulating film, functions as a lightly doped drain (LDD) region because the resistance thereof is lower than that of the region which overlaps with the gate electrode 504. With the LDD region of the transistor, drain induced barrier lowering (DIBL) and hot-carrier deterioration can be suppressed. The region of the oxide semiconductor film 506, which overlaps with the sidewall insulating film, may be used as an offset region. Also with the offset region of the transistor, DIBL and hot-carrier deterioration can be suppressed

For the oxide semiconductor film 506, refer to the description of the oxide semiconductor film 106.

For the substrate 500, refer to the description of the substrate 100.

For the base insulating film 502, an insulating film which is similar to the base insulating film 302 may be used.

For the gate insulating film 512, an insulating film similar to the gate insulating film 112 may be used.

For the gate electrode 504, refer to the description of the gate electrode 104.

The interlayer insulating film 518 may be formed using a single layer or a stacked layer of an insulating film containing one or more kinds of an aluminum oxide, a magnesium oxide, a silicon oxide, a silicon oxynitride, a gallium oxide, a germanium oxide, an yttrium oxide, a zirconium oxide, a lanthanum oxide, a neodymium oxide, a hafnium oxide, and a tantalum oxide.

The wiring 524a and the wiring 524b each may be formed using a single layer or a stacked layer of a simple substance, a nitride, an oxide, or an alloy containing one or more kinds of Al, Ti, Cr, Co, Ni, Cu, Y, Zr, Mo, Ag, Ta, and W. Note that the compositions of the wiring 524a and the wiring 524b are either the same as or different from each other.

Although not illustrated in the drawing, a back-gate electrode may be provided under the base insulating film 502 of the transistor illustrated in FIGS. 21A to 21C. For the back-gate electrode, refer to the description of the back-gate electrode 114.

In the transistor illustrated in FIGS. 21A to 21C, a region where the gate electrode 504 overlaps with another wiring or electrode is small, so that parasitic capacitance hardly occurs and the switching properties of the transistor can be increased. Further, the channel length of the transistor can be determined by the width of the gate electrode 504, which enables a miniaturized transistor having a short channel length to be fabricated easily.

In each of the transistors illustrated in FIGS. 16A to 16C, FIGS. 17A to 17C, FIGS. 18A to 18C, FIGS. 19A to 19C, FIGS. 20A to 20C, and FIGS. 21A to 21C, the oxide film with high crystallinity described in the above embodiments is applied to the oxide semiconductor film. Therefore, stable electrical characteristics are provided.

This embodiment can be implemented in appropriate combination with any of the other embodiments.

[Embodiment 5]

In this embodiment, a logic circuit that is a semiconductor device of one embodiment of the present invention is described.

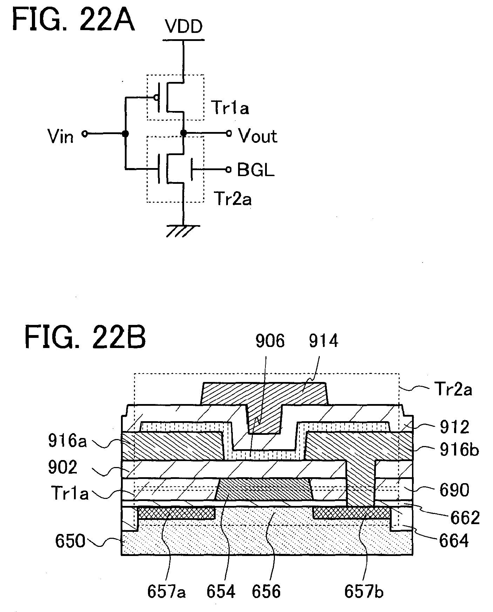

FIG. 22A is a circuit diagram showing one example of a NOT circuit (inverter) using a p-channel transistor and an n-channel transistor.

A transistor including, for example, silicon may be applied to a transistor Tr1a that is a p-channel transistor. However, the transistor Tr1a is not limited to the transistor including silicon. The threshold voltage of the transistor Tr1a is referred to as Vth1a.

As a transistor Tr2a that is an n-channel transistor, the transistor described in the above embodiments may be used. The threshold voltage of the transistor Tr2a is referred to as Vth2a.

Here, a gate of the transistor Tr1a is connected to an input terminal Vin and a gate of the transistor Tr2a. A source of the transistor Tr1a is electrically connected to a power source potential (VDD). A drain of the transistor Tr1a is connected to a drain of the transistor Tr2a and an output terminal Vout. A source of the transistor Tr2a is connected to a ground potential (GND). Further, a back gate of the transistor Tr2a is connected to a back-gate line BGL. Although the structure in which the transistor Tr2a has the back gate is described in this embodiment, the present invention is not limited thereto. For example, the transistor Tr2a may not have a back gate, and the transistor Tr1a may have a back gate.

For example, the threshold voltage Vth1a of the transistor Tr1a is set to be greater than VDD with the potential inverted and less than 0 V (-VDD < Vth1a < 0 V), and the threshold voltage Vth2a of the transistor Tr2a is set to be greater than 0 V and less than VDD (0 V < Vth2a < VDD). A back gate may be used to control the threshold voltage of the transistor.

Here, when the potential of the input terminal Vin is VDD, the gate voltage of the transistor Tr1a becomes 0 V, so that the transistor Tr1a is turned off, whereas the gate voltage of the transistor Tr2a becomes VDD, so that the transistor Tr2a is turned on. Consequently, the output terminal Vout is electrically connected to GND, so that GND is supplied to the output terminal Vout.

On the other hand, when the potential of the input terminal Vin is GND, the gate voltage of the transistor Tr1a becomes VDD, so that the transistor Tr1a is turned on, whereas the gate voltage of the transistor Tr2a becomes 0 V, so that the transistor Tr2a is turned off. Consequently, the output terminal Vout is electrically connected to VDD, so that VDD is supplied to the output terminal Vout.

As described above, in the circuit diagram shown in FIG. 22A, GND and VDD are output from the output terminal Vout when the potential of the input terminal Vin is VDD and when the potential of the input terminal Vin is GND, respectively.

FIG. 22B is one example of the cross-sectional view of a semiconductor device corresponding to FIG. 22A.

FIG. 22B is a cross-sectional view of a semiconductor device including the transistor Tr1a including a gate electrode 654, an insulating film 902 over the transistor Tr1a, and the transistor Tr2a which is over the transistor Tr1a and includes the gate electrode 654 and the insulating film 902.

The insulating film 902 may be formed using a single layer or a stacked layer of an insulating film containing one or more kinds of an aluminum oxide, a magnesium oxide, a silicon oxide, a silicon oxynitride, a gallium oxide, a germanium oxide, an yttrium oxide, a zirconium oxide, a lanthanum oxide, a neodymium oxide, a hafnium oxide, and a tantalum oxide.

In FIG. 22B, a transistor which is similar to the transistor illustrated in FIGS. 20A to 20C is applied to the transistor Tr2a. Therefore, for components of the transistor Tr2a other than the components described below, refer to the description of FIGS. 20A to 20C.

The transistor Tr1a includes a semiconductor substrate 650, a channel region 656, a source region 657a, and a drain region 657b which are formed in the semiconductor substrate 650, an element separation layer 664 which fills a groove formed in the semiconductor substrate 650, a gate insulating film 662 provided over the semiconductor substrate 650, and the gate electrode 654 provided over the channel region 656 with the gate insulating film 662 provided therebetween.

As the semiconductor substrate 650, a single crystal semiconductor substrate or a polycrystalline semiconductor substrate made of silicon, silicon carbide, or the like, or a compound semiconductor substrate made of silicon germanium or the like may be used.

Although the structure in which the transistor Tr1a is provided in the semiconductor substrate is described in this embodiment, the present invention is not limited thereto. For example, a substrate having an insulating surface may be used instead of the semiconductor substrate, and a semiconductor film may be provided on the insulating surface. As the substrate having an insulating surface, a glass substrate, a ceramic substrate, a quartz substrate, or a sapphire substrate may be used, for example.

The source region 657a and the drain region 657b are each a region of the semiconductor substrate 650 containing an impurity imparting p-type conductivity.

The element separation layer 664 may be formed using a single layer or a stacked layer of an insulating film containing one or more kinds of an aluminum oxide, a magnesium oxide, a silicon oxide, a silicon oxynitride, a silicon nitride oxide, a silicon nitride, a gallium oxide, a germanium oxide, an yttrium oxide, a zirconium oxide, a lanthanum oxide, a neodymium oxide, a hafnium oxide, and a tantalum oxide.

The gate insulating film 662 may be formed using a single layer or a stacked layer of an insulating film containing one or more kinds of an aluminum oxide, a magnesium oxide, a silicon oxide, a silicon oxynitride, a silicon nitride oxide, a silicon nitride, a gallium oxide, a germanium oxide, an yttrium oxide, a zirconium oxide, a lanthanum oxide, a neodymium oxide, a hafnium oxide, and a tantalum oxide.

The gate electrode 654 may be formed using a single layer or a stacked layer of a simple substance, a nitride, an oxide, or an alloy containing one or more kinds of Al, Ti, Cr, Co, Ni, Cu, Y, Zr, Mo, Ag, Ta, and W.

The gate electrode 654 functions as not only the gate electrode of the transistor Tr1a but also the gate electrode of the transistor Tr2a. Thus, the insulating film 902 functions as a gate insulating film of the transistor Tr2a.

For a source electrode 916a and a drain electrode 916b of the transistor Tr2a, refer to the description of the source electrode 416a and the drain electrode 416b.

For an oxide semiconductor film 906 of the transistor Tr2a, refer to the description of the oxide semiconductor film 406.

For a gate insulating film 912 of the transistor Tr2a, refer to the description of the gate insulating film 412.

For a gate electrode 914 of the transistor Tr2a, refer to the description of the gate electrode 404. The gate electrode 914 functions as the back-gate electrode of the transistor Tr2a.

The semiconductor device illustrated in FIG. 22B includes an insulating film 690 whose top surface is level with the top surface of the gate electrode 654. The insulating film 690 is not necessarily provided.

The insulating film 690 may be formed using a single layer or a stacked layer of an insulating film containing one or more kinds of an aluminum oxide, a magnesium oxide, a silicon oxide, a silicon oxynitride, a silicon nitride oxide, a silicon nitride, a gallium oxide, a germanium oxide, an yttrium oxide, a zirconium oxide, a lanthanum oxide, a neodymium oxide, a hafnium oxide, and a tantalum oxide.

An opening reaching the drain region 657b of the transistor Tr1a is provided in the insulating film 690, the insulating film 902, and the gate insulating film 662. The drain electrode 916b of the transistor Tr2a is in contact with the drain region 657b of the transistor Tr1a through the opening.

In the case where the transistor described in the above embodiments is applied to the transistor Tr2a, the off-state current of the transistor Tr2a is extremely small, and thus the shoot-through current in the case where the transistor Tr2a is off is also extremely small. Accordingly, a low power consumption inverter can be achieved.

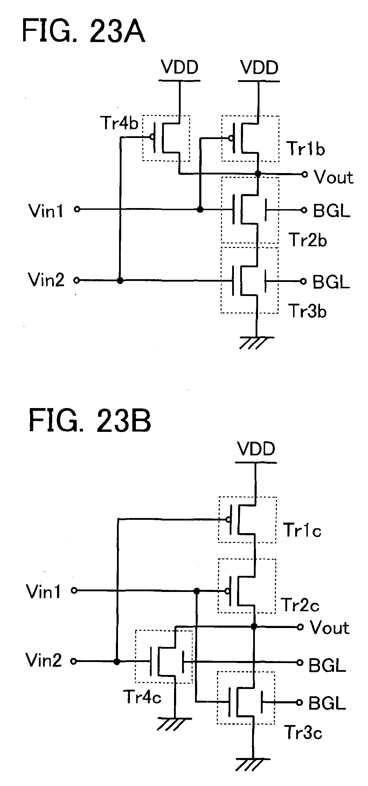

A NAND circuit shown in FIG. 23A may be configured by combining the inverters shown in FIG. 22A. A circuit diagram shown in FIG. 23A includes p-channel transistors Tr1b and Tr4b and n-channel transistors Tr2b and Tr3b. Transistors each using, for example, silicon may be applied to the transistors Tr1b and Tr4b. Further, the transistors including the oxide semiconductor film, which are described in the above embodiments, may be applied to the transistors Tr2b and Tr3b.

A NOR circuit shown in FIG. 23B may be configured by combining the inverters shown in FIG. 22A. A circuit diagram shown in FIG. 23B includes p-channel transistors Tr1c and Tr2c and n-channel transistors Tr3c and Tr4c. Transistors each using, for example, silicon may be applied to the transistors Tr1c and Tr2c. Further, the transistors including the oxide semiconductor film, which are described in the above embodiments, may be applied to the transistors Tr3c and Tr4c.

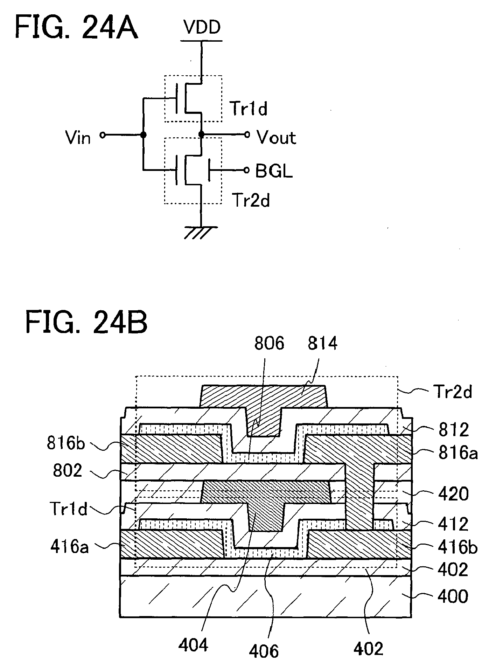

Although examples of the logic circuit configured by an inverter using a p-channel transistor and an n-channel transistor are described above, a logic circuit may be configured by an inverter using only n-channel transistors. An example thereof is shown in FIG. 24A.

A circuit diagram shown in FIG. 24A includes a depression transistor Tr1d and an enhancement transistor Tr2d.

A transistor including, for example, an oxide semiconductor film may be applied to the depression transistor Tr1d. However, the transistor Tr1d is not limited to the transistor including an oxide semiconductor film. For example, a transistor including silicon may be used as well. The threshold voltage of the transistor Tr1d is referred to as Vth1d. Instead of the depression transistor, a resistor with sufficiently low resistance may be provided.

As the enhancement transistor Tr2d, the transistor including the oxide semiconductor film, which is described in the above embodiments, may be used. The threshold voltage of the transistor Tr2d is referred to as Vth2d.

The transistor including the oxide semiconductor film, which is described in the above embodiments, may be used as the transistor Tr1d. In that case, any transistor other than the transistor including the oxide semiconductor film, which is described in the above embodiments, may be used as the transistor Tr2d.

Here, a gate of the transistor Tr1d is connected to an input terminal Vin and a gate of the transistor Tr2d. A drain of the transistor Tr1d is electrically connected to VDD. A source of the transistor Tr1d is connected to a drain of the transistor Tr2d and an output terminal Vout. A source of the transistor Tr2d is connected to GND. Further, a back gate of the transistor Tr2d is connected to a back-gate line BGL. Although the structure in which the transistor Tr2d has the back gate is described in this embodiment, the present invention is not limited thereto. For example, the transistor Tr2d may not have a back gate, and the transistor Tr1d may have a back gate.

For example, the threshold voltage Vth1d of the transistor Tr1d is set to be lower than 0 V (Vth1d < 0 V), so that the transistor Tr1d is on regardless of its gate voltage; that is, the transistor Tr1d functions as a resistor with sufficiently low resistance. Further, the threshold voltage Vth2d of the transistor Tr2d is set to be greater than 0 V and less than VDD (0 V < Vth2d < VDD). A back gate may be used to control the threshold voltage of the transistor. Further, a resistor with sufficiently low resistance may be provided instead of the transistor Tr1d.

Here, when the potential of the input terminal Vin is VDD, the gate voltage of the transistor Tr2d becomes VDD, so that the transistor Tr2d is turned on. Consequently, the output terminal Vout is electrically connected to GND, so that GND is supplied to the output terminal Vout.

On the other hand, when the potential of the input terminal Vin is GND, the gate voltage of the transistor Tr2d becomes 0 V, so that the transistor Tr2d is turned off. Consequently, the output terminal Vout is electrically connected to VDD, so that VDD is supplied to the output terminal Vout. Strictly speaking, a potential whose voltage is dropped from VDD by the resistance of the transistor Tr1d is output from the output terminal Vout; however, such a voltage drop can be ignored because the resistance of the transistor Tr1d is sufficiently low.

As described above, in the circuit diagram shown in FIG. 24A, GND and VDD are output from the output terminal Vout when the potential of the input terminal Vin is VDD and when the potential of the input terminal Vin is GND, respectively.

The transistor Tr1d and the transistor Tr2d may be formed in the same plane, which enables the inverter to be fabricated easily. In that case, at least one of the transistor Tr1d and the transistor Tr2d is preferably provided with a back gate. In the case where a depression transistor is formed, the threshold voltage Vth2d of the transistor Tr2d may be controlled to be in the above-described range by the back gate of the transistor Tr2d, and in the case where an enhancement transistor is formed, the threshold voltage Vth1d of the transistor Tr1d may be controlled to be in the above-described range by the back gate of the transistor Tr1d. The threshold voltages of the transistor Tr1d and the transistor Tr2d may be controlled by their respective back gates.

Alternatively, the transistor Tr1d and the transistor Tr2d may be stacked, which leads to a reduction in the area of the inverter.

FIG. 24B is one example of the cross-sectional view of a semiconductor device fabricated by stacking the transistor Tr1d and the transistor Tr2d.

In FIG. 24B, refer to the description of the transistor illustrated in FIGS. 20A to 20C for the transistor Tr1d, and a transistor which is similar to the transistor illustrated in FIGS. 20A to 20C is applied to the transistor Tr2d. Therefore, for components of the transistor Tr2d other than the components described below, refer to the description of FIGS. 20A to 20C.

The transistor Tr1d includes the base insulating film 402 over the substrate 400, the source electrode 416a and the drain electrode 416b over the base insulating film 402, the oxide semiconductor film 406 over the base insulating film 402, the source electrode 416a, and the drain electrode 416b, the gate insulating film 412 over the oxide semiconductor film 406, and the gate electrode 404 which is over the gate insulating film 412 and overlaps with the oxide semiconductor film 406.

The gate electrode 404 functions as not only the gate electrode of the transistor Tr1d but also the gate electrode of the transistor Tr2d. Thus, an insulating film 802 functions as a gate insulating film of the transistor Tr2d.

For a source electrode 816a and a drain electrode 816b of the transistor Tr2d, refer to the description of the source electrode 416a and the drain electrode 416b.

For an oxide semiconductor film 806 of the transistor Tr2d, refer to the description of the oxide semiconductor film 406.

For a gate insulating film 812 of the transistor Tr2d, refer to the description of the gate insulating film 412.

For a gate electrode 814 of the transistor Tr2d, refer to the description of the gate electrode 404. The gate electrode 814 functions as the back-gate electrode of the transistor Tr2d.

The semiconductor device illustrated in FIG. 24B includes an insulating film 420 whose top surface is level with the top surface of the gate electrode 404. The insulating film 420 is not necessarily provided.

The insulating film 420 may be formed using a single layer or a stacked layer of an insulating film containing one or more kinds of an aluminum oxide, a magnesium oxide, a silicon oxide, a silicon oxynitride, a silicon nitride oxide, a silicon nitride, a gallium oxide, a germanium oxide, an yttrium oxide, a zirconium oxide, a lanthanum oxide, a neodymium oxide, a hafnium oxide, and a tantalum oxide.

An opening reaching the drain electrode 416b of the transistor Tr1d is provided in the insulating film 420, the insulating film 802, the gate insulating film 412, and the oxide semiconductor film 406. The source electrode 816a of the transistor Tr2d is in contact with the drain electrode 416b of the transistor Tr1d through the opening.

In the case where the transistor described in the above embodiments is applied to the transistor Tr2d, the off-state current of the transistor Tr2d is extremely small, and thus the shoot-through current in the case where the transistor Tr2d is off is also extremely small. Accordingly, a low power consumption inverter can be achieved.

This embodiment can be implemented in appropriate combination with any of the other embodiments.

[Embodiment 6]

In this embodiment, a static random access memory (SRAM) which is a semiconductor device including a flip-flop to which the inverters described in Embodiment 5 are applied is described.

The SRAM, which retains data with the use of the flip-flop, does not need the refresh operation unlike a dynamic random access memory (DRAM). Therefore, power consumption in retaining data can be suppressed. In addition, since a capacitor is not used, the SRAM is suitable for application which requires high-speed operation.

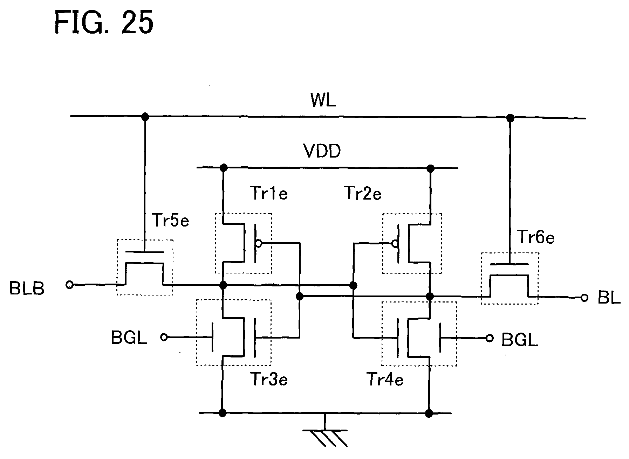

FIG. 25 is a circuit diagram of a memory cell of an SRAM of one embodiment of the present invention. FIG. 25, which shows one memory cell, may be applied to a memory cell array in which the plurality of memory cells are arranged.

The memory cell illustrated in FIG. 25 includes a transistor Tr1e, a transistor Tr2e, a transistor Tr3e, a transistor Tr4e, a transistor Tr5e, and a transistor Tr6e. The transistor Tr1e and the transistor Tr2e are p-channel transistors, and the transistor Tr3e and the transistor Tr4e are n-channel transistors. A gate of the transistor Tr1e is electrically connected to a drain of the transistor Tr2e, a gate of the transistor Tr3e, a drain of the transistor Tr4e, and one of a source and a drain of the transistor Tr6e. A source of the transistor Tr1e is electrically connected to VDD. A drain of the transistor Tr1e is electrically connected to a gate of the transistor Tr2e, a drain of the transistor Tr3e, and one of a source and a drain of the transistor Tr5e. A source of the transistor Tr2e is electrically connected to VDD. A source of the transistor Tr3e is electrically connected to GND. A back gate of the transistor Tr3e is electrically connected to a back-gate line BGL. A source of the transistor Tr4e is electrically connected to GND. A back gate of the transistor Tr4e is electrically connected to a back-gate line BGL. A gate of the transistor Tr5e is electrically connected to a word line WL. The other of the source and the drain of the transistor Tr5e is electrically connected to a bit line BLB. A gate of the transistor Tr6e is electrically connected to the word line WL. The other of the source and the drain of the transistor Tr6e is electrically connected to a bit line BL.

Described in this embodiment is an example in which n-channel transistors are applied to the transistors Tr5e and Tr6e. However, the transistors Tr5e and Tr6e are not limited to the n-channel transistors, and p-channel transistors may be applied thereto, and accordingly the method of writing, retaining, and reading data described below is changed as appropriate.

In this manner, the inverter including the transistors Tr1e and Tr3e is connected to the inverter including the transistors Tr2e and Tr4e in ring connection, whereby the flip-flop is configured.

A transistor including, for example, silicon may be applied to the p-channel transistor. However, the p-channel transistor is not limited to the transistor including silicon. Further, the transistor including the oxide semiconductor film, which is described in the above embodiments, may be used as the n-channel transistor.

In this embodiment, the transistor including the oxide semiconductor film, which is described in the above embodiments, is applied to each of the transistors Tr3e and Tr4e. Since the off-state current of the transistor is extremely small, the shoot-through current is also extremely small.

Instead of the p-channel transistors, n-channel transistors may be applied to the transistors Tr1e and Tr2e. In the case where n-channel transistors are used as the transistors Tr1e and Tr2e, depression transistors may be applied thereto with reference to the description of FIGS. 24A and 24B.

Data writing, retaining, and reading of the memory cell shown in FIG. 25 are described below.

In the case where data is written, first, potentials corresponding to data 0 or data 1 are applied to the bit line BL and the bit line BLB.

For example, in the case where data 1 is to be written, the bit line BL and the bit line BLB are set to VDD and GND, respectively. Next, a potential (VH) which is greater than or equal to a potential obtained by adding VDD to the threshold voltage of the transistor Tr5e and Tr6e is applied to the word line WL.

Next, the potential of the word line WL is changed to a potential lower than the threshold voltage of the transistor Tr5e and Tr6e, so that the data 1 written into the flip-flop is retained. In the case of an SRAM, the current flowing during a period of retaining data is only the leak current of the transistor. Therefore, by applying the transistor including the oxide semiconductor film, which is described in the above embodiments, to the transistor included in the SRAM, standby electricity for data retention can be reduced because the off-state current of the transistor is extremely small, i.e., the leak current attributed to the transistor is extremely small.

In the case where the data is read, first, the bit line BL and the bit line BLB are set to VDD in advance. Next, VH is applied to the word line WL, so that the potential of the bit line BL remains VDD but the bit line BLB is discharged through the transistors Tr5e and Tr3e to be GND. This difference between the potential of the bit line BL and the potential of the bit line BLB is amplified by a sense amplifier (not shown), whereby the retained data 1 can be read.

In the case where data 0 is to be written, the bit line BL and the bit line BLB are set to GND and VDD, respectively, and then, VH is applied to the word line WL. Next, the potential of the word line WL is changed to a potential lower than the threshold voltage of the transistor Tr5e and Tr6e, so that the data 0 written into the flip-flop is retained. In the case where the data is read, first, the bit line BL and the bit line BLB are set to VDD, and then, VH is applied to the word line WL, so that the potential of the bit line BLB remains VDD but the bit line BL is discharged through the transistors Tr6e and Tr4e to be GND. This difference between the potential of the bit line BL and the potential of the bit line BLB is amplified by the sense amplifier, whereby the retained data 0 can be read.

According to this embodiment, an SRAM with low standby electricity can be provided.

This embodiment can be implemented in appropriate combination with any of the other embodiments.

[Embodiment 7]

The off-state current of the transistor including the oxide semiconductor film, which is described in the above embodiments, can be made extremely small. That is, the transistor has such electrical characteristics in which leakage of charge through the transistor is less likely to occur.

A semiconductor device including a memory element to which the transistor having such electrical characteristics and which has a greater function than a semiconductor device including a conventional memory element is described below.

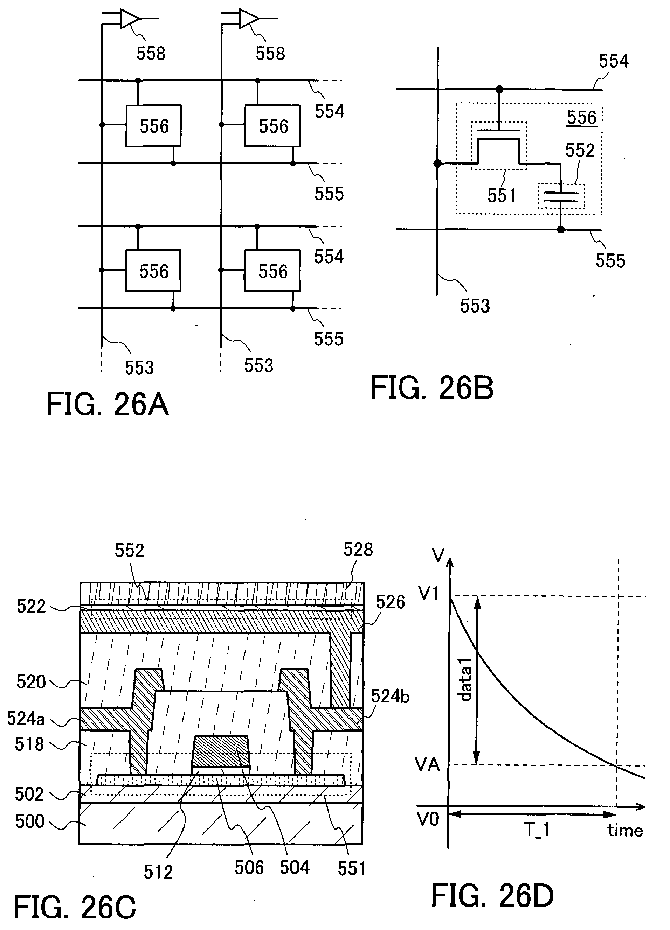

First, a semiconductor device is specifically described with reference to FIGS. 26A to 26D. FIG. 26A is a circuit diagram of a memory cell array of the semiconductor device. FIG. 26B is a circuit diagram of a memory cell. FIG. 26C illustrates an example of the cross-sectional structure of the memory cell shown in FIG. 26B. Further, FIG. 26D is a graph showing electrical characteristics of the memory cell shown in FIG. 26B.

The memory cell array shown in FIG. 26A includes memory cells 556, bit lines 553, word lines 554, capacitor lines 555, and sense amplifiers 558.

The bit lines 553 and the word lines 554 are provided in a grid pattern, and the memory cell 556 is provided per intersection of the bit line 553 and the word line 554. The bit line 553 is connected to the sense amplifier 558. The potential of the bit line 553 is read as data by the sense amplifier 558.

In FIG. 26B, the memory cell 556 includes a transistor 551 and a capacitor 552. A gate of the transistor 551 is electrically connected to the word line 554, a source of the transistor 551 is electrically connected to the bit line 553, and a drain of the transistor 551 is electrically connected to one electrode of the capacitor 552. The other electrode of the capacitor 552 is electrically connected to the capacitor line 555.

FIG. 26C illustrates an example of the cross-sectional structure of the memory cell. FIG. 26C is a cross-sectional view of a semiconductor device including the transistor 551, the wiring 524a and the wiring 524b which are connected to the transistor 551, an insulating film 520 over the transistor 551 and the wirings 524a and 524b, and the capacitor 552 over the insulating film 520.

In FIG. 26C, the transistor illustrated in FIGS. 21A to 21C is applied to the transistor 551. Therefore, for components of the transistor 551 other than the components described below, refer to the description in the above embodiment.

For the insulating film 520, refer to the description of the interlayer insulating film 518. A resin film made of a polyimide resin, an acrylic resin, an epoxy resin, a silicone resin, or the like may be used as the insulating film 520.

The capacitor 552 includes an electrode 526 which is in contact with the wiring 524b, an electrode 528 which overlaps with the electrode 526, and an insulating film 522 which is provided between the electrodes 526 and 528.

The electrode 526 may be formed using a single layer or a stacked layer of a simple substance, a nitride, an oxide, or an alloy containing one or more kinds of aluminum, titanium, chromium, cobalt, nickel, copper, yttrium, zirconium, molybdenum, silver, tantalum, and tungsten.

The electrode 528 may be formed using a single layer or a stacked layer of a simple substance, a nitride, an oxide, or an alloy containing one or more kinds of aluminum, titanium, chromium, cobalt, nickel, copper, yttrium, zirconium, molybdenum, silver, tantalum, and tungsten.

The insulating film 522 may be formed using a single layer or a stacked layer including an insulating film containing one or more kinds of an aluminum oxide, a magnesium oxide, a silicon oxide, a silicon oxynitride, a silicon nitride oxide, a silicon nitride, a gallium oxide, a germanium oxide, an yttrium oxide, a zirconium oxide, a lanthanum oxide, a neodymium oxide, a hafnium oxide, and a tantalum oxide.

Although the example in which the transistor 551 and the capacitor 552 are provided in different layers is illustrated in FIG. 26C, the present invention is not limited thereto. For example, the transistor 551 and the capacitor 552 may be provided in the same plane, which enables a memory cell having the same structure to be stacked over the memory cell. By stacking a plurality of memory cells, a large number of memory cells can be integrated in the area for one memory cell. Accordingly, the degree of integration of the semiconductor device can be increased. Note that in this specification, "A overlaps with B" means that A and B are provided such that at least part of A overlaps with at least part of B.

The wiring 524a in FIG. 26C is electrically connected to the bit line 553 in FIG. 26B. The gate electrode 504 in FIG. 26C is electrically connected to the word line 554 in FIG. 26B. The electrode 528 in FIG. 26C is electrically connected to the capacitor line 555 in FIG. 26B.

As shown in FIG. 26D, a voltage retained in the capacitor 552 decreases gradually due to leak through the transistor 551 as time passes. A voltage which has been charged from V0 to V1 decreases to VA which is a limit for reading data 1 as a certain period of time passes. This period is referred to as a retaining period T_1. That is, in the case of a two-level memory cell, refresh operation needs to be performed within the retaining period T_1.

For example, in the case where the off-state current of the transistor 551 is not sufficiently small, the amount of change of a voltage retained in the capacitor 552 with time is large, resulting in a reduction in the retaining period T_1. Consequently, the frequency of refresh operations needs to be increased, which leads to an increase in power consumption of the semiconductor device.

Since the off-state current of the transistor 551 is extremely small in this embodiment, the retaining period T_1 can be made extremely long. That is, the frequency of refresh operations can be reduced, which results in reduction in power consumption. For example, in the case where the transistor 551 in the memory cell has an off-state current of $1 \times 10^{-21}$ A to $1 \times 10^{-25}$ A, data can be retained for several days to several decades during which power is not supplied.

As described above, according to one embodiment of the present invention, a semiconductor device with high integration degree and low power consumption can be provided.

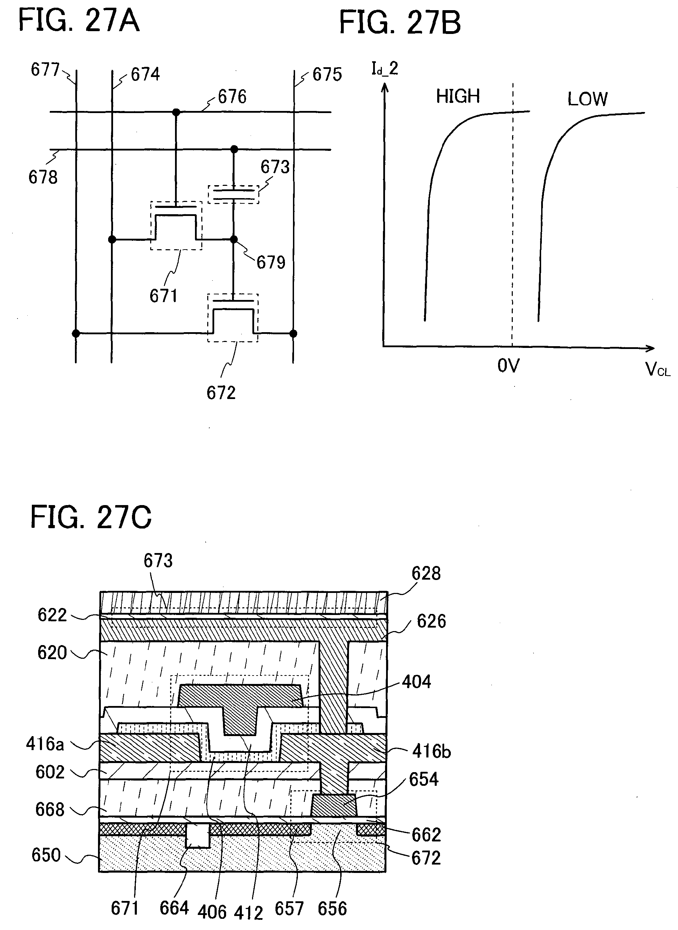

Next, a semiconductor device which is different from FIGS. 26A to 26D is described with reference to FIGS. 27A to 27C. FIG. 27A is a circuit diagram including a memory cell and wirings of the semiconductor device. FIG. 27B is a graph showing electrical characteristics of the memory cell shown in FIG. 27A. FIG. 27C illustrates an example of the cross-sectional structure of the memory cell shown in FIG. 27A.

In FIG. 27A, the memory cell includes a transistor 671, a transistor 672, and a capacitor 673. A gate of the transistor 671 is electrically connected to a word line 676, and a source of the transistor 671 is electrically connected to a source line 674. A drain of the transistor 671 is electrically connected to a gate of the transistor 672 and one electrode of the capacitor 673; this connection portion is referred to as a node 679. A source of the transistor 672 is electrically connected to a source line 675, and a drain of the transistor 672 is electrically connected to a drain line 677. The other electrode of the capacitor 673 is electrically connected to a capacitor line 678.

The semiconductor device shown in FIGS. 27A to 27C utilizes the fact that the apparent threshold voltage of the transistor 672 is changed in accordance with the potential of the node 679. For example, FIG. 27B is a graph showing a relation between the voltage $V_{CL}$ of the capacitor line 678 and the drain current $I_{d\_}2$ flowing through the transistor 672.

The potential of the node 679 can be controlled through the transistor 671. For example, the potential of the source line 674 is set to a power source potential VDD. In that case, when the potential of the word line 676 is set to be greater than or equal to a potential obtained by adding the power source potential VDD to the threshold voltage Vth of the transistor 671, the voltage of the node 679 can be HIGH. On the other hand, when the potential of the word line 676 is set to be less than or equal to the threshold voltage Vth of the transistor 671, the potential of the node 679 can be LOW.

Therefore, the transistor 672 has either electrical characteristics shown by a curve $V_{CL}$ - $I_{d\_}2$ denoted by LOW or electrical characteristics shown by a curve $V_{CL}$ - $I_{d\_}2$ denoted by HIGH. That is, when the potential of the node 679 is LOW, data 0 is stored at $V_{CL}$ of 0 V because $I_{d\_}2$ is small. Further, when the potential of the node 679 is HIGH, data 1 is stored at $V_{CL}$ of 0 V because $I_{d\_}2$ is large. In this manner, data can be stored.

FIG. 27C illustrates an example of the cross-sectional structure of the memory cell. FIG. 27C is a cross-sectional view of a semiconductor device including the transistor 672, an insulating film 668 over the transistor 672, the transistor 671 over the insulating film 668, an insulating film 620 over the transistor 671, and the capacitor 673 over the insulating film 620.

For the insulating film 620, refer to the description of the protective insulating film 118. A resin film made of a polyimide resin, an acrylic resin, an epoxy resin, a silicone resin, or the like may be used as the insulating film 620.

In FIG. 27C, the transistor illustrated in FIGS. 20A to 20C is applied to the transistor 671. Therefore, for components of the transistor 671 other than the components described below, refer to the description in the above embodiment.

A transistor including crystalline silicon has an advantage of higher capability of increasing the on-state characteristics over a transistor including an oxide semiconductor film, and is therefore suitable for the transistor 672 that needs high on-state characteristics.

The transistor 672 includes the channel region 656 and impurity regions 657 in the semiconductor substrate 650, the element separation layer 664 which fills a groove in the semiconductor substrate 650, the gate insulating film 662 over the semiconductor substrate 650, and the gate electrode 654 over the channel region 656 with the gate insulating film 662 provided therebetween.

As the semiconductor substrate 650, a single crystal semiconductor substrate or a polycrystalline semiconductor substrate made of silicon, silicon carbide, or the like, or a compound semiconductor substrate made of silicon germanium or the like may be used.

Although the structure in which the transistor 672 is provided in the semiconductor substrate is described in this embodiment, the present invention is not limited thereto. For example, a substrate having an insulating surface may be used instead of the semiconductor substrate, and a semiconductor film may be provided on the insulating surface. As the substrate having an insulating surface, a glass substrate, a ceramic substrate, a quartz substrate, or a sapphire substrate may be used, for example. The transistor including the oxide semiconductor film, which is described in the above embodiments, may be applied to the transistor 672.

The impurity regions 657 are each a region of the semiconductor substrate 650 containing an impurity imparting one conductivity type.

The element separation layer 664 may be formed using a single layer or a stacked layer of an insulating film containing one or more kinds of an aluminum oxide, a magnesium oxide, a silicon oxide, a silicon oxynitride, a silicon nitride oxide, a silicon nitride, a gallium oxide, a germanium oxide, an yttrium oxide, a zirconium oxide, a lanthanum oxide, a neodymium oxide, a hafnium oxide, and a tantalum oxide.

The gate insulating film 662 may be formed using a single layer or a stacked layer of an insulating film containing one or more kinds of an aluminum oxide, a magnesium oxide, a silicon oxide, a silicon oxynitride, a silicon nitride oxide, a silicon nitride, a gallium oxide, a germanium oxide, an yttrium oxide, a zirconium oxide, a lanthanum oxide, a neodymium oxide, a hafnium oxide, and a tantalum oxide.

For the gate electrode 654, refer to the description of the gate electrode 104.

For the insulating film 668, refer to the description of the protective insulating film 118. A resin film made of a polyimide resin, an acrylic resin, n epoxy resin, a silicone resin, or the like may be used as the insulating film 668.

The insulating film 668 and the base insulating film 602 have an opening reaching the gate electrode 654 of the transistor 672. The drain electrode 416b of the transistor 671 is in contact with the gate electrode 654 of the transistor 672 through the opening.

The capacitor 673 includes an electrode 626 which is in contact with the drain electrode 416b, an electrode 628 which overlaps with the electrode 626, and an insulating film 622 which is provided between the electrodes 626 and 628.

For the electrode 626, refer to the description of the electrode 526.

For the electrode 628, refer to the description of the electrode 528.

The source electrode 416a in FIG. 27C is electrically connected to the source line 674 in FIG. 27A. The gate electrode 404 in FIG. 27C is electrically connected to the word line 676 in FIG. 27A. The electrode 628 in FIG. 27C is electrically connected to the capacitor line 678 in FIG. 27A.

Although the example in which the transistor 671 and the capacitor 673 are provided in different layers is illustrated in FIG. 27C, the present invention is not limited thereto. For example, the transistor 671 and the capacitor 673 may be provided in the same plane, which enables a memory cell having the same structure to be stacked over the memory cell. By stacking a plurality of memory cells, a large number of memory cells can be integrated in the area for one memory cell. Accordingly, the degree of integration of the semiconductor device can be increased.

By applying the transistor including the oxide semiconductor film, which is described in the above embodiments, to the transistor 671, leak of charge accumulated in the node 679 through the transistor 671 can be suppressed because the off-state current of the transistor is extremely small. Therefore, data can be retained for a long period. Further, as compared to a flash memory, a high voltage is not needed in writing data, and accordingly power consumption can be reduced and the operation speed can be increased.

As described above, according to one embodiment of the present invention, a semiconductor device with high integration degree and low power consumption can be provided.

This embodiment can be implemented in appropriate combination with any of the other embodiments.

[Embodiment 8]

A central processing unit (CPU) can be formed with the use of the transistor including the oxide semiconductor film or the semiconductor device including the memory element described in the above embodiments, for at least part of the CPU.

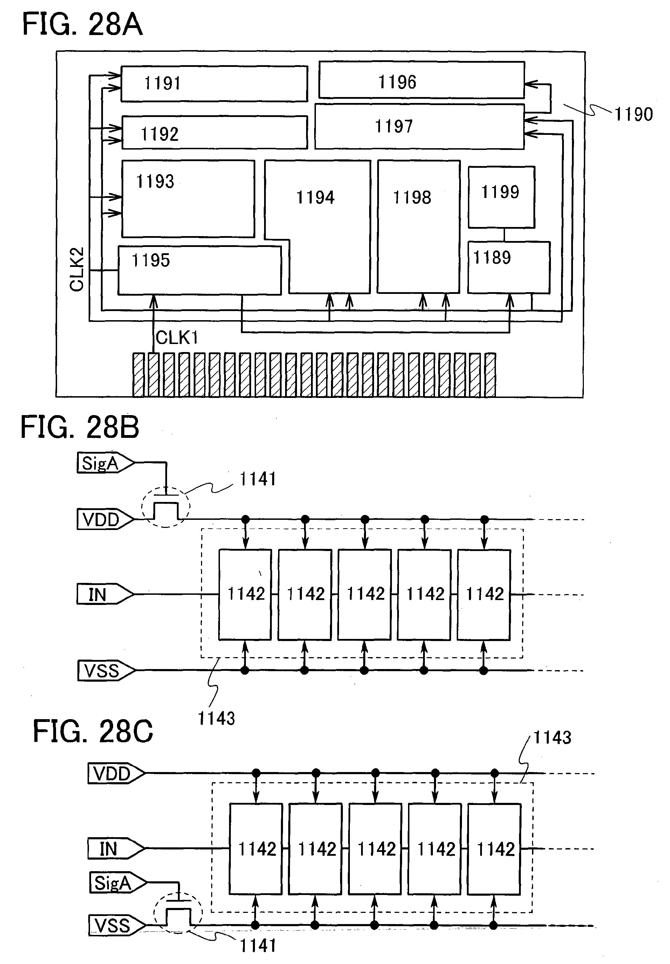

FIG. 28A is a block diagram showing a specific structure of a CPU. The CPU shown in FIG. 28A includes an arithmetic logic unit (ALU) 1191, an ALU controller 1192, an instruction decoder 1193, an interrupt controller 1194, a timing controller 1195, a register 1196, a register controller 1197, a bus interface (Bus I/F) 1198, a rewritable ROM 1199, and an ROM interface (ROM I/F) 1189 over a substrate 1190. A semiconductor substrate, an SOI substrate, a glass substrate, or the like is used as the substrate 1190. The ROM 1199 and the ROM interface 1189 may be provided over a separate chip. The CPU shown in FIG. 28A is just an example in which the structure is simplified; an actual CPU may have various structures depending on its application.

An instruction input to the CPU through the bus interface 1198 is input to the instruction decoder 1193 and decoded therein, and then input to the ALU controller 1192, the interrupt controller 1194, the register controller 1197, and the timing controller 1195.

The ALU controller 1192, the interrupt controller 1194, the register controller 1197, and the timing controller 1195 conduct various controls in accordance with the decoded instruction. Specifically, the ALU controller 1192 generates signals for controlling the operation of the ALU 1191. While the CPU is executing a program, the interrupt controller 1194 judges an interrupt request from an external input/output device or a peripheral circuit on the basis of its priority or a mask state, and processes the request. The register controller 1197 generates an address of the register 1196, and reads/writes data from/to the register 1196 in accordance with the state of the CPU.

The timing controller 1195 generates signals for controlling operation timings of the ALU 1191, the ALU controller 1192, the instruction decoder 1193, the interrupt controller 1194, and the register controller 1197. For example, the timing controller 1195 has an internal clock generator for generating an internal clock signal CLK2 based on a reference clock signal CLK1, and supplies the clock signal CLK2 to the above circuits.

In the CPU shown in FIG. 28A, a memory element is provided in the register 1196. In the register 1196, the semiconductor device including the memory element described in the above embodiments can be used.

In the CPU shown in FIG. 28A, the register controller 1197 selects operation of retaining data in the register 1196 in accordance with an instruction from the ALU 1191. That is, the register controller 1197 selects whether data is retained by a flip-flop or data is retained by a capacitor in the memory element included in the register 1196. When data is retained by the flip-flop, a power source voltage is supplied to the memory element in the register 1196. When data is retained by the capacitor, the data in the capacitor is rewritten, and supply of the power source voltage to the memory element in the register 1196 can be stopped.

The power supply can be stopped by a switching element provided between the memory element group and the node to which a power source potential VDD or a power source potential VSS is applied, as shown in FIG. 28B or FIG. 28C. Circuits illustrated in FIGS. 28B and 28C are described below.

FIGS. 28B and 28C each illustrate an example of the structure using the transistor including the oxide semiconductor film, which is described in the above embodiments, as the switching element for controlling supply of the power source potential to the memory element.

A memory device shown in FIG. 28B includes a switching element 1141 and a memory element group 1143 including a plurality of memory elements 1142. Specifically, as each of the memory elements 1142, the semiconductor device including the memory element described in the above embodiments can be used. Each of the memory elements 1142 included in the memory element group 1143 is supplied with the high-level power source potential VDD through the switching element 1141. Further, each of the memory elements 1142 included in the memory element group 1143 is supplied with the potential of a signal IN and the potential of the low-level power source potential VSS.

In FIG. 28B, the transistor including the oxide semiconductor film, which is described in the above embodiments, is used as the switching element 1141. The off-state current of the transistor can be made extremely small. The switching of the transistor is controlled by a signal SigA input to a gate thereof.

Although FIG. 28B shows the structure in which the switching element 1141 includes only one transistor, the present invention is not limited thereto; a plurality of transistors may be included. In the case where the switching element 1141 includes a plurality of transistors which function as switching elements, the plurality of transistors may be connected to each other in parallel, in series, or in combination of parallel connection and series connection.

In FIG. 28C, an example of a memory device in which each of the memory elements 1142 included in the memory element group 1143 is supplied with the low-level power source potential VSS through the switching element 1141 is illustrated. The supply of the low-level power source potential VSS to each of the memory elements 1142 included in the memory element group 1143 can be controlled by the switching element 1141.

With the switching element provided between the memory element group and the node to which the power source potential VDD or the power source potential VSS is supplied, data can be retained even in the case where an operation of the CPU is temporarily stopped and the supply of the power source voltage is stopped; accordingly, power consumption can be reduced. For example, while a user of a personal computer does not input data to an input device such as a keyboard, the operation of the CPU can be stopped, whereby the power consumption can be reduced.

Although the CPU is given as an example in this embodiment, the transistor can also be applied to an LSI such as a digital signal processor (DSP), a custom LSI, or a field programmable gate array (FPGA).

This embodiment can be implemented in appropriate combination with any of the other embodiments.

[Embodiment 9]

In this embodiment, a display device to which the transistor described in the above embodiments is applied is described.

As a display element provided in the display device, a liquid crystal element (also referred to as a liquid crystal display element), a light-emitting element (also referred to as a light-emitting display element), or the like can be used. The light-emitting element includes, in its category, an element whose luminance is controlled by current or voltage, specifically an inorganic electroluminescent (EL) element, an organic EL element, and the like. Furthermore, a display medium whose contrast is changed by an electric effect, such as electronic ink, can be used as the display element. In this embodiment, a display device including an EL element and a display device including a liquid crystal element are described as examples of the display device.

The display device in this embodiment includes in its category a panel in which a display element is sealed, and a module in which an IC such as a controller or the like is mounted on the panel.

The display device in this embodiment also refers to an image display device, a display device, or a light source (including a lighting device). The display device includes any of the following modules: a module provided with a connector such as an FPC or TCP; a module in which a printed wiring board is provided at the end of TCP; and a module in which an integrated circuit (IC) is mounted directly on a display element by a COG method.

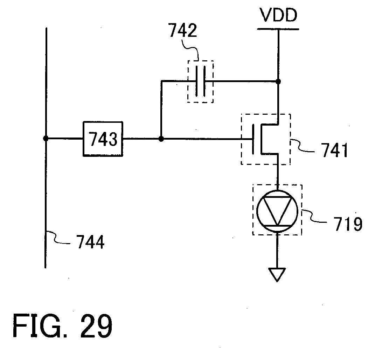

FIG. 29 is an example of the circuit diagram of a pixel of a display device including an EL element.

The display device shown in FIG. 29 includes a switching element 743, a transistor 741, a capacitor 742, and a light-emitting element 719.

A gate of the transistor 741 is electrically connected to one electrode of the switching element 743 and one electrode of the capacitor 742. A source of the transistor 741 is electrically connected to one terminal of the light-emitting element 719. A drain of the transistor 741 is electrically connected to the other electrode of the capacitor 742, to which a power source potential VDD is supplied. The other electrode of the switching element 743 is electrically connected to a signal line 744. A constant potential is supplied to the other terminal of the light-emitting element 719. The constant potential is a ground potential GND or a potential lower than the ground potential GND.

The transistor including the oxide semiconductor film, which is described in the above embodiments, is used as the transistor 741. The transistor has stable electrical characteristics. Accordingly, a display device having high display quality can be provided.

A transistor is preferably used as the switching element 743, which enables the pixel area to be small, so that a display device with high resolution can be achieved. The transistor including the oxide semiconductor film, which is described in the above embodiments, may be used as the switching element 743; accordingly, the switching element 743 can be fabricated by the same process as the transistor 741, which leads to an improvement in the productivity of the display device.

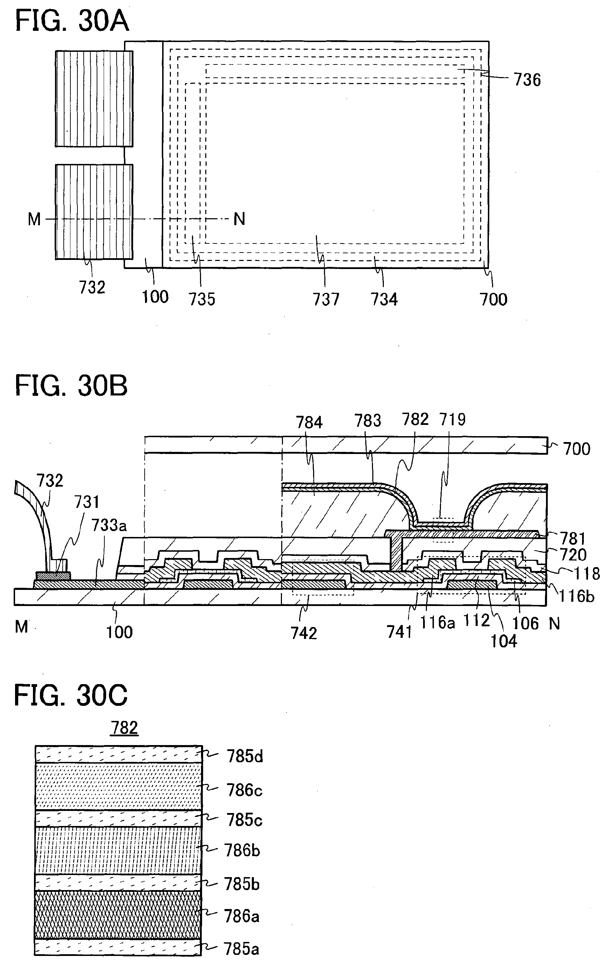

FIG. 30A is a top view of a display device including an EL element. The display device including an EL element includes a substrate 100, a substrate 700, a seal material 734, a driver circuit 735, a driver circuit 736, a pixel 737, and an FPC 732. The seal material 734 is provided between the substrate 100 and the substrate 700 so as to surround the pixel 737, the driver circuit 735, and the driver circuit 736. The driver circuit 735 and/or the driver circuit 736 may be provided outside the seal material 734.

FIG. 30B is a cross-sectional view of the display device including an EL element taken along dashed-dotted line M-N in FIG. 30A. The FPC 732 is connected to a wiring 733a through a terminal 731. The wiring 733a is the same layer as the gate electrode 104.

FIG. 30B illustrates the example in which the transistor 741 and the capacitor 742 are provided in the same plane. With such a structure, the capacitor 742 can be fabricated in the same planes as the gate electrode, the gate insulating film, and the source (drain) electrode of the transistor 741. Such provision of the transistor 741 and the capacitor 742 in the same plane leads to shortening of the manufacturing process of the display device and an improvement of the productivity.

FIG. 30B illustrates the example in which the transistor illustrated in FIGS. 16A to 16C is applied to the transistor 741. Therefore, for components of the transistor 741 other than the components described below, refer to the description of the above embodiment.

An insulating film 720 is provided over the transistor 741 and the capacitor 742.

Here, an opening reaching the source electrode 116a of the transistor 741 is provided in the insulating film 720 and the protective insulating film 118.

An electrode 781 is provided over the insulating film 720. The electrode 781 is in contact with the source electrode 116a of the transistor 741 though the opening provided in the insulating film 720 and the protective insulating film 118.

Over the electrode 781, a bank 784 having an opening reaching the electrode 781 is provided.

Over the bank 784, a light-emitting layer 782 in contact with the electrode 781 through the opening provided in the bank 784 is provided.

An electrode 783 is provided over the light-emitting layer 782.

A region where the electrode 781, the light-emitting layer 782, and the electrode 783 overlap with one another serves as the light-emitting element 719.

For the insulating film 720, refer to the protective insulating film 118. A resin film made of a polyimide resin, an acrylic resin, an epoxy resin, a silicone resin, or the like may be used as the insulating film 720.

The light-emitting layer 782 is not limited to one layer and may be a stacked layer of plural kinds of light-emitting layers. For example, a structure illustrated in FIG. 30C may be used. FIG. 30C illustrates a structure in which an intermediate layer 785a, a light-emitting layer 786a, an intermediate layer 785b, a light-emitting layer 786b, an intermediate layer 785c, a light-emitting layer 786c, and an intermediate layer 785d are stacked in this order. By using light-emitting layers whose emission colors are appropriate as the light-emitting layer 786a, the light-emitting layer 786b, and the light-emitting layer 786c, the light-emitting element 719 can be provided with high color rendering properties or high luminous efficiency.

White light may be provided by stacking plural kinds of light-emitting layers. Although not illustrated in FIG. 30B, a structure in which white light is extracted through a coloring layer may be employed.

Although the structure in which three light-emitting layers and four intermediate layers are provided is illustrated here, the number of light-emitting layers and the number of intermediate layers can be changed as appropriate without being limited thereto. For example, the light-emitting layer 782 may be formed with the intermediate layer 785a, the light-emitting layer 786a, the intermediate layer 785b, the light-emitting layer 786b, and the intermediate layer 785c. Alternatively, the light-emitting layer 782 may be formed with the intermediate layer 785a, the light-emitting layer 786a, the intermediate layer 785b, the light-emitting layer 786b, the light-emitting layer 786c, and the intermediate layer 785d, and the intermediate layer 785c may be omitted.

The intermediate layer can be formed using a stacked-layer structure of a hole-injection layer, a hole-transport layer, an electron-transport layer, an electron-injection layer, or the like. Not all of these layers need to be provided in the intermediate layer; these layers may be selected as appropriate. Further, layers having the same functions may be provided to overlap with each other. Further, an electron-relay layer or the like may be added as appropriate as the intermediate layer, in addition to a carrier generation layer.

As the electrode 781, a conductive film having visible light permeability may be used. Having visible light permeability means to have an average transmittance of 70 % or more, particularly 80 % or more in the visible light region (e.g., the range of wavelength of from 400 nm to 800 nm).

As the electrode 781, for example, an oxide film such as an In-Zn-W oxide film, an In-Sn oxide film, an In-Zn oxide film, an In oxide film, a Zn oxide film, or an Sn oxide film may be used. Further, a slight amount of Al, Ga, Sb, F, or the like may be added to the above-described oxide film. A metal thin film having a thickness thin enough to transmit light (preferably, approximately 5 nm to 30 nm) can also be used. For example, an Ag film, a Mg film, or an Ag-Mg alloy film with a thickness of 5 nm may be used.

Alternatively, a film on which visible light is reflected efficiently is preferably used as the electrode 781. For example, a film containing lithium, aluminum, titanium, magnesium, lanthanum, silver, silicon, or nickel may be used as the electrode 781.

As the electrode 783, any of the films described for the electrode 781 can be used. Note that in the case where the electrode 781 has visible light permeability, it is preferable that the electrode 783 reflect visible light efficiently, and in the case where the electrode 781 reflects visible light efficiently, it is preferable that the electrode 783 have visible light permeability.

Although the electrodes 781 and 783 are provided in accordance with the structure illustrated in FIG. 30B, the positions of the electrodes 781 and 783 may be replaced with each other. It is preferable to use a conductive film having a high work function for the electrode which functions as an anode, and a conductive film having a low work function for the electrode which functions as a cathode. However, in the case where a carrier generation layer is provided in contact with the anode, a variety of conductive films can be used for the anode regardless of their work functions.

For the bank 784, refer to the protective insulating film 118. A resin film made of a polyimide resin, an acrylic resin, an epoxy resin, a silicone resin, or the like may be used as the bank 784.

The transistor 741 connected to the light-emitting element 719 has stable electrical characteristics. Accordingly, a display device having high display quality can be provided.

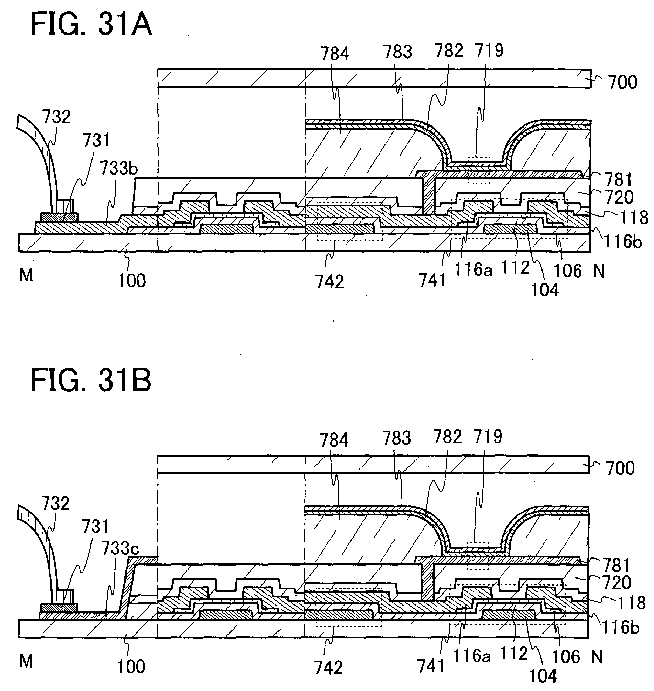

FIGS. 31A and 31B are examples of the cross-sectional view of a display device including an EL element, which are partly different from FIG. 30B. Specifically, the wiring connected to the FPC 732 is different in them. In FIG. 31A, the FPC 732 is connected to a wiring 733b through the terminal 731. The wiring 733b is the same layer as the source electrode 116a and the drain electrode 116b. In FIG. 31B, the FPC 732 is connected to a wiring 733c through the terminal 731. The wiring 733c is the same layer as the electrode 781.

Next, a display device including a liquid crystal element is described.

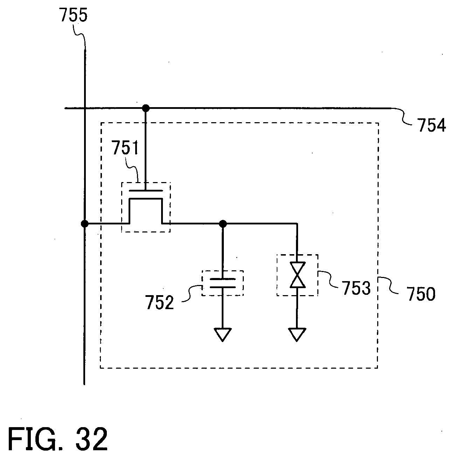

FIG. 32 is a circuit diagram illustrating a configuration example of the pixel of a display device including a liquid crystal element. A pixel 750 shown in FIG. 32 includes a transistor 751, a capacitor 752, and an element (hereinafter also referred to as liquid crystal element) 753 in which a space between a pair of electrodes is filled with a liquid crystal.

One of a source and a drain of the transistor 751 is electrically connected to a signal line 755, and a gate of the transistor 751 is electrically connected to a scan line 754.

One electrode of the capacitor 752 is electrically connected to the other of the source and the drain of the transistor 751, and the other electrode of the capacitor 752 is electrically connected to a wiring to which a common potential is supplied.

One electrode of the liquid crystal element 753 is electrically connected to the other of the source and the drain of the transistor 751, and the other electrode of the liquid crystal element 753 is electrically connected to a wiring to which a common potential is supplied. The common potential supplied to the wiring electrically connected to the other electrode of the capacitor 752 may be different from that supplied to the wiring electrically connected to the other electrode of the liquid crystal element 753.

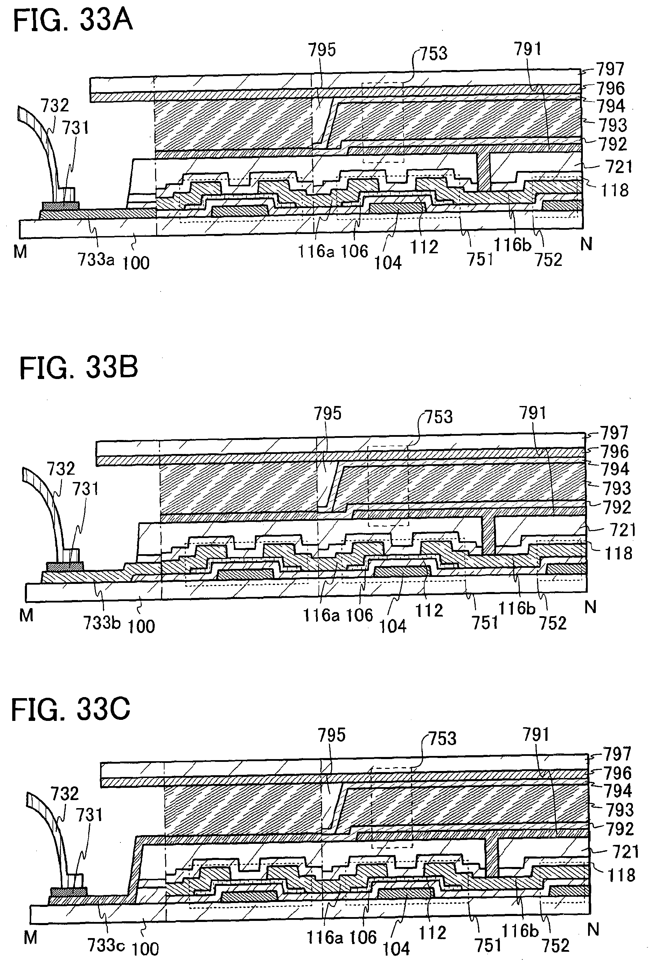

The top view of the display device including a liquid crystal element is similar to that of the display device including an EL element. A cross-sectional view of the display device including a liquid crystal element taken along dashed-dotted line M-N in FIG. 30A is illustrated in FIG. 33A. In FIG. 33A, the FPC 732 is connected to the wiring 733a through the terminal 731. The wiring 733a is the same layer as the gate electrode 104.

FIG. 33A illustrates the example in which the transistor 751 and the capacitor 752 are provided in the same plane. With such a structure, the capacitor 752 can be fabricated in the same planes as the gate electrode, the gate insulating film, and the source (drain) electrode of the transistor 751. Such provision of the transistor 751 and the capacitor 752 in the same plane leads to shortening of the manufacturing process of the display device and an improvement of the productivity.

The transistor described in the above embodiments can be applied to the transistor 751. FIG. 33A illustrates an example in which the transistor illustrated in FIGS. 16A to 16C is applied to the transistor 751. Therefore, for components of the transistor 751 other than the components described below, refer to the description of the above embodiment.

The off-state current of the transistor 751 can be made extremely small. Therefore, charge retained in the capacitor 752 is unlikely to leak, so that the voltage applied to the liquid crystal element 753 can be maintained for a long time. Accordingly, the transistor 751 can be kept off during a period in which moving images with few motions or a still image are/is displayed, whereby power for the operation of the transistor 751 can be saved in that period; accordingly a display device with low power consumption can be provided.

An insulating film 721 is provided over the transistor 751 and the capacitor 752.

Here, an opening reaching the drain electrode 116b of the transistor 751 is provided in the insulating film 721 and the protective insulating film 118.

An electrode 791 is provided over the insulating film 721. The electrode 791 is in contact with the drain electrode 116b of the transistor 751 though the opening provided in the insulating film 721 and the protective insulating film 118.

An insulating film 792 which functions as an alignment film is provided over the electrode 791.

A liquid crystal layer 793 is provided over the insulating film 792.

An insulating film 794 which functions as an alignment film is provided over the liquid crystal layer 793.

A spacer 795 is provided over the insulating film 794.

An electrode 796 is provided over the spacer 795 and the insulating film 794.

A substrate 797 is provided over the electrode 796.

For the insulating film 721, refer to the protective insulating film 118. A resin film made of a polyimide resin, an acrylic resin, an epoxy resin, a silicone resin, or the like may be used as the insulating film 721.

For the liquid crystal layer 793, a thermotropic liquid crystal, a low-molecular liquid crystal, a high-molecular liquid crystal, a high-molecular distributed liquid crystal, a ferroelectric liquid crystal, an anti-ferroelectric liquid crystal, or the like may be used. Such a liquid crystal exhibits a cholesteric phase, a smectic phase, a cubic phase, a chiral nematic phase, an isotropic phase, or the like depending on conditions.

A liquid crystal exhibiting a blue phase may be used as the liquid crystal layer 793. In that case, the insulating films 792 and 794, which function as alignment films, may be omitted.

As the electrode 791, a conductive film having visible light permeability may be used.

As the electrode 791, for example, an oxide film such as an In-Zn-W oxide film, an In-Sn oxide film, an In-Zn oxide film, an In oxide film, a Zn oxide film, or an Sn oxide film may be used. Further, a slight amount of Al, Ga, Sb, F, or the like may be added to the above-described oxide film. A metal thin film having a thickness thin enough to transmit light (preferably, approximately 5 nm to 30 nm) can also be used.

Alternatively, a film on which visible light is reflected efficiently is preferably used as the electrode 791. For example, a film containing aluminum, titanium, chromium, copper, molybdenum, silver, tantalum, or tungsten may be used as the electrode 791.

As the electrode 796, any of the films described for the electrode 791 can be used. Note that in the case where the electrode 791 has visible light permeability, it is preferable that the electrode 796 reflect visible light efficiently, and in the case where the electrode 791 reflects visible light efficiently, it is preferable that the electrode 796 have visible light permeability.

Although the electrodes 791 and 796 are provided in accordance with the structure illustrated in FIG. 33A, the positions of the electrodes 791 and 796 may be replaced with each other.

Each of the insulating films 792 and 794 may be formed using an organic compound or an inorganic compound.

The spacer 795 may be formed using an organic compound or an inorganic compound. The spacer 795 can have any shape such as a column shape or spherical shape.

A region where the electrode 791, the insulating film 792, the liquid crystal layer 793, the insulating film 794, and the electrode 796 overlap with one another serves as the liquid crystal element 753.

Glass, resin, metal, or the like may be used for the substrate 797. The substrate 797 may be flexible.

FIGS. 33B and 33C are examples of the cross-sectional view of a display device including a liquid crystal element, which are partly different from FIG. 33A. Specifically, the wiring connected to the FPC 732 is different in them. In FIG. 33B, the FPC 732 is connected to the wiring 733b through the terminal 731. The wiring 733b is the same layer as the source electrode 116a and the drain electrode 116b. In FIG. 33C, the FPC 732 is connected to the wiring 733c through the terminal 731. The wiring 733c is the same layer as the electrode 791.

The transistor 751 connected to the liquid crystal element 753 has stable electrical characteristics. Accordingly, a display device having a high display quality can be provided. Further, the off-state current of the transistor 751 can be made extremely small. Accordingly, a display device with low power consumption can be provided.

This embodiment can be implemented in appropriate combination with any of the other embodiments.

[Embodiment 10]

In this embodiment, examples of an electronic device to which the semiconductor device described in the above embodiments is applied are described.

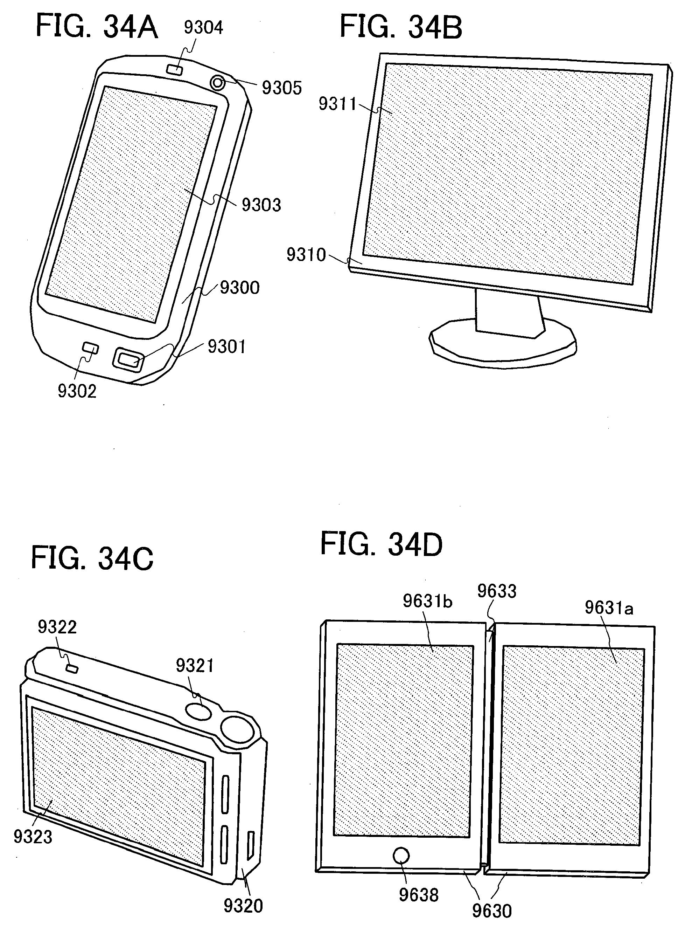

FIG. 34A illustrates a portable information terminal. The portable information terminal illustrated in FIG. 34A includes a housing 9300, a button 9301, a microphone 9302, a display portion 9303, a speaker 9304, and a camera 9305, and has a function as a mobile phone. One embodiment of the present invention can be applied to an arithmetic unit, a wireless circuit, or a memory circuit in its main body. One embodiment of the present invention can also be applied to the display portion 9303.

FIG. 34B illustrates a display. The display illustrated in FIG. 34B includes a housing 9310 and a display portion 9311. One embodiment of the present invention can be applied to an arithmetic unit, a wireless circuit, or a memory circuit in its main body. One embodiment of the present invention can also be applied to the display portion 9311.

FIG. 34C illustrates a digital still camera. The digital still camera illustrated in FIG. 34C includes a housing 9320, a button 9321, a microphone 9322, and a display portion 9323. One embodiment of the present invention can be applied to an arithmetic unit, a wireless circuit, or a memory circuit in its main body. One embodiment of the present invention can also be applied to the display portion 9323.

FIG. 34D illustrates a foldable portable information terminal. The foldable portable information terminal illustrated in FIG. 34D includes a housing 9630, a display portion 9631a, a display portion 9631b, a hinge 9633, and an operation switch 9638. One embodiment of the present invention can be applied to an arithmetic unit, a wireless circuit, or a memory circuit in its main body. One embodiment of the present invention can also be applied to the display portion 9631a and the display portion 9631b.

Part or whole of the display portion 9631a and/or the display portion 9631b can function as a touch panel, which enables data input by touching an operation key displayed thereon.

With the use of the semiconductor device of one embodiment of the present invention, a high performance electronic device with low power consumption can be provided.

This embodiment can be implemented in appropriate combination with any of the other embodiments.

EXPLANATION OF REFERENCE

100: substrate, 102: base insulating film, 104: gate electrode, 106: oxide semiconductor film, 112: gate insulating film, 114: back-gate electrode, 116a: source electrode, 116b: drain electrode, 118: protective insulating film, 200: substrate, 202: base insulating film, 204: gate electrode, 206: oxide semiconductor film, 212: gate insulating film, 216a: source electrode, 216b: drain electrode, 218: protective insulating film, 300: substrate, 302: base insulating film, 304: gate electrode, 306: oxide semiconductor film, 312: gate insulating film, 316a: source electrode, 316b: drain electrode, 400: substrate, 402: base insulating film, 404: gate electrode, 406: oxide semiconductor film, 412: gate insulating film, 416a: source electrode, 416b: drain electrode, 420: insulating film, 500: substrate, 502: base insulating film, 504: gate electrode, 506: oxide semiconductor film, 512: gate insulating film, 518: interlayer insulating film, 520: insulating film, 522: insulating film, 524a: wiring, 524b: wiring, 526: electrode, 528: electrode, 551: transistor, 552: capacitor, 553: bit line, 554: word line, 555: capacitor line, 556: memory cell, 558: sense amplifier, 602: base insulating film, 620: insulating film, 622: insulating film, 626: electrode, 628: electrode, 650: semiconductor substrate, 654: gate electrode, 656: channel region, 657: impurity region, 657a: source region, 657b: drain region, 662: gate insulating film, 664: element separation layer, 668: insulating film, 671: transistor, 672: transistor, 673: capacitor, 674: source line, 675: source line, 676: word line, 677: drain line, 678: capacitor line, 679: node, 690: insulating film, 700: substrate, 719: light-emitting element, 720: insulating film, 721: insulating film, 731: terminal, 732: FPC, 733a: wiring, 733b: wiring, 733c: wiring, 734: seal material, 735: driver circuit, 736: driver circuit, 737: pixel, 741: transistor, 742: capacitor, 743: switching element, 744: signal line, 750: pixel, 751: transistor, 752: capacitor, 753: liquid crystal element, 754: scan line, 755: signal line, 781: electrode, 782: light-emitting layer, 783: electrode, 784: bank, 785a: intermediate layer, 785b: intermediate layer, 785c: intermediate layer, 785d: intermediate layer, 786a: light-emitting layer, 786b: light-emitting layer, 786c: light-emitting layer, 791: electrode, 792: insulating film, 793: liquid crystal layer, 794: insulating film, 795: spacer, 796: electrode, 797: substrate, 802: insulating film, 806: oxide semiconductor film, 812: gate insulating film, 814: gate electrode, 816a: source electrode, 816b: drain electrode, 902: insulating film, 906: oxide semiconductor film, 912: gate insulating film, 914: gate electrode, 916a: source electrode, 916b: drain electrode, 1000: sputtering target, 1001: ion, 1002: sputtered particle, 1003: deposition surface, 1141: switching element, 1142: memory element, 1143: memory element group, 1189: ROM interface, 1190: substrate, 1191: ALU, 1192: ALU controller, 1193: instruction decoder, 1194: interrupt controller, 1195: timing controller, 1196: register, 1197: register controller, 1198: bus interface, 1199: ROM, 4000: film formation apparatus, 4001: atmosphere-side substrate supply chamber, 4002: atmosphere-side substrate transfer chamber, 4003a: load lock chamber, 4003b: unload lock chamber, 4004: transfer chamber, 4005: substrate heating chamber, 4006a: film formation chamber, 4006b: film formation chamber, 4006c: film formation chamber, 4032a: sputtering target, 4032b: sputtering target, 4033a: cathode magnet, 4033b: cathode magnet, 4035: substrate holder, 4101: cassette port, 4102: alignment port, 4103: transfer robot, 4104: gate valve, 4105: heating stage, 4106: target, 4107: attachment protection plate, 4108: substrate stage, 4109: substrate, 4110: cryotrap, 4111: stage, 4200: vacuum pump, 4201: cryopump, 4202: turbo molecular pump, 4300: mass flow controller, 4301: refiner, 4302: gas heating system, 9304: speaker, 9300: housing, 9301: button, 9302: microphone, 9303: display portion, 9305: camera, 9310: housing, 9311: display portion, 9320: housing, 9321: button, 9322: microphone, 9323: display portion, 9630: housing, 9631a: display portion, 9631b: display portion, 9633: hinge, 9638: operation switch, S101: step, S102: step, S103: step, S104: step, S111: step, S112: step, S113: step, and S 114: step.

This application is based on Japanese Patent Application serial No. 2012-147928 filed with the Japan Patent Office on June 29, 2012, Japanese Patent Application serial No. 2012-266243 filed with the Japan Patent Office on December 5, 2012, and Japanese Patent Application serial No. 2012-273482 filed with the Japan Patent Office on December 14, 2012, the entire contents of which are hereby incorporated by reference.

THE FOLLOWING ARE FURTHER EMBODIMENTS OF THE INVENTION:

1. A method for using a target comprising the steps of:

separating a plurality of particles charged positively from the target by subjecting the target to sputtering; and

depositing the plurality of particles repelling each other on a deposition surface,

wherein the target comprises a polycrystalline oxide including crystal grains, and

wherein the particles have a flat plate shape.

2. The method for using a target according to embodiment 1, wherein the particles have a hexagonal cylindrical shape.

3. The method for using a target according to embodiment 1, wherein the particles have crystallinity.

4. The method for using a target according to embodiment 1,
wherein the plurality of particles are generated by cleavage of the crystal grains included in the target.

5. A method for using a target comprising the steps of:

separating a plurality of particles from the target; and

positively charging the plurality of particles so that the plurality of particles are deposited on a deposition surface while repelling each other,

wherein the target comprises a polycrystalline oxide including crystal grains, and

wherein the particles have a flat plate shape.

6. The method for using a target according to embodiment 5, wherein the particles have a hexagonal cylindrical shape.

7. The method for using a target according to embodiment 5, wherein the particles have crystallinity.

8. The method for using a target according to embodiment 5,
wherein the plurality of particles are generated by cleavage of the crystal grains included in the target.

9. A method for forming an oxide film comprising the steps of:

separating a plurality of particles charged positively from a target by subjecting the target to collision of ions; and

depositing the plurality of particles repelling each other on a deposition surface,

wherein the target includes crystal grains,

wherein the particles have a flat plate shape, and

wherein the plurality of particles are deposited so as to be spread on the deposition surface with flat plate planes facing upward.

10. The method for forming an oxide film according to embodiment 9, wherein the particles have crystallinity.

11. The method for forming an oxide film according to embodiment 9, wherein a shape of the particle is a substantially hexagonal cylinder and a c-axis of a crystal is aligned in a direction perpendicular to a hexagonal plane of the substantially hexagonal cylinder.

12. The method for forming an oxide film according to embodiment 9, wherein the plurality of particles are generated by cleavage of the crystal grains included in the target.

13. The method for forming an oxide film according to embodiment 9, wherein the deposition surface is heated during the deposition of the plurality of particles.

14. A method for forming an oxide film comprising the steps of:

separating a plurality of particles from a target by subjecting the target to collision of ions; and

positively charging the plurality of particles so that the plurality of particles are deposited on a deposition surface while repelling each other,

wherein the target includes crystal grains,

wherein the particles have a flat plate shape, and

wherein the plurality of particles are deposited so as to be spread on the deposition surface with flat plate planes facing upward.

15. The method for forming an oxide film according to embodiment 14, wherein the particles have crystallinity.

16. The method for forming an oxide film according to embodiment 14, wherein a shape of the particle is a substantially hexagonal cylinder and a c-axis of a crystal is aligned in a direction perpendicular to a hexagonal plane of the substantially hexagonal cylinder.

17. The method for forming an oxide film according to embodiment 14, wherein the plurality of particles are generated by cleavage of the crystal grains included in the target.

18. The method for forming an oxide film according to embodiment 14,

wherein the deposition surface is heated during the deposition of the plurality of particles.

**Claims**

1. A method of manufacturing an oxide film having crystallinity, the method comprising:

providing a first sputtering target and a second sputtering target in a sputtering apparatus, the first sputtering target and the second sputtering target facing each other with a region therebetween;
providing a first substrate holder in such a manner that a surface of the first substrate holder faces the region; and
performing a formation of the oxide film having crystallinity by sputtering.

2. The method of manufacturing an oxide film having crystallinity according to claim 1, wherein the oxide film comprises a plurality of crystal parts, and wherein each of the plurality of crystal parts fits inside a cube whose one side is less than 100 nm.

3. The method of manufacturing an oxide film having crystallinity according to claim 1, wherein the surface of the first substrate holder is perpendicular to surfaces of the first sputtering target and the second sputtering target.

4. The method of manufacturing an oxide film having crystallinity according to claim 1, wherein the oxide film comprise crystals whose c-axes are aligned in a direction perpendicular to the oxide film.

5. The method of manufacturing an oxide film having crystallinity according to claim 3 or 4, wherein the first substrate holder is on an upper side of the region.

6. The method of manufacturing an oxide film having crystallinity according to claim 3 or 4, wherein the first substrate holder is on an lower side of the region.

7. The method of manufacturing an oxide film having crystallinity according to claim 1, wherein the first sputtering target and the second sputtering target face each other with inclination.

8. The method of manufacturing an oxide film having crystallinity according to claim 7, wherein the first substrate holder is provided on one side of the region on which a distance between the first sputtering target and the second sputtering is larger than on the other side.

9. The method of manufacturing an oxide film having crystallinity according to claim 3 or 7, wherein the oxide film having crystallinity comprise crystals whose c-axes are aligned in a direction perpendicular to the oxide film.

10. The method of manufacturing an oxide film having crystallinity according to any one of claims 3, 4 and 7, wherein the first substrate is heated at a temperature higher than or equal to 100 °C and lower than or equal to 600 °C during the formation of the oxide film.

11. The method of manufacturing an oxide film having crystallinity according to claim 1, further comprising the steps of:

> providing a second substrate holder in such a manner that a surface of the second substrate holder faces the region, wherein the first substrate holder is on an upper side of the region and the second substrate holder is on a lower side of the region, and wherein each of the surface of the first substrate holder and the surface of the second substrate holder is perpendicular to surfaces of the first sputtering target and the second sputtering target.

12. The method of manufacturing an oxide film having crystallinity according to claim 11, wherein the first substrate and the second substrate are heated at a temperature higher than or equal to 100 °C and lower than or equal to 600 °C during the formation of the oxide film.

FIG. 1A

1001

1002

1000

plasma

FIG. 1B

c-axis

1002

## FIG. 2A

## FIG. 2B

# FIG. 3A

# FIG. 3B

cleavage

○ In

◉ Ga

○ Zn

● O

c−axis

# FIG. 4A

c-axis direction

In — charge 0

# FIG. 4B

Ga — charge 0

a-b plane

# FIG. 4C

Zn — charge 0

# FIG. 4D

Sn — charge +1

# FIG. 4E

Zn / Zn — charge −1

# FIG. 5A

# FIG. 5B

# FIG. 5C

| | |
|---|---|
| ● | In |
| ○ | Sn |
| ○ | Zn |
| ● | O |

FIG. 6B

FIG. 6A

FIG. 6C

3

In

3
1

Zn

3
1

Ga

1
3

In

3

In

Ga

Zn

O

FIG. 7A

In
Ga or Zn
O

FIG. 7B

In
Ga
Zn
O

# FIG. 8

crystal structure

surface structure (1)

surface structure (2)

surface structure (3)

● In

○ Ga

☾ Zn

● O

# FIG. 9

In
Ga
Zn
O

crystal structure      surface structure (4)

FIG. 10

crystal structure          surface structure (5)

● In
○ Ga
◔ Zn
● O

# FIG. 11

crystal
structure

surface structure (6)

surface structure (7)

● In
◐ Ga
◔ Zn
● O

# FIG. 12

4000

EP 3 029 172 A1

FIG. 13A

FIG. 13B

FIG. 13C

evacuation

evacuation

evacuation

evacuation

evacuation

52

FIG. 14A

N S 4032a
4033a
4032b 4033b
N S
S N
S N
4035

FIG. 14B

N S 4032a
4033a
4032b 4033b
N S
N S
N S
4035

FIG. 14C

N S 4032a
4033a
4032b 4033b
N S
S N
S N
4035

FIG. 14D

N S 4032a
4033a
4032b 4033b
N S
N S
N S
4035

# FIG. 15A

```
        ┌──────────────┐
        │    start     │
        └──────┬───────┘
               │              S101
        ┌──────┴───────┐
        │   weighing   │
        └──────┬───────┘
               │              S102
        ┌──────┴───────┐
        │   baking     │
        └──────┬───────┘
               │ ◄────────┐   S103
        ┌──────┴───────┐  │
        │   grinding   │  │
        └──────┬───────┘  │
               │          │   S104
          NG  ╱─┴─╲        │
        ┌────◄ check ╲─────┘
              ╲ grain size ╱
               ╲────┬────╱
                 OK │
        ┌──────────┴───┐
        │   finish     │
        └──────────────┘
```

# FIG. 15B

```
        ┌──────────────┐
        │    start     │
        └──────┬───────┘
          ┌───►│              S111
          │ ┌──┴───────────┐
          │ │   molding    │
          │ └──────┬───────┘
          │        │          S112
          │ ┌──────┴───────┐
          │ │pressure treatment│
          │ └──────┬───────┘
          │        │          S113
          │ ┌──────┴───────┐
          │ │   baking     │
          │ └──────┬───────┘
          │        │          S114
          │  NG  ╱─┴─╲
          └────◄ check ╲
                ╲thickness ╱
                 ╲───┬───╱
                  OK │
        ┌───────────┴──┐
        │   finish     │
        └──────────────┘
```

EP 3 029 172 A1

FIG. 16A

A4

A1                          A2

A3

116a  104  106  A3            116b          100

FIG. 16C

A4

102
112
106
104

118    100    A3

FIG. 16B

116a        106              116b

118
112
100

A1        104        102      A2

55

# FIG. 17A

# FIG. 17C

# FIG. 17B

## FIG. 18A

B4

200

B1

B2

216a    204  206  B3                    216b

## FIG. 18C

B4

202

212

206

204

218    200

B3

## FIG. 18B

216a        206              216b

218

212

200

B1          204        202      B2

# FIG. 19A

# FIG. 19C

# FIG. 19B

# FIG. 20A

D4

400

D1

D2

D3

416a    404    406    416b

# FIG. 20C

D4

402

412

406

404

400

D3

# FIG. 20B

416a    404    416b

412

400

D1                    D2

406    402

# FIG. 21A

E4

E1

E2

524a  504  E3  506  524b

500

# FIG. 21C

E4

502

512

506

518

504

E3

500

# FIG. 21B

504

524a  524b

518

500

E1

E2

506  512  502

FIG. 22A

VDD

Tr1a

Vin ○

Vout

BGL

Tr2a

FIG. 22B

906   914

Tr2a

912

916a

902

Tr1a

916b

690

662

650

664

657a  654  656    657b

# FIG. 23A

# FIG. 23B

# FIG. 24A

VDD

Tr1d

Vin —o

Vout

BGL

Tr2d

# FIG. 24B

806  814

Tr2d

816b
802
Tr1d
416a

812
816a
420
412
416b
402
400

404   406   402

FIG. 25

FIG. 26A

FIG. 26B

FIG. 26C

FIG. 26D

# FIG. 27A

# FIG. 27B

# FIG. 27C

## FIG. 28A

## FIG. 28B

## FIG. 28C

FIG. 29

## FIG. 30A

736

M — N

732  100  735  737  734  700

## FIG. 30B

784  783  782  719

700

732
731
733a

781
720
118
116b

M  100  742  741  116a  112  106  N
104

## FIG. 30C

782

785d
786c
785c
786b
785b
786a
785a

## FIG. 31A

## FIG. 31B

FIG. 32

FIG. 33A

FIG. 33B

FIG. 33C

## FIG. 34A

9304
9305
9303
9300
9301
9302

## FIG. 34B

9311
9310

## FIG. 34C

9322
9321
9323
9320

## FIG. 34D

9631b
9633
9631a
9638
9630

FIG. 35A

V

0

Time

A B A B

FIG. 35B1

target1
(cathode)

target2
(anode)

FIG. 35B2

target1
(anode)

target2
(cathode)

FIG. 35C

1002

+ +
+ +
+ +
+

charges
are lost

**EP 3 029 172 A1**

Europäisches Patentamt
European Patent Office
Office européen des brevets

# EUROPEAN SEARCH REPORT

Application Number

EP 15 20 2535

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TOMINAGA K ET AL: "Transparent ZnO:Al films prepared by co-sputtering of ZnO:Al with either a Zn or an Al target", THIN SOLID FILMS, ELSEVIER-SEQUOIA S.A. LAUSANNE, CH, vol. 290-291, 15 December 1996 (1996-12-15), pages 84-87, XP004173295, ISSN: 0040-6090, DOI: 10.1016/S0040-6090(96)09127-4 * sections 2, 3.2, 3.4; figure 1 * | 1,3-12 | INV. C23C14/34 C23C14/08 H01L21/363 H01L21/8247 H01L27/115 H01L51/50 H05B33/14 C23C14/35 |
| X | TOMINAGA K ET AL: "Preparation of conductive ZnO:Al films by a facing target system with a strong magnetic field", THIN SOLID FILMS, ELSEVIER-SEQUOIA S.A. LAUSANNE, CH, vol. 253, no. 1-2, 15 December 1994 (1994-12-15), pages 9-13, XP025834965, ISSN: 0040-6090, DOI: 10.1016/0040-6090(94)90285-2 [retrieved on 1994-12-15] * sections 2, 3.1, 3.4; figures 1-2 * | 1,3-12 | |
| X | T. KOIDA ET AL: "Improved near-infrared transparency in sputtered In[sub 2]O[sub 3]-based transparent conductive oxide thin films by Zr-doping", JOURNAL OF APPLIED PHYSICS, vol. 101, no. 6, 23 March 2007 (2007-03-23), page 063705, XP55048040, ISSN: 0021-8979, DOI: 10.1063/1.2711768 * sections II, III; figures 1-3 * | 1-3,7,8, 10 | |

TECHNICAL FIELDS SEARCHED (IPC)

C23C
H01J

-/--

The present search report has been drawn up for all claims

| Place of search | Date of completion of the search | Examiner |
|---|---|---|
| The Hague | 15 February 2016 | Peijzel, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

75

Europäisches
Patentamt

European
Patent Office

Office européen
des brevets

# EUROPEAN SEARCH REPORT

Application Number

EP 15 20 2535

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2001/027167 A1 (KAWAKUBO TAKASHI [JP] ET AL) 4 October 2001 (2001-10-04) * paragraphs [0010], [0018]; figure 5 * ----- | 1,3-10 | |
| A | US 2011/168553 A1 (CHOI SEUNG-HO [KR] ET AL) 14 July 2011 (2011-07-14) * figure 1 * ----- | 11,12 | |

TECHNICAL FIELDS
SEARCHED      (IPC)

The present search report has been drawn up for all claims

| Place of search | Date of completion of the search | Examiner |
|---|---|---|
| The Hague | 15 February 2016 | Peijzel, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 20 2535

This annex lists the patent family members relating to the patent documents cited in  the above-mentioned European search report.
The members are as contained in the European Patent Office EDP file on
The European Patent Office is in no way liable for these particulars which are merely given for the purpose of information.

15-02-2016

| Patent document cited in search report | | Publication date | Patent family member(s) | | Publication date |
|---|---|---|---|---|---|
| US 2001027167 | A1 | 04-10-2001 | JP | 3944341 B2 | 11-07-2007 |
| | | | JP | 2001270795 A | 02-10-2001 |
| | | | KR | 20010093671 A | 29-10-2001 |
| | | | US | 2001027167 A1 | 04-10-2001 |
| US 2011168553 | A1 | 14-07-2011 | CN | 102121095 A | 13-07-2011 |
| | | | DE | 102011002451 A1 | 01-09-2011 |
| | | | JP | 5485077 B2 | 07-05-2014 |
| | | | JP | 2011140710 A | 21-07-2011 |
| | | | KR | 20110082320 A | 19-07-2011 |
| | | | US | 2011168553 A1 | 14-07-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006165528 A
- JP H6275697 B
- JP 2012147928 A
- JP 2012266243 A
- JP 2012273482 A

**Non-patent literature cited in the description**

- **SHUNPEI YAMAZAKI ; JUN KOYAMA ; YOSHITA-KA YAMAMOTO ; KENJI OKAMOTO.** Research, Development, and Application of Crystalline Oxide Semiconductor. *SID 2012 DIGEST,* 2012, 183-186